# EUROPÄISCHE PATENTSCHRIFT

(11) **EP 0 565 488 B1**
(45) Veröffentlichungstag und Bekanntmachung des Hinweises auf die Patenterteilung: **21.04.1999**
(21) Anmeldenummer: 93810229.0
(22) Anmeldetag: 30.03.1993
(51) Int. Cl.: C07F 17/00, C08F 2/50, G03F 7/00, C09D 4/00

(54) **Fluorfreie Titanocene und deren Verwendung**
Fluorine free titanocenes and their application
Titanocènes exempts de fluor et leur application

(30) Priorität: 09.04.1992 CH 1155/92
(43) Veröffentlichungstag der Anmeldung: 13.10.1993
(73) Patentinhaber: Ciba Specialty Chemicals Holding Inc., 4057 Basel (CH)
(72) Erfinder: Desobry, Vincent, CH-1723 Marly (CH)

(56) Entgegenhaltungen:
- EP-A- 0 401 166

## Beschreibung

Die Erfindung bettrift neue, fluorfreie Titanocene, deren Verwendung als Photoinitiatoren und Zusammensetzungen, die diese Titanocene enthalten.

Titanocenverbindungen sind als hochwirksame Photoinitiatoren bekannt. In den US-A-4,590,287 und 4,910,121 sind beispielsweise Titanocene als Photoinitiatoren beschrieben, die mit Halogen-, Alkyl- oder Amino-Resten am Aromaten substituiert sind. Der US-A-4,548,891 ist die Verwendung dieser Verbindungen als Photoinitiatoren zur Herstellung von Reliefplatten zu entnehmen. Aus den US-A-4,713,401 und 4,855,468 sind Titanocenverbindungen, die an den aromatischen Resten mit mindestens einer Trifluormethylgruppe substituiert sind, bekannt. In der US-A-4,963,470 sind Titanocene, die am Cyclopentadienylring mit Trialkylsiliziumresten substituiert sind veröffentlicht. Titanocenverbindungen mit Stickstoff- und heterocyclischen Substituenten am aromatischen Ring sind den US-A-5,008,302, US-A-5,026,625 und US-A-5,068,371 zu entnehmen. Im US-A-5,192,642 sind Titanocene, die am aromatischen Rest Ester-Substituenten tragen, beschrieben. Den als Photoinitiator wirksamen Titanocenverbindungen, die im oben erwähnten Stand der Technik beschrieben sind, ist eines gemeinsam: Die aromatischen Liganden am Titanatom sind in mindestens einer otto-Position zum C-Atom, welches an das Titan gebunden ist, mit Fluor oder Trifluormethylgruppen substituiert. L.Summers, R. H. Uloth und A. Holmers stellen im J. Am. Chem. Soc. 77, 3604 (1959) fest, dass Bis(alkylaryl)bis(cyclopentadienyl)titan- Verbindungen nur eine geringe Stabilität besitzen. M.A. Chaudari, P.M. Treichel und F. G. A. Stone vergleichen die Stabilität von Titanocenen mit perfluorierten Arylliganden mit der der entsprechenden halogenfreien Titanocene (J. Organomet. Chem. 2, 206-212 (1964)). Die Titanocene mit den perfluorierten aromatischen Resten erweisen sich dabei als wesentlich stabiler. Zum gleichen Ergebnis führen die Untersuchungen von R. Usón, J. Forniés und M. Tomás, die im J. Organomet. Chem. 358, 525-543 (1988) veröffentlicht sind, wobei die Fluor-Substitution in der ortho-Position eine wichtige Rolle spielt.

Die Handhabung, Herstellung und Entsorgung von fluorhaltigen Verbindungen ist technisch häufig nicht einfach zu bewerkstelligen. Daher besteht ein Bedarf an als Photoinitiatoren brauchbaren Titanocenen, die keine Fluoratome enthalten.

Es wurde nun überraschenderweise gefunden, dass Titanocenverbindungen mit Pyrimidinliganden auch ohne eine Substitution durch Fluor stabil und wirksam als Photoinitatoren sind.

Gegenstand der Erfindung sind daher Verbindungen der Formeln I und II 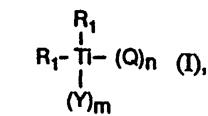 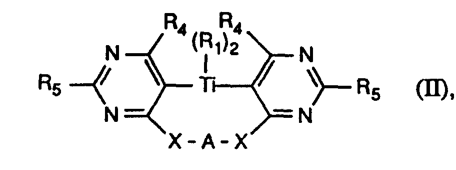 worin beide R₁ unabhängig voneinander Cyclopentadienyl^{⊖}, Indenyl^{⊖} oder 4,5,6,7-Tetrahydroindenyl^{⊖} bedeuten, wobei diese Reste unsubstituiert oder durch C₁-C₁₈-Alkyl oder -Alkoxy, C₂-C₁₈-Alkenyl, C₅-C₈-Cycloalkyl, C₁-C₄-Alkyl-C₅-C₈-cycloalkyl, Phenyl, Naphthyl, mit Phenyl substituiertes C₁-C₁₂-Alkyl, -Si(R₂)₃, -Ge(R₂)₃, Cyano, Cl, Br oder I substituiert sind und beide R₂ unabhängig voneinander C₁-C₁₂-Alkyl, C₅-C₈-Cycloalkyl, unsubstituiertes oder mit C₁-C₆-Alkyl substituiertes Phenyl oder Benzyl bedeuten,
Q für einen Rest 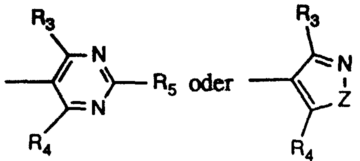 steht,
Z für -NR₁₀-, -O- oder -S- steht,
Y Cl, Br, I, CN, SCN, -O-CO-CH₃, -O-CO-Phenyl oder -O-SO₂-CH₃ bedeutet
n 1 oder 2 ist,
m 0 oder 1 ist, wobei die Summe von n und m 2 sein muss,
R₃, R₄ und R₅ unabhängig voneinander Wasserstoff, Cl, Br, I, unsubstituiertes oder mit C₁-C₄-Alkoxy, C₅-C₆-Cycloalkyl oder Phenyl substituiertes C₁-C₁₂-Alkyl, unsubstituiertes oder mit C₁-C₄-Alkyl substituiertes C₃-C₈-Cycloalkyl oder Adamantyl sind, oder R₃, R₄ und R₅ Phenyl, Pyrryl, Furyl, Thienyl, Imidazolyl, Pyridyl, Naphthyl, Anthryl, Phenanthryl oder Biphenylyl bedeuten, wobei die Reste Phenyl, Pyrryl, Furyl, Thienyl, Imidazolyl, Pyridyl, Naphthyl, Anthryl, Phenanthryl oder Biphenylyl unsubstituiert oder mit C₁-C₁₂-Alkyl, Cyclopentyl, Cyclohexyl, Cl, Br, I, C₁-C₈-Alkylthio, -NR₈R₉, Phenyl, Phenylthio oder/und C₁-C₁₀-Alkoxy substituiert sind, oder R₃, R₄ und R₅ unsubstituiertes C₂-C₁₂-Alkenyl oder C₂-C₁₂-Alkenyl, welches mit unsubstituiertem oder mit C₁-C₄-Alkyl, C₁-C₄-Alkoxy, C₁-C₄-Alkylthio, Cl, Br oder I substituiertem Phenyl oder 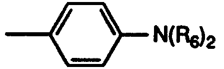 substituiert ist, bedeuten, oder R₃, R₄ und R₅ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy, C₂-C₆-Alkenyloxy, -O-Si-(R₇)₃, C₁-C₈-Alkylthio, C₃-C₈-Cycloalkylthio, unsubstituiertes oder mit C₁-C₄-Alkyl und/oder C₁-C₄-Alkoxy substituiertes Benzylthio, unsubstituiertes oder mit C₁-C₄-Alkyl und/oder C₁-C₄-Alkoxy substituiertes Phenylthio, -S(O)R₈, -SO₂R₈, -N(R₉)₂, 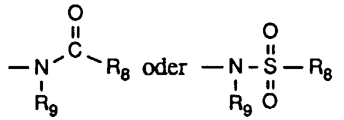 bedeuten,
wobei R₃ und R₄ nicht gleichzeitig Wasserstoff bedeuten, und im Rest 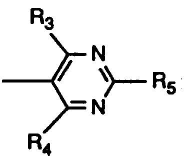 mindestens ein Rest R₃ oder R₄ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Terahydrofurfuryloxy oder C₂-C₆-Alkenyloxy bedeutet,
und im Falle, dass Z -NR₁₀- ist, R₃ und R₄ Cl, Br oder I darstellen,
beide R₆ unabhängig voneinander C₁-C₄-Alkyl oder C₂-C₁₀-Alkenyl bedeuten oder beide R₆ zusammen mit dem N-Atom, an welches sie gebunden sind einen Morpholino-Rest bilden,
R₇ für C₁-C₁₂-Alkyl, C₅-C₈-Cycloalkyl, unsubstituiertes oder mit C₁-C₆-Alkyl substituiertes Phenyl steht,
R₈ unsubstituiertes oder mit C₁-C₄-Alkyl substituiertes Phenyl oder in α-Position tertiäres C₄-C₆-Alkyl darstellt,
R₉ unsubstituiertes oder mit Phenyl, C₇-C₁₂-Alkylphenyl, C₅-C₈-Cycloalkyl oder C₁-C₄-Alkyl C₅-C₈-cycloalkyl substituiertes C₁-C₈-Alkyl, C₂-C₈-Alkenyl, unsubstituiertes oder mit C₁-C₄-Alkyl substituiertes C₅-C₈-Cycloalkyl, C₆-C₂₀-Cycloalkenylalkyl, unsubstituiertes oder mit C₁-C₁₂-Alkyl substituiertes Phenyl, einen Rest 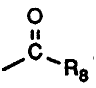 oder 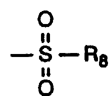 bedeutet, wobei ausserdem in -N(R₉)₂ beide R₉ gleich oder verschieden sind und die beiden R₉ zusammen mit dem N-Atom, an welches sie gebunden sind, einen 5- oder 6-gliedrigen Heterozyklus, der neben dem N-Atom noch weitere N-, O- oder S-Atome enthalten kann, bilden können, oder die beiden R₉ zusammen mit dem N-Atom, an welches sie gebunden sind, einen Rest 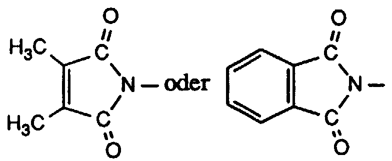 bilden,
R₁₀ die Bedeutungen von R₉ hat und zusätzlich Naphthyl, Biphenylyl, Pyridyl oder Pyrimidinyl ist, wobei diese Reste unsubstituiert oder mit Cl, Br, I, NO₂, C₁-C₁₂-Alkyl, C₁-C₁₀-Alkoxy, C₁-C₈-Alkylthio, Phenylthio, Morpholino oder -N(C₁-C₄-Alkyl)₂ substituiert sind, oder R₁₀ mit Cl, Br, I, NO₂, C₁-C₁₀-Alkoxy, C₁-C₈-Alkylthio, Phenylthio, Morpholino oder -N(C₁-C₄-Alkyl)₂ substituiertes Phenyl ist, X -O-, -S-, 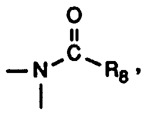 Methylen oder Ethylen bedeutet,
A für C₁-C₁₂-Alkylen steht, oder -X-A-X- für eine direkte Bindung steht.

Bei den Gruppen R₁ handelt es sich bevorzugt um gleiche Reste. Als Substituenten kommen für R₁ in Frage: lineares oder verzweigtes Alkyl oder Alkoxy mit 1 bis 18, besonders 1 bis 12 und insbesondere 1 bis 6 C-Atomen, und Alkenyl mit 2 bis 18, besonders 2 bis 12, und insbesondere 2 bis 6 C-Atomen, wie z.B. Methyl, Ethyl, Propyl, Isopropyl, n-Butyl, t-Butyl, Pentyl, Hexyl, Octyl, Decyl, Dodecyl, Tetradecyl, Hexadecyl, Octadecyl und entsprchende Alkenyl- und Alkoxygruppen; Cycloalkyl mit 5 bis 8 Ringkohlenstoffatomen wie z.B. Cyclopentyl, Cyclohexyl, Cycloheptyl, Methyl- cyclopentyl und Methylcyclohexyl; Phenyl oder Naphthyl, mit Phenyl substituiertes C₁-C₁₂-Alkyl wie z.B. Benzyl und Phenylethyl; Cyano und Cl, I und Br; -Si(R₂)₃ oder -Ge(R₂)₃, worin R₂ bevorzugt C₁-C₈-Alkyl, Cyclohexyl, Phenyl oder Benzyl ist. Beispiele für R₂ in der Bedeutung von Alkyl sind Methyl, Ethyl, n- und i-Propyl, n-, i- und t-Butyl, Pentyl, Hexyl, Heptyl und Octyl.
Die Reste R₁ können bis zu 5, besonders aber bis zu 3 Substituenten enthalten. Bevorzugt sind beide R₁ Cyclopentadienyl^{⊖}- oder Methylcyclopentadienyl^{⊖}-Reste, insbesondere Cyclopentadienyl^{⊖}-Reste.

Stehen etwaige Reste für C₁-C₁₂-Alkyl, so handelt es sich beispielsweise um lineares oder verzweigtes C₁-C₁₂-, bevorzugt C₁-C₈-Alkyl und besonders C₁-C₄-Alkyl. Beispiele sind Methyl, Ethyl und die Isomeren von Propyl, Butyl, Pentyl, Hexyl, Heptyl, Octyl, Nonyl, Decyl, Undecyl oder Dodecyl. Tertiäres C₄-C₆-Alkyl bedeutet beispielsweise t-Butyl, 2-Methyl-but-2-yl, 2,3-Dimethyl-but-2-yl oder 2-Methyl-pent-2-yl.

A als C₁-C₁₂-Alkylen ist Methylen, Ethylen, Propylen, Butylen, Pentylen, Hexylen, Heptylen, Octylen, Nonylen, Decylen, Undecylen oder Dodecylen, bevorzugt Ethylen oder Methylen.

Beispiele für mit C₁-C₄-Alkoxy substituierte C₁-C₁₂-Alkylreste sind Methoxymethyl, Ethoxymethyl, Propoxymethyl, Butoxymethyl, Methoxyethyl, Ethoxyethyl, Butoxyethyl, Propoxyethyl, Methoxypropyl, Ethoxypropyl, Methoxybutyl, Ethoxybutyl, Methoxyhexyl, Methoxyoctyl, oder Methoxydodecyl.
Mit Phenyl substituiertes C₁-C₁₂-Alkyl ist beispielsweise Benzyl, 1,1-Dimethylbenzyl, Phenylethyl, Phenylpropyl oder Phenylbutyl.
C₁-C₄-Alkyl-C₅-C₈-Cycloalkyl steht für C₅-C₈-Cycloalkyl, welches mit C₁-C₄-Alkyl substituiert ist, z.B. Methylcyclopentyl oder Methylcyclohexyl.
C₅-C₈-Cycloalkyl ist beispielsweise Cyclopentyl, Cyclohexyl, Cycloheptyl oder Cyclooctyl, bevorzugt Cyclopentyl und Cyclohexyl.
Beispiele für mit C₇-C₁₂-Alkylphenyl, C₅-C₈-Cycloalkyl oder C₁-C₄-Alkyl-C₅-C₈-Cycloalkyl substituiertes C₁-C₈-Alkyl sind Methylbenzyl, Ethylbenzyl, Butylbenzyl, 2,6-Dimethylbenzyl, 2,4,6-Trimethylbenzyl, 2,6-Dimethylphenylethyl, -propyl oder -butyl, 2,4,6-Trimethylphenylethyl, -propyl oder -butyl, 2,6-Dimethylphenyl-α,α-dimethylethyl, 2,4,6-Trimethylphenyl-α,α-dimethylethyl, Cyclopentyl- oder Cyclohexylmethyl, Cyclopentyl- oder Cyclohexylethyl, Cyclopentyl- oder Cyclohexylpropyl, Cyclopentyl- oder Cyclohexylbutyl, (Methylcyclopentyl)methyl, (Ethylcylohexyl)methyl oder -ethyl, (Butylcyclopentyl)methyl, (Propylcyclohexyl)methyl oder -ethyl.

In α-Position tertiäres C₄-C₆-Alkyl ist beispielsweise t-Butyl, 1,1-Dimethylprop-1-yl, 1,1,2-Trimethylprop-1-yl oder 1,1-Dimethylbut-1-yl, vorzugsweise t-Butyl.

Sind etwaige Substituenten C₃-C₈-Cycloalkyl, so stehen sie z.B. für Cyclopropyl, Cyclopentyl, Cyclohexyl, Cycloheptyl und Cyclooctyl, insbesondere für Cyclopentyl und Cyclohexyl, bevorzugt Cyclohexyl.
Mit C₁-C₁₂-Alkyl substituiertes C₃-C₈-Cycloalkyl ist z.B. Methyl-, Dimethyl-, Ethyl-, n-Propyl-, i-Propyl-, n-Butyl, i-Butyl-, t-Butyl-, Octyl-, Dodecylcyclopentyl oder -cyclohexyl.

Unter C₆-C₂₀-Cycloalkenylalkyl ist beispielsweise Cyclopentenyl-, Cyclohexenyl-, Cyclooctenylmethyl oder -ethyl zu verstehen.

Mit C₁-C₁₂-Alkyl, Cl, Br, I oder C₁-C₄-Alkoxy substituiertes Phenyl ist ein- oder mehrfach, besonders ein- bis dreifach, insbesondere ein- oder zweifach, bevorzugt einfach substituiertes Phenyl. Beispiele für solche Reste sind Tolyl, Mesityl, Xylyl, Ethylphenyl, Butylphenyl, Dodecylphenyl, Methoxyphenyl, Dimethoxyphenyl, Ethoxyphenyl, Diethoxyphenyl, Butoxyphenyl, Chlorphenyl, Dichlorphenyl, Trichlorphenyl. Alkyl- und Alkoxysubstituenten am Phenylsubstituenten haben vorzugsweise 1-4 C-Atome.

Bedeuten R₃, R₄ oder R₅ mit C₁-C₈-Alkylthio, Phenyl oder Phenylthio substituiertes Phenyl, so ist dieses ein- oder mehrfach, besonders ein- bis dreifach, insbesondere ein- oder zweifach, bevorzugt einfach substituiertes Phenyl. Die Substituenten befinden sich in der 3-, 4-, 3,4- oder 3,4,5-Position, bevorzugt in der 4-Position des Phenylrings.

Stehen etwaige Reste für C₂-C₁₂-Alkenyl, so handelt es sich beispielsweise um lineares oder verzweigtes C₂-C₁₂-, bevorzugt C₂-C₈-Alkenyl und insbesondere C₂-C₄-Alkenyl. Das Alkenyl kann einfach oder mehrfach ungesättigt sein. Beispiele sind Allyl, Methallyl, 1,1-Dimethylallyl, Butenyl, Hexenyl, Octenyl, 2,5,8-Trimethyl-nona-2,7-dien-5-yl, Undecenyl oder Dodecenyl, bevorgzugt Allyl und Methallyl. R₅ als C₂-C₁₂-Alkenyl steht insbesondere für 2,5,8-Trimethyl-nona-2,7-dien-5-yl.

C₁-C₁₂-Alkoxy ist beispielsweise linear oder verzweigt. Bevorzugt ist C₁-C₈-Alkoxy, insbesondere C₁-C₆-Alkoxy und besonders C₁-C₄-Alkoxy. Beispiele sind Methoxy, Ethoxy und die Isomeren von Propyloxy, Butyloxy, Pentyloxy, Hexyloxy, Heptyloxy, Octyloxy, Nonyloxy, Decyloxy, Undecyloxy oder Dodecyloxy. Durch ein oder mehrere O-Atome unterbrochenes C₂-C₁₂-Alkoxy steht z.B. für eine Gruppe -O-CH₂-OCH₃, -O-CH₂-OC₂H₅, -O-(CH₂-O)ₓ-CH₃, -O-(CH₂-O)ₓ-C₂H₅, -O-(CH₂CH₂-O)ₓ-CH₃ oder -O-(CH₂CH₂-O)ₓ-C₂H₅, wobei x ein Zahl von 1 bis 20 darstellt. Insbesondere ist durch O-Atome unterbrochenes C₂-C₁₂-Alkoxy -O-CH₂-OCH₃.
Mit C₅-C₈-Cycloalkyl substituiertes C₁-C₁₂-Alkoxy ist beispielsweise Cyclohexylmethoxy, Cyclopentylmethoxy, Cyclohexylethoxy oder Cyclopentylethoxy, bevorzugt Cyclohexylmethoxy. Mit Phenoxy substituiertes C₁-C₁₂-Alkoxy ist z.B. Phenoxymethoxy, Phenoxyethoxy, Phenoxybutoxy, Phenoxyoctyloxy, bevorzugt Phenoxyethoxy.

C₃-C₁₂-Cycloalkoxy ist beispielsweise Cyclopropyloxy, Cyclopentyloxy, Cyclohexyloxy, Cycloheptyloxy, Cyclooctyloxy und Cyclododecyloxy, insbesondere Cyclopentyloxy und Cyclohexyloxy, bevortzugt Cyclohexyloxy. Sind diese Reste mit C₁-C₄-Alkyl substituiert, so sind sie ein- bis vierfach, insbesondere ein- bis dreifach, bevorzugt einfach substituiert. Solche Reste sind beispielsweise Methylcyclohexyloxy, Methylcyclopentyloxy, Dimethylcyclohexyloxy, Ethylcyclohexyloxy, Diethylcyclohexyloxy, Propylcyclohexyloxy oder Butylcyclohexyloxy.

Mit C₁-C₄-Alkoxy substituiertes Phenoxy ist ein- bis vierfach, insbesondere ein- bis dreifach, bevorzugt ein- oder zweifach substituiert. Solche Reste sind z.B. 2,6-Dimethoxyphenoxy, 2,4-Dimethoxyphenoxy, 2,4,6-Trimethoxyphenoxy, 4-Methoxyphenoxy, 2-Methoxyphenoxy, 6-Methoxyphenoxy, 2,6-Diethoxyphenoxy, 2,4-Diethoxyphenoxy, 2-Ethoxyphenoxy, 4-Ethoxyphenoxy, 6-Ethoxyphenoxy, Propoxyphenoxy oder Butoxyphenoxy.

Mit C₁-C₄-Alkyl substituiertes Phenoxy ist ein- bis vierfach, insbesondere ein- bis dreifach, bevorzugt ein- oder zweifach substituiert. Solche Reste sind z.B.2,6-Dimethylphenoxy, 2,4-Dimethylphenoxy, 2,4,6-Trimethylphenoxy, 4-Methylphenoxy, 2-Methylphenoxy, 6-Methylphenoxy, 2,6-Diethylphenoxy, 2,4-Diethylphenoxy, 2-Ethylphenoxy, 4-Ethylphenoxy, 6-Ethylphenoxy, Propylphenoxy oder Butylphenoxy.

Mit C₁-C₄-Alkyl substituiertes Benzyloxy ist ein- bis vierfach, insbesondere ein- bis dreifach, bevorzugt ein- oder zweifach substituiert. Die Alkyl-Substituenten können sowohl am Methylen, als auch am aromatischen Ring des Benzyloxyrests positioniert sein. Solche Reste sind z.B. 2-Methylbenzyloxy, 4-Methylbenzyloxy, 6-Methylbenzyloxy, 2,4-Dimethylbenzyloxy, 2,6-Dimethylbenzyloxy, 2,6-Diethylbenzyloxy, 2,4-Diethylbenzyloxy, Propylbenzyloxy, Butylbenzyloxy, 1-Methyl-1-phenyl-methoxy, 1,1-Dimethyl-1-phenyl-methoxy oder 1-Methyl-1-(2,6-dimethylphenyl)-methoxy.

C₂-C₆-Alkenyloxy enthält beispielsweise lineare oder verzweigte Alkenyl-Reste. Bevorzugt ist C₂-C₄-Alkenyloxy. Beispiele sind Allyloxy, Methallyloxy, 1,1-Dimethylallyloxy, Butenyloxy, Hexenyloxy, Octenyloxy, Undecenyloxy oder Dodecenyloxy, bevorzugt Allyloxy und Methallyloxy.

Sind etwaige Substituenten C₁-C₈-Alkylthio, so handelt es sich beispielsweise um Methylthio, Ethylthio, Isomere von Propylthio, Butylthio, Pentylthio, Hexylthio, Heptylthio oder Octylthio. Bevorzugt ist C₁-C₆-Alkylthio, insbesondere C₁-C₄-Alkylthio, beispielsweise i-Butylthio.
C₃-C₈-Cycloalkylthio steht für C₃-C₈-Cycloalkyl-S-, wobei die Cycloalkylreste wie oben beschrieben definiert werden bis zur entsprechenden Anzahl der C-Atome. Substituiertes Benzylthio oder Phenylthio kann beispielsweise ein- bis drei-fach, z.B. ein- oder zweifach, insbesondere einfach mit C₁-C₄-Alkoxy und/oder C₁-C₄-Alkyl substituiert sein. Beispiele dafür sind (4-Methyl)-, (2,4-Dimethyl)-, (2,4,6-Trimethyl)-, (4-Methoxy)-, (2,4-Dimethoxy)-, (2,4,6-Trimethoxy)-, (4-Ethoxy)-, (2,4-Diethoxy)-, (2,4,6-Trimethoxy)-, (4-Methoxy-2-methyl)-, (2,4-Dimethoxy-6-methyl)-, (4-Ethoxy-2-methyl)-, (2,4-Diethoxy-6-methyl)-benzylthio oder -phenylthio.

Halogen steht Chlor, Brom oder Iod, insbesondere Chlor oder Brom, bevorzugt Chlor.

Bilden die beiden R₉ in -N(R₉)₂ zusammen mit dem N-Atom, an welches sie gebunden sind, einen 5- oder 6-gliedrigen Heterozyklus, der neben dem N-Atom noch weitere N-, O- oder S-Atome enthalten kann, so können diese Ringe gesättigt oder vorzugsweise ungesättigt sein. Es handelt sich dabei beispielsweise um Pyrryl, Dimethylpyrryl, Piperidinyl, Morpholinyl, Piperazinyl, 4-Methylpiperazinyl, Diazolyl, Thienyl, Thiazolyl, Imidazolyl oder Oxazolyl Reste.

-N(C₁-C₄-Alkyl)₂ bedeutet z.B. Dimethylamino, Diethylamino, Dipropylamino, Dibutylamino oder Methylethylamino, insbesondere Dimethylamino.

R₅ ist z.B. C₁-C₁₂-Alkyl, bevorzugt C₁-C₈-, z.B. C₁-C₆-, insbesondere C₁-C₄-Alkyl, C₃-C₈-Cycloalkyl, insbesondere Cyclohexyl oder Cyclopentyl, oder R₅ ist Adamantyl.

Ist R₅ beispielsweise mit -NR₈R₉ substituiertes Phenyl, so sind R₈ und R₉ bevorzugt identisch und C₁-C₄-Alkyl, insbesondere Methyl.

R₁₀ als substituiertes Phenyl ist ein- oder mehrfach, besonders ein- bis dreifach, insbesondere ein- oder zweifach, bevorzugt einfach substituiertes Phenyl. Beispiele für solche Reste sind Tolyl, Mesityl, Xylyl, Ethylphenyl, Butylphenyl, Dodecylphenyl, Methoxyphenyl, Dimethoxyphenyl, Ethoxyphenyl, Diethoxyphenyl, Butoxyphenyl, Chlorphenyl, Dichlorphenyl, Trichlorphenyl, Morpholinophenyl und Dimethylaminophenyl. Alkylsubstituenten am Phenylsubstituenten haben vorzugsweise 1-4 C-Atome.

Die Verbindungen der Formel I werden allgemein durch Umsetzung eines Titanocendihalogenids mit dem Rest Q in Gegenwart einer starken Base hergestellt:

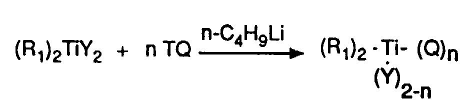

R₁, Q und n haben die Bedeutungen wie in Anspruch 1 definiert. Y steht für Chlor, Brom oder Iod, T für Wasserstoff oder Brom.

Titanocene mit Y = CN oder SCN werden durch Substitutionsreaktionen aus dem entsprechenden Titanocen mit Y = Cl hergestellt.

Titanocene mit Y = -O-CO-CH₃, -O-CO-Phenyl oder -O-SO₂-CH₃ werden analog der im US-A-4,713,401 für fluorhaltige Titanocene beschriebenen Methode hergestellt.

Die Verbindungen der Formel I (3), die als Q den Pyrimidinrest enthalten, werden beispielsweise durch Umsetzung von einem Titanocendihalogenid (1) mit einem substituierten Pyrimidin (2) in Gegenwart einer starken Base hergestellt: 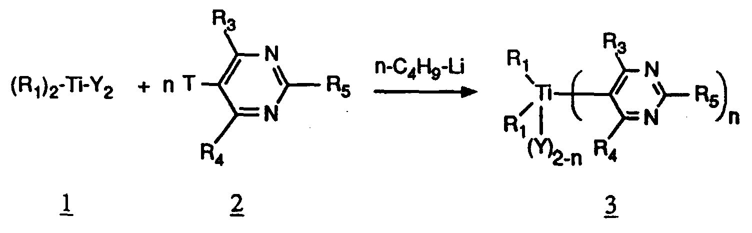 (n, R₁, R₃, R₄ und R₅ haben die in den Ansprüchen angebenen Bedeutungen, T steht für Wasserstoff oder Br, Y ist Cl, Br oder I.)
Solche Reaktionen sind beispielsweise im J. Chem. Soc. (1965), 6695 von M.D. Mehta, D. Miller und MF. Mooney beschrieben worden. Weitere Hinweise für solche Reaktionen sind D.J. Brown, The Pyrimidines Suppl. 1, 159 oder Suppl. 2, 219, Interscience publishers, John Wiley & Sons, New York-London, 1962, zu entnehmen.

In den oben beschriebenen Umsetzungen können als Basen auch beispielsweise s-Butyllithium, t-Butyllithium oder Magnesiummetall verwendet werden.

Bei der Herstellung der Titanocene mit Tris-ether-pyrimidin-Resten (R₃, R₄ und R₅= -OR) ist zu beachten, dass in der Verbindung (2) T=Br sein muss, da das entsprechende unbromierte Tris-ether-pyrimidin durch Butyllithium nicht direkt deprotoniert wird. Das entsprechende Pyrimidin wird also vor der Umsetzung mit Butyllithium und dem (R₁)₂-TiY₂ in 5-Stellung bromiert. (Vgl. J. Chem. Soc. 1965, 5467-73).

Im US-A-5 075 467 ist ein Verfahren zur Herstellung von fluorierten Titanocenen beschrieben, worin ein Titanocendihalogenid mit einem fluorierten und gegebenenfalls noch zusätzlich substituierten Phenyl in Gegenwart von Lithiumamid bei -30 bis +25°C umgesetzt wird. Es ist z.B. auch möglich die erfindungsgemässen Verbindungen analog zu diesem Verfahren herzustellen.

Die Pyrimidin-Verbindungen (2) können zum Beispiel durch Chlorierung von Barbitursäure mit POCl₃ und anschliessender Umsetsung mit Natriumalkoholaten erhalten werden. Auf diese Weise können durch Wählen der entsprechenden Stöchiometrie und Reaktionsbedingungen sowohl die Di-chlor-mono-ether-, die Mono-chlor-di-ether- als auch die Tris-ether-Verbindungen erhalten werden. (Vgl. J. Baddiley and A. Tapham, J. Chem. Soc. 1944, 679 und D.J. Brown, The Pyrimidines, Kapitel IV, 202, Interscience publishers, John Wiley & Sons, New York-London, 1962). Die Synthese von 4,6-Dichlor-2-aryl-pyrimidinen ist z.B. von J. A. Hendry und R. F. Homer im J. Chem. Soc. (1952), 328-333 beschrieben.
Die Verbindungen (2) mit Thioether-Resten werden durch Umsetzung der entsprechenden chlorsubstituierten Pyrimidine mit den entsprechenden Mecaptanen in Gegenwart einer Base, vorzugsweise Natriumhydrid, hergestellt. Ein Beispiel für die Herstellung einer solchen Verbindung mit dem Thioether-Rest in 2-Stellung: 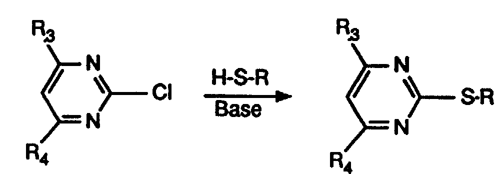 R₃ und R₄ haben die oben angegebene Bedeutung, R steht für C₁-C₈-Alkyl, unsubstituiertes oder substituiertes Benzyl oder Phenyl.
Die entsprechenden Verbindungen mit Sulfonrest werden beispielsweise aus den oben beschriebenen Alkylthioether-Verbindungen durch Oxidation mit m-Chlorperbenzoesäure hergestellt.
2-Alkylpyrimidine können z.B. aus Alkylnitrilen über die Stufe der Alkylamidine nach der von D.J. Brown im Australian J. Chem., (1977) 30, 1785-1791 beschriebenen Methode hergestellt werden.

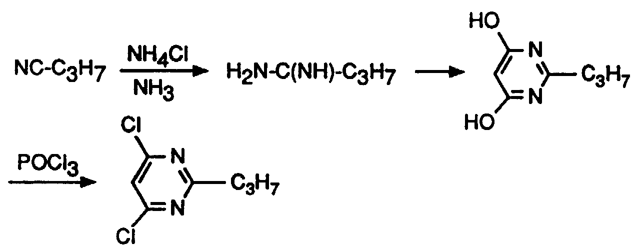

Die Herstellung der Pyrimidine mit 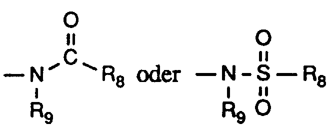 Substituenten erfolgt beispielsweise durch Umsetzung eines chlorierten Pyrimidins mit einem sekundären Amin und anschliessender N-Acylierung.

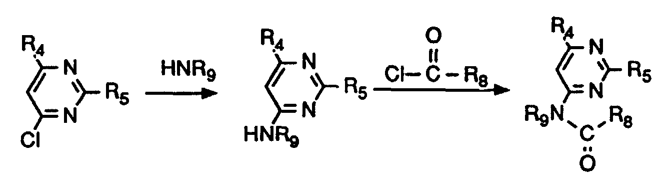

Eine andere Möglichkeit ist beispielsweise von einem Aminopyrimidin auszugehen. Dieses wird zunächst alkyliert und anschliessend acyliert. 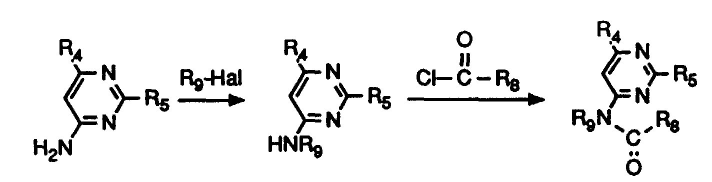 (Hal steht für Halogen, die Reste R₄, R₅, R₈ und R₉ haben die zuvor angegebene Bedeutung.)
Die Herstellung chlorierter Pyrimidine oder von Aminopyrimidinen ist allgemein bekannt.

Die Herstellung von Fünfringen mit zwei Heteroatomen 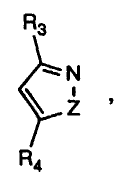 worin R₃, R₄ und Z die oben angegebene Bedeutung haben, ist in der Fachwelt allgemein bekannt und einer Vielzahl von Veröffentlichungen zu entnehmen, wie beispielsweise den J. Chem. Soc. C (1968), 466; Synthetic Commun. 20 (1990), 3213-3218; Izv. Akad. Nauk, SSSR, Ser. Khim. (1990) 3, 640, 645; Bull. Chem. Soc. Jpn (1991) 2, 719-20; Synthetic Comm. 20 (1990), 3161-3166; Synthetic Comm. 20 (1990), 2799-2804; J. Chem. Soc., Chem. Comm. (1991), 17-18; Can. J. Chem. 69 (1991), 625-631; Advances in Heterocyclic Chemistry (1979) 25, 154, 159, 171; J. Chem. Soc. C (1968), 172; Chem. Pharm. Bulletin 16 (1968), 148 oder den Uebersichtsartikeln von A.N. Kost und I.J. Grandberg in Advances in Heterocyclic Chemistry (1966) 6, 370ff; B.J. Wakefield und D.J. Wright in Advances in Heterocyclic Chemisry (1979) 25, 148ff oder K.R.H. Wooldridge Advances in Heterocyclic Chemistry (1972) 14, 12, 20, 29.

Die Edukte (IV) zw Herstellung von Verbindungen der Formel II, worin X -O- oder -S- bedeutet, können beispielsweise durch Umsetzung von 2 Aequivalenten eines substituierten Pyrimidins mit einem Aequivalent Allylendiol bzw. -thiol in Gegenwart von 2 Aequivalenten Base hergestellt werden:

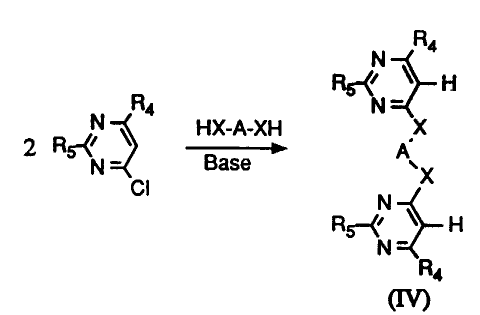

Die Edukte (V) zur Herstellung von Verbindungen der Formel II, worin X 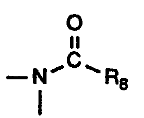 bedeutet, können beispielsweise durch Umsetzung von 2 Aequivalenten eines substituierten Pyrimidins mit einem Aequivalent des entsprechenden Bis-Aminoalkylens in Gegenwart von 2 Aequivalenten Base und anschliessender Acylierung erhalten werden: 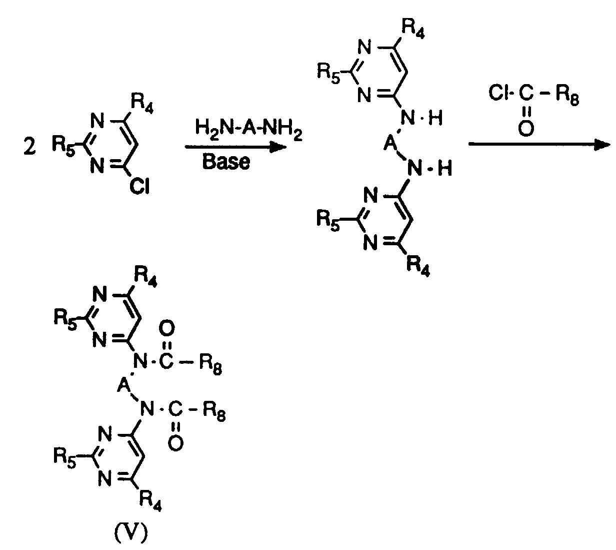 Die Edukte (VI) zw Herstellung von Verbindungen der Formel II, worin X Methylen, Ethylen, oder eine direkte Bindung bedeutet, erfolgt z.B. durch Reaktion eines Aequivalentes des entsprechenden Tetraketons mit zwei Aequivalenten eines Amidins:

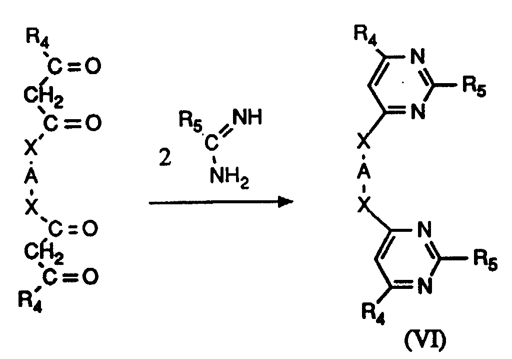

Die Verbindungen der Formeln II werden dann analog zu den Verbindungen der Formel I durch Reaktion mit (R₁)₂TiY₂ hergestellt, indem das jeweilige verwendete Pyrimidin durch die entsprechende Verbindung der Formel IV, V bzw. VI ersetzt wird. Die Reaktanden werden dabei zweckmässig im Verhältnis 1:1 eingesetzt. Interessant sind auch Verbindungen 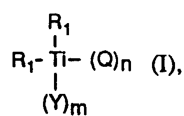 worin, beide R₁ unabhängig voneinander Cyclopentadienyl^{⊖}, lndenyl^{⊖} oder 4,5,6,7-Tetrahydroindenyl^{⊖} bedeuten, wobei diese Reste unsubstituiert oder durch C₁-C₁₈-Alkyl oder -Alkoxy, C₂-C₁₈-Alkenyl, C₅-C₈-Cycloalkyl, C₁-C₄-Alkyl-C₅-C₈-cycloalkyl, Phenyl, Naphthyl, mit Phenyl substituiertes C₁-C₁₂-Alkyl, -Si(R₂)₃, Ge(R₂)₃, Cyano, Cl, Br oder I substituiert sind und beide R₂ unabhängig voneinander C₁-C₁₂-Alkyl, C₅-C₈-Cycloalkyl, unsubstituiertes oder mit C₁-C₆-Alkyl substituiertes Phenyl oder Benzyl bedeutet,
Q für einen Rest 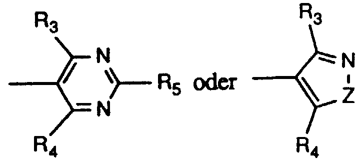 steht,
Z für -NR₁₀-, -O- oder -S- steht,
Y Cl, Br, I, CN, SCN oder -O-SO₂-CH₃ bedeutet
n 1 oder 2 ist,
m 0 oder 1 ist, wobei die Summe von n und m 2 sein muss,
R₃, R₄ und R₅ unabhängig voneinander Wasserstoff, Cl, Br, I, unsubstituiertes oder mit C₁-C₄-Alkoxy oder Phenyl substituiertes C₁-C₁₂-Alkyl, unsubstituiertes oder mit C₁-C₄-Alkyl substituiertes C₃-C₈-Cycloalkyl, unsubstituiertes oder mit C₁-C₁₂-Alkyl, Cl, Br, I, C₁-C₈-Alkylthio, -NR₈R₉ oder C₁-C₁₀-Alkoxy substituiertes Phenyl, Pyrryl, Furyl, Thienyl, Imidazolyl oder Pyridyl sind, oder R₃, R₄ und R₅ unsubstituiertes C₂-C₁₂-Alkenyl oder C₂-C₁₂-Alkenyl, welches mit unsubstituiertem oder mit C₁-C₄-Alkyl, C₁-C₄-Alkoxy, C₁-C₄-Alkylthio, Cl, Br oder I substituiertem Phenyl oder 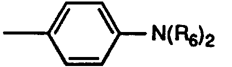 substituiert ist, bedeuten, oder R₃, R₄ und R₅ unsubstituiertes oder mit C₅-C₈-Cycloalkyl substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder C₁-C₄-Alkyl substituiertes Phenoxy, unsubstituiertes oder mit C₁-C₄-Alkyl substituiertes Benzyloxy, Tetrahydrofurfuryloxy, C₂-C₆-Alkenyloxy, -O-Si-(R₇)₃, C₁-C₈-Alkylthio, C₃-C₈Cycloalkythio, unsubstituiertes oder mit C₁-C₄-Alkyl und/oder C₁-C₄-Alkoxy substituiertes Benzylthio,unsubstituiertes oder mit C₁-C₄-Alkyl und/oder C₁-C₄-Alkoxy substituiertes Thiophenyl, -S(O)R₈, -SO₂R₈, -N(R₉)₂, 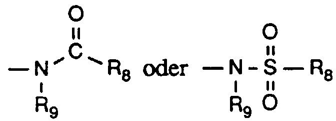 bedeuten, wobei R₃ und R₄ nicht gleichzeitig Wasserstoff bedeuten, und im Rest 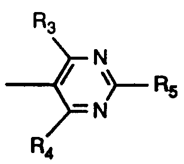 mindestens ein Rest R₃ oder R₄ unsubstituiertes oder mit C₅-C₈-Cycloalkyl substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
und im Falle, dass Z -NR₁₀- ist, R₃ und R₄ Cl, Br oder I darstellen,
beide R₆ unabhängig voneinander C₁-C₄-Alkyl oder C₂-C₁₀-Alkenyl bedeuten oder beide R₆ zusammen mit dem N-Atom, an welches sie gebunden sind einen Morpholino-Rest bilden,
R₇ für C₁-C₁₂-Alkyl, C₅-C₈-Cycloalkyl, unsubstituiertes oder mit C₁-C₆-Alkyl substituiertes Phenyl steht,
R₈ unsubstituiertes oder mit C₁-C₄-Alkyl substituiertes Phenyl oder in α-Position tertiäres C₄-C₆-Alkyl darstellt,
R₉ unsubstituiertes oder mit Phenyl, C₇-C₁₂-Alkylphenyl, C₅-C₈-Cycloalkyl oder C₁-C₄-Alkyl-C₅-C₈-cycloalkyl substituiert C₁-C₈-Alkyl, C₂-C₈-Alkenyl, unsubstituiertes oder mit C₁-C₄-Alkyl substituiertes C₅-C₈-Cycloalkyl, C₆-C₂₀-Cycloalkenylalkyl, unsubstituiertes oder mit C₁-C₁₂-Alkyl substituiertes Phenyl, einen Rest 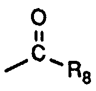 oder 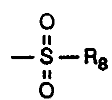 bedeutet, wobei ausserdem in -N(R₉)₂ beide R₉ gleich oder verschieden sind und die beiden R₉ zusammen mit dem N-Atom, an welches sie gebunden sind, einen 5- oder 6-gliedrigen Heterozyklus, der neben dem N-Atom noch weitere N-, O- oder S-Atome enthalten kann, bilden können, oder, falls beide Reste R₉ für eine Gruppe 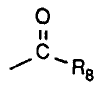 stehen, die beiden R₉ zusammen mit dem N-Atom, an welches sie gebunden sind, einen Rest 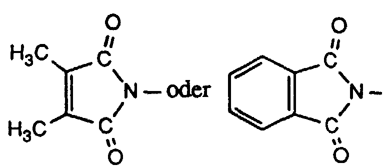 bilden, R₁₀ die gleichen Bedeutungen wie R₉ hat,
und
wenn n = 2 ist, die Formel I auch Verbindungen der Formel II umfasst, 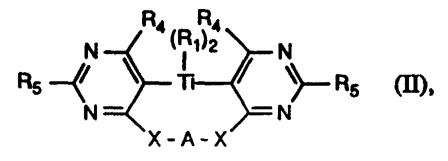 worin,
X -O-, -S-, 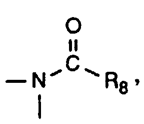 Methylen oder Ethylen bedeutet,
A für C₁-C₁₂-Alkylen steht, oder -X-A-X- für eine direkte Bindung steht.

Bevorzugt sind Verbindungen der Formeln I und II, worin beide R₁ unabhängig voneinander unsubstituiertes oder durch C₁-C₁₈-Alkyl oder -Alkoxy, C₂-C₁₈-Alkenyl, -Si(R₂)₃ oder Cl, Br, I, insbesondere C₁-C₄-Alkyl, substituiertes Cyclopentadienyl^{⊖} bedeuten.

Weitere interessante Verbindungen der Formeln I und II sind solche, worin R₃ und R₅ für unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy stehen.

Insbesondere sind solche Verbindungen bevorzugt, worin R₃ und R₅ für unsubstituiertes oder mit Cyclohexyl oder Phenoxy substituiertes C₁-C₁₂-Alkoxy, durch ein oder mehrere O-Atome unterbrochenes C₂-C₁₂-Alkoxy, unsubstituiertes odrr mit C₁-C₄-Alkyl substituiertes C₅-C₈-Cycloalkoxy, unsubstituiertes oder mit C₁-C₄-Alkoxy substituiertes Phenoxy, unsubstituiertes oder mit C₁-C₄-Alkyl substituiertes Benzyloxy, Tetrahydrofurfuryloxy oder C₂-C₆-Alkenyloxy stehen.

Interessant sind auch solche Verbindungen der Formeln I und II, worin R₅ C₁-C₈-Alkylthio, C₃-C₈Cycloalkylthio, unsubstituiertes oder mit C₁-C₄-Alkyl oder/und C₁-C₄-Alkoxy substituiertes Benzylthio, unsubstituiertes oder mit C₁-C₄-Alkyl oder/und C₁-C₄-Alkoxy substituiertes Phenylthio, -S(O)R₈ oder -SO₂R₈, insbesondere C₁-C₈-Alkylthio, bedeutet.

Insbesondere sind solche Verbindungen interessant, worin Q für einen Rest 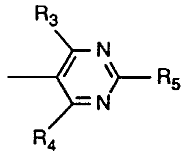 steht.

Ausserdem bevorzugt sind die Verbindungen, worin R₄ Cl, Br oder I, insbesondere Cl bedeutet.

Weitere bevorzugte Verbindungen der Formel I sind die, worin n = 2 und m = 0 ist.

Interessant sind ausserdem Verbindungen der Formel I, worin n und m 1 sind.

Ausserdem bevorzugt sind Verbindungen der Formel I, worin Y Cl, Br oder I, insbesondere Cl, ist.

Andere bevorzugte Verbindungen sind solche, worin R₃, R₄ und R₅ unabhängig voneinander für unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy stehen.

In weiteren interessanten Verbindungen der Formeln I und II bedeutet R₅ Phenyl, Pyrryl,Furyl, Thienyl, Imidazolyl, Pyridyl, Naphthyl, Anthryl, Phenanthryl oder Biphenylyl bedeuten, wobei die Reste Phenyl, Pyrryl, Furyl, Thienyl, Imidazolyl, Pyridyl, Naphthyl, Anthryl, Phenanthryl oder Biphenylyl unsubstituiert oder mit C₁-C₁₂-Alkyl, Cyclopentyl, Cyclohexyl, Cl, Br, I, C₁-C₈-Alkylthio, -NR₈R₉, Phenyl, Phenylthio oder C₁-C₁₀-Alkoxy substituiert sind.

Andere wichtige Verbindungen sind die, worin R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
R₄ für Cl steht und
R₅ unsubstituiertes oder mit C₁-C₁₂-Alkyl, Cl, Br, C₁-C₈-Alkylthio, -NR₈R₉, Phenyl, Phenylthio oder C₁-C₁₀-Alkoxy substituiertes Phenyl ist.

Ebenfalls interessant sind die Verbindungen, worin R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
R₄ für Cl steht und
R₅ C₁-C₁₂-Alkyl, C₃-C₈-Cycloalkyl oder Adamantyl ist.

Insbesondere hervorzuheben sind Verbindungen der Formel I, worin
Y Cl, -O-CO-CH₃ oder -O-CO-Phenyl ist,
R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, C₅-C₈-Cycloalkoxy, Benzyloxy, Tetrahydrofurfuryloxy oder Cl bedeutet,
R₄ die für R₃ definierten Bedeutungen hat und zusätzlich Wasserstoff ist und
R₅ die für R₃ gegebenen Bedeutungen hat und zusätzlich Wasserstoff, C₁-C₁₂-Alkyl, C₁-C₈-Alkylthio, Pyrryl, unsubstituiertes oder mit Cl, C₁-C₁₀-Alkoxy, Phenyl, C₁-C₈-Alkylthio, Phenylthio oder -NR₈R₉ substituiertes Phenyl ist und
R₁₀ für Phenyl steht.

Bevorzugt sind Verbindungen der Formel I.

Hervorzuheben sind auch Verbindungen der Formel I, worin Q 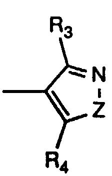 bedeutet.

Bevorzugte Verbindungen der Formel I, worin Q für 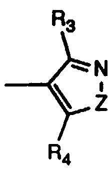 steht, sind die, worin
R₃ und R₄ Cl bedeuten,
Z für -NR₁₀- steht und
R₁₀ unsubstituiertes oder mit Cl, Br, I, NO₂, C₁-C₁₂-Alkyl, C₁-C₁₀-Alkoxy, C₁-C₈-Alkylthio, Phenylthio, Morpholino oder -N(C₁-C₄-Alkyl)₂ substituiertes Phenyl darstellt.

Die erfindungsgemässen Verbindungen der Formeln I und II können, bedingt durch bestimmte Substituenten, in mehreren verschiedenen Konformeren vorliegen. Die Erfindung umfasst alle entstehenden Konformere.

Erfindungsgemäss können die Verbindungen der Formel I und II als Photoinitiatoren für die Photopolymerisation von ethylenisch ungesättigten Verbindungen bzw. Gemischen, die solche Verbindungen enthalten, verwendet werden.
Diese Verwendung kann auch in Kombination mit einem anderen Photoinitiator und/oder anderen Additiven erfolgen.

Die Erfindung betrifft daher auch photopolymerisierbare Zusammensetzungen, enthaltend
(a) mindestens eine ethylenisch ungesättigte photopolymerisierbare Verbindung und
(b) als Photoinitiator mindestens eine Verbindung der Formel I oder II
wobei die Zusammensetzung ausserdem noch einen anderen Photoinitiator (c) und/oder andere Additive enthalten kann.

Als Photoinitiator (c) kommen beispielsweise solche vom Typ der Titanocene, welche nicht der Formel I oder II entsprechen, Benzoinalkylether, Benzophenone, Benzilketale, 4-Aroyl-1,3-dioxolane, Dialkoxyacetophenone, α-Hydroxy- oder α-Aminoacetophenone, α-Hydroxycycloalkylphenylketone, Mono- oder Bisacylphosphinoxide, oder Mischungen davon, in Frage.
Mischungen solcher Photoinitiatoren (c) mit Titanocenen sind beispielsweise in der EP-A-242 330 und dem US Patent 4,960,746 beschrieben. Die erfindungsgemässen neuen Titanocene der Formeln I und II können ebenfalls in den dort beschriebenen Mischungen als Titanocenkomponente verwendet werden.

Enthalten die erfindungsgemässen Zusammensetzungen zusätzlich zum Photoinitator (b) noch einen oder mehrere weitere Photoinitiatoren (c), so kann das Gewichtsverhältnis der beiden Komponenten (c):(b) z.B. von 1:1 bis 30:1, bevorzugt von 5:1 is 15:1 betragen.

Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Interessant sind auch Silicon-acrylate. Weitere Beispiele sind Acrylinitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylen- glykol-, Neopentylglykol-, Hexamethylenglykol- oder Bisphenol-A-diacrylat, 4,4'-Bis(2- acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte oder Vinylether- oder Epoxy-Gruppen enthaltende Polyester, Polyurethane und Polyether. Weitere Beispiele für ungesättigteOligomere sind ungesättigte Polyesterharze, die meist aus Maleinsäure, Phthalsäure und einem oder mehreren Diolen hergestellt werden und Molekulargewichte von etwa 500 bis 3000 besitzen. Daneben können auch Vinylether-Monomere und -Oligomere, sowie maleat-terminierte Oligomere mit Polyester-, Polyurethan-, Polyether-, Polyvinylether- und Epoxidhauptketten eingesetzt werden. Insbesondere Kombinationen von Vinylethergruppen tragenden Oligomeren und Polymeren, wie sie in der WO 90/01512 beschrieben sind, sind gut geeignet. Aber auch Copolymere aus Vinylether und Maleinsäure funktionalisierten Monomeren kommen in Frage. Solche ungesättigten Oligomere kann man auch als Prepolymere bezeichnen.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien-Copolymere, Polyisopren und Isopren-Copolymere, Polymere und Coplymere mit (Meth)Acrylgruppen in Seitenketten, sowie Mischungen von einem oder mehreren solcher Polymerer.

Beispiele für ungesägttigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hyroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Tri- ethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrycrylat, Oligoesteracrylate und -methacrylate, Glycerindi- und -triacrylat, 1,4-Cyclo- hexandiacrylat, Bisacrylate und Bismethacrylate von Polyethylenglykol mit Molekular- gewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Poly- amine sind Ethylendiamin, 1,2- oder 1,3-Propylendiamin, 1,2-, 1,3- oder 1,4-Butylen- diamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β- aminoethylether, Diethylentriamin, Triethylentetramin, Di-(β-aminoethoxy)- oder Di- (β-aminopropoxy)ethan. Weitere geeignete Polyamine sind Polymere und Copolymere mit gegebenenfalls zusätzlichen Aminogruppen in der Seitenkette und Oligoamide mit Aminoendgruppen. Beispiele für solche ungesättigten Amide sind:
Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Vinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 40-90 Gew.-% betragen, bezogen auf den Gesamtfestkörper. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000-1 000 000. Beispiele sind: Homo- und Copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copoly- mere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösemitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenann- ten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon, Hydrochinonderivate, p-Methoxyphenol, β-Naphtol oder sterish gehinderte Phenole wie z.B. 2.6-Die(tert-bu- tyl)-p-kresol. Zur Erhöhung der Dunkellagerstabilität können z.B. Kupferverbindungen, wie Kupfernaphthenat, -stearat oder -octat, Phosphorverbindungen, wie z.B. Triphenyl- phosphin, Tributylphosphin, Triethylphosphit, Triphenylphosphit oder Tribenzylphosphit quartäre Ammoniumverbindungen, wie z.B. Tetramethylammoniumchlorid oder Tri- methyl-benzylammoniumchlorid, oder Hydroxylaminderivate, wie z.B. N-Diethylhydroxylamin verwendet werden. Zwecks Ausschluss des Luftsauerstoffes während der Polymerisation kann man Paraffin oder änhliche wachsartige Stoffe zusetzen, die bei Beginn der Polymerisation wegen mangelnder Löslichkeit im Polymeren an die Oberfläche wandern und eine transparente Oberflächenschicht bilden, die den zutritt von Luft verhindert. Als Lichtschutzmittel können in geringer Menge UV-Absorber, wie z.B. solche vom Benztriazol-, Benzophenon-, Oxalanilid- oder Hydroxyphenyl-s-triazin-Typ, zugesetzt werden. Noch besser ist der Zusatz von Lichtschutzmitteln, die UV-Licht nicht absorbieren, wie z.B. von sterisch gehinderten Aminen (HALS).

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons. Als Sauerstofffänger brauchbare Amine sind beispielsweise substituierte N,N-dialkylaniline, wie sie in der EP-A- 339 841 beschrieben sind.
Eine Beschleunigung der Photopolymerisation kann weiterhin durch Zusatz von Photo- sensibilisatoren geschehen, welche die spektrale Empfindlichkeit verschieben bzw. verbreitern. Dies sind insbesondere aromatische Carbonylverbindungen wie z.B. Benzo- phenon-, Thioxanthon-, Anthrachinon- und 3-Acylcumarinderivate sowie 3-(Aroyl- methylen)-thiazoline, aber auch Eosin-, Rhodamin- und Erythrosin-Farbstoffe.

Die erfindungsgemässen Zusammensetzungen können auch einen photoreduzierbaren Farbstoff, wie z.B. Xanthen-, Benzoxanthen, Benzothioxanthen, Thiazin-, Pyronin, Porphyrin- oder Acridinfarbstoffe, und/oder eine durch Strahlung spaltbare Trihalogenmethylverbindung enthalten. Aehntliche Zusammensetzungen sind beispielweise in der EP-A-445 624 beschrieben.

Weitere übliche Zusätze sind - je nach Verwendungszweck - optische Aufheller, Füllstoffe, Pigmente, Farbstoffe, Netzmittel oder Verlaufhilfsmittel. Zur Härtung dicker und pigmentierter Beschichtungen eignet sich der Zusatz von Mikro-Glaskugeln oder pulverisierter Glasfasern, wie z.B. im US-A-5 013 768 beschrieben.

Gegenstand der Erfindung sind auch Zusammensetzungen enthaltend als Komponente (a) mindestens eine in Wasser gelöste oder emulgierte ethylenisch ungesättigte photopolymerisierbare Verbindung.

Solche strahlungshärtbaren wässrigen Prepolymerdispersionen sind in vielen Variationen im Handel erhältlich. Man versteht darunter eine Dispersion aus Wasser und mindestens einem darin dispergierten Prepolymeren. Die Konzentration des Wassers in diesen Systemen liegt z.B. bei 5 bis 80, insbesondere 30 bis 60 Gew.-%. Das strahlungshärtbare Prepolymere bzw. Prepolymerengemisch ist beispielsweise in Konzentrationen von 95 bis 20, insbesonre 70 bis 40 Gew.-% enthalten. In diesen Zusammensetzungen ist die Summe der für Wasser und Prepolymere genannten Prozentzahlen jeweils 100, die Hilfs- und Zusatzstoffe kommen, je nach Verwendungszweck in unterschiedlichen Mengen hinzu.

Bei den strahlungshärtbaren, in Wasser dispergierten, oft auch gelösten filmbildenden Prepolymeren handelt es sich um für wässrige Prepolymerdispersionen an sich bekannte, durch freie Radikale initiierbare mono- oder polyfunktionelle ethylenisch ungesättigte Prepolymere, die beispielsweise einen Gehalt von 0,01 bis 1,0 Mol pro 100 g Prepolymer an polymerisierbaren Doppelbindungen, sowie ein mittleres Molekulargewicht von z.B. mindestens 400, insbesondre von 500 bis 10000 aufweisen. Je nach Anwendungszweck kommen jedoch auch Prepolymere mit höheren Molekulargewichten in Frage.
Es werden beispielsweise polymerisierbare C-C-Doppelbindungen enthaltende Polyester mit einer Säurezahl von höchstens 10, polymerisierbare C-C-Doppelbindungen enthaltende Polyether, hydroxylgruppenhaltige Umsetzungsprodukte aus einem mindestens zwei Epoxidgruppen pro Molekül enthaltenden Polyepoxid mit mindestens einer α,β-ethylenisch ungesättigten Carbonsäure, Polyurethan(meth-)acrylate sowie α,β-ethylenisch ungesättigte Acrylreste enthaltende Acrylcopolymere verwendet, wie sie in der EP-A-12 339 beschrieben sind. Gemische dieser Prepolymeren können ebenfalls verwendet werden. In Frage kommen ausserdem die in der EP-A-33 896 beschriebenen polymerisierbaren Prepolymere, bei denen es sich um Thioetheraddukte von polymerisierbaren Prepolymeren mit einem mittleren Molekulargewicht von mindestens 600, einem Carboxylgruppengehalt von 0,2 bis 15 % und einem Gehalt von 0,01 bis 0,8 Mol polymerisierbarer C-C-Doppelbindungen pro 100 g Prepolymer handelt. Andere geeignete wässrige Dispersionen auf Basis von speziellen (Meth-)-Acrylsäurealkylester-Polymerisaten sind in der EP-A-41 125 beschrieben, geeignete in Wasser dispergierbare, strahlungshärtbare Prepolymere aus Urethanacrylaten sind der DE-A-29 36 039 zu entnehmen.
Als weitere Zusätze können diese strahlungshärtbaren wässrigen Prepolymerdispersionen Dispergierhilfsmittel, Emulgatoren, Antioxidantien, Lichtstabilisatoren, Farbstoffe, Pigmente, Füllstoffe, z.B. Talkum, Gips, Kieselsäure, Rutil, Russ, Zinkoxid, Eisenoxide, Reaktionsbeschleuniger, Verlaufsmittel, Gleitmittel, Netzmittel, Verdickungsmittel, Mattierungsmittel, Entschäumer und andere in der Lacktechnologie übliche Hilfsstoffe enthalten. Als Dispergierhilfsmittel kommen wasserlösliche hochmolekulare organische Verbindungen mit polaren Gruppen, wie z.B. Polyvinylalkohole, Polyvinylpyrrolidon oder Celluloseether in Frage. Als Emulgatoren können nicht-ionische, gegebenenfalls auch ionische Emulgatoren verwendet werden.

Die photopolymerisierbaren Zusammensetzungen enthalten den Photoinitiator (b) zweck- mässig in einer Menge von 0,05 bis 15 Gew.-%, vorzugsweise 0,2 bis 5 Gew.-%, bezogen auf die Zusammensetzung.

In bestimmten Fällen kann es von Vorteil sein, Gemische von zwei oder mehr der erfin- dungsgemässen Photoinitiatoren zu verwenden. Selbstverständlich können auch Gemische mit bekannten Photoinitiatoren verwendet werden, z.B. Gemische mit Benzophenon, Acetophenonderivaten, wie beispielsweise α-Hydroxycycloalkylphenylketonen, Dialkoxyacetophenonen, α-Hydroxy- oder α-Aminoacetophenonen, 4-Aroyl-1,3-Dioxolanen, Benzoinalkylethern und Benzilketalen, Monoacylphosphinoxiden, Bisacylphosphinoxiden oder weiteren Titanocenen. Im Falle des Einsatzes der erfindungsgemäßen Photoinitiatoren in Hybridsystemen werden zusätzlich zu den erfindungsgemäßen radikalischen Härtern kationische Photoinitiatoren wie z.B. aromatische Sulfonium- oder Iodonium-Salze oder Cyclopentadienyl-aren-eisen(II)-Komplexsalze verwendet.

Die photopolymerisierbaren Zusammensetzungen können für verschiedene Zwecke ver- wendet werden, beispielsweise als Druckfarbe, als Klarlack, als Weisslack, z.B. für Holz oder Metall, als Anstrichstoff, u.a. für Papier, Holz, Metall oder Kunststoff, als tageslichthärtbarer Anstrich für Bauten- und Straßenmarkierung, für photographische Reproduktionsverfahren, für holographische Aufzeichnungsmaterialien, für Bildauf- zeichnungsverfahren oder zur Herstellung von Druckplatten, die mit organischen Lösemitteln oder wässrig-alkalisch entwickelbar sind, zur Herstellung von Masken für den Siebdruck, als Zahnfüllmassen, als Klebstoffe, als drucksensitive Klebstoffe, als Laminierharze, als Aetz- oder Permanentresists und als Lötstoppmasken für elektronische Schaltungen, zur Herstellung von dreidimensionalen Gegenständen durch Massenhärtung (UV-Härtung in transparenten Formen) oder nach dem Stereolithographie-Verfahren, wie es z.B. im US-Patent Nr. 4,575,330 beschrieben ist, zur Herstellung von Verbundwerkstoffen (z.B. styrolischen Polyestern, die gegebenenfalls Glasfasern und andere Hilfsstoffe enthalten können) und anderen dickschichtigen Massen, zur Beschichtung oder Versiegelung von elektronischen Teilen oder als Ueberzüge für optische Fasern.
Die erfindungsgemäßen Verbindungen können weiterhin als Initatoren für Emulsionspolymerisationen, als Initiatoren einer Polymerisation für die Fixierung von Ordnungszuständen von flüssigkristallinen Mono- und Oligomeren, sowie zur Härtung von Pulverlacken verwendet werden.

In Lacken verwendet man häufig Gemische eines Prepolymeren mit mehrfach ungesättigten Monomeren, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwendet muss.

Ungesättigte Polyesterharze werden meist in Zweikomponentensystemen zusammen mit einem einfach ungesättigten Monomer, vorzugsweise mit Styrol, verwendet. Für Photo- resists werden oft spezifische Einkomponentensysteme verwendet, wie z.B. Polymalein- imide, Polychalkone oder Polyimide, wie sie in der DE-OS 2 308 830 beschrieben sind.

Die erfindungsgemässen photohärtbaren Zusammensetzungen eignen sich z.B. als Beschichtungsstoffe für Substrate aller Art, z.B. Holz, Textilien, Papier, Keramik, Glas, Kunststoffe wie Polyester, Polyethylenterephthalat, Polyolefine oder Celluloseacetat, insbesondere in Form von Filmen, sowie Metalle wie Al, Cu, Ni, Fe, Zn, Mg oder Co und GaAs, Si oder SiO₂, auf denen eine Schutzschicht oder durch bildmässiges Belichten eine Abbildung aufgebracht werden soll.

Die Beschichtung der Substrate kann erfolgen, indem man eine flüssige Zusammen- setzung, eine Lösung oder Suspension auf das Substrat aufbringt. Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder entfernt werden können. Geeignete Lösungsmittel sind z.B. Ketone, Ether und Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester und 3-Ethoxy-propionsäureethylester.
Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Roll-Beschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Der Schichtdickenbereich umfasst im allgemeinen Werte von ca 0,1 µm bis mehr als 10 µm.

Die erfindungsgemässen strahlungsempfindlichen Zusammensetzungen finden Anwendung als Negativresists, die eine sehr hohe Lichtempfindlichkeit aufweisen und schwellungsfrei in wässrig-alkalischem Medium entwickelt werden können. Sie eignen sich als Photoresists für die Elektronik (Galvanoresist, Aetzresist, Löststopresist), die Herstellung von Druckplatten, wie Offsetdruckplatten oder Siebdruckformen, den Einsatz beim Formteilätzen oder den Einsatz als Mikroresist bei der Herstellung integrierter Schaltkreise. Dementsprechend unterschielich sind die möglichen Schichträger und dieVerarbeitungsbedindungen der beschichteten Substrate.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 µm bis 10 µm, für gedruckte Schaltungen 0,4 µm bis ca. 2 µm.

Nach dem Beschichten der Substrate wird das Lösungsmittel in der Regel durch Trocknen entfernt, und es resultiert eine Schicht des Photoresists auf dem Träger.

Der Begriff "bildmässige" Belichtung beinhaltet sowohl die Belichtung durch eine Photomaske, die ein vorbestimmtes Muster enthält, beispielsweise ein Diapositiv, die Belichtung durch einen Laserstrahl der beispielsweise computergesteuert über die Oberfläche des beschichteteten Substrates bewegt wird und auf diese Weise ein Bild erzeugt, sowie die Bestrahlung mit computergesteuerten Elektronenstrahlen.

Nach der bildmässigen Belichtung des Materials und vor der Entwicklung kann es vorteilhaft sein, für kürzere Zeit ein thermische Behandlung durchzuführen. Dabei werden nur die belichteten Teile thermisch gehärtet. Die angewandten Temperaturen liegen im allgemeinen bei 50-150 °C, bevorzugt bei 80-130 °C; die Zeit für die thermische Behandlung liegt in der Regel zwischen 0,25 und 10 Minuten.

Die photohärtbare Zusammensetzung kann weiterhin in einem Verfahren zur Herstellung von Druckformen oder Photoresists wie es z.B. in der DE-A-4013358 beschrieben wird verwendet werden. Darin wird die Zusammensetzung vor, zugleich mit oder nach der bildmäßigen Bestrahlung kurzzeitig mit sichtbarem Licht einer Wellenlänge von mindestens 400 nm ohne Maske belichtet.

Nach der Belichtung und gegebenenfalls thermischen Behandlung werden die unbelichteten Stellen des Photolacks in an sich bekannter Weise mit einem Entwickler entfernt.

Die erfindungsgemässen Zusammensetzungen sind -wie schon erwähnt- wässrig-alkalisch entwickelbar. Geeignete wässrig-alkalische Entwickler-Lösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwicklerflüssigkeiten in kleinen Mengen zugesetzt werden können, sind beispielsweise Cyclohexanon, 2-Ethoxyethanol, Toluol, Aceton sowie Mischungen solcher Lösungsmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Farben von Bedeutung.

Gut geeignet sind die erfindungsgemässen Gemische -wie oben bereits erwähnt- auch zur Herstellung von Druckplatten. Hierbei werden z. B. Gemische von löslichen linearen Polyamiden oder Styrol/Butadien bzw. Styrol/Isopren Kautschuk, Polyacrylaten oder Polymethylmethacrylaten mit Carboxyl-Gruppen, Polyvinylalkoholen oder Urethanacrylaten mit photopolymerisierbaren Monomeren, beispielsweise Acryl- bzw. Methacrylamiden oder Acryl- bzw. Methacrylestern, und einem Photoinitiator verwendet. Filme und Platten aus diesen Systemen (nass oder trocken) werden über das Negativ (oder Positiv) der Druckvorlage belichtet und die ungehärteten Teile anschliessend mit einem geeigneten Lösemittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung auf Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplattenhüllen oder Buchumschlägen.

Wichtig ist auch die Verwendung von photohärtbaren Zusammensetzungen für Abbildungsverfahren und zur optischen Herstellung von Informationsträgern. Hierbei wird -wie oben bereits beschrieben- die auf dem Träger aufgebrachte Schicht (nass oder trocken) durch eine Photomaske mit UV oder sichtbarem Licht bestrahlt und die unbelichteten Stellen der Schicht durch Behandlung mit einem Lösemittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte elektronische Schaltungen und Photoresists herstellen.

Die Lichtempfindlichkeit der erfindungsgemässen Zusammensetzungen reicht in der Regel vom UV-Gebiet (ca.200 nm) bis ca. 600 nm und umspannt somit einen sehr breiten Bereich. Geeignete Strahlung enthält z.B. Sonnenlicht oder Licht, aus künstlichen Lichtquellen. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilbermitteldruck-, -hochdruck- und -niederdruckstrahler, gegebenenfalls mit Metall-Halogeniden dotiert (Metall-Halogenlampen), mikrowellenangeregte Metalldampflampen, Excimer Lampen, superaktinische Leuchtstoffröhren, Fluoreszenzlampen, Argonglühlampen, Elektronenblitzlampen, photographische Flutlichtlampen, Elektronenstrahlen und Röntgenstrahlen, erzeugt mittels Synchrotronen oder Laser-Plasma. Der Abstand zwischen Lampe und erfindungsgemässem zu belichtendem Substrat kann je nach Anwendungszweck und Lampentyp bzw. -stärke variieren, z.B. zwischen 2 cm bis 150 cm. Speziell geeignet sind Laserlichtquellen, z.B. Excimer-Laser, wie Krypton-F-Laser zur Belichtung bei 248 nm. Auch Laser im sichtbaren Bereich können eingesetzt werden. Hier ist die hohe Empfindlichkeit der erfindungsgemässen Materialien sehr vorteilhaft. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Erfindungsgegenstand ist auch die Verwendung der oben beschriebenen Zusammensetzung zur Herstellung von Lacken, Druckfarben, Druckplatten, Dentalmassen, Resistmaterialien sowie als Bildaufzeichnungsmaterial, insbesondere für holographische Aufzeichnungen.

Ebenfalls Gegenstand der Erfindung ist ein beschichtetes Substrat, das auf mindestens einer Oberfläche mit einer wie oben beschriebenen Zusammensetzung beschichtet ist, sowie ein Verfahren zur photographischen Herstellung von Reliefabbildungen, in welchem ein beschichtetes Substrat bildmässig belichtet wird und danach die unbelichteten Anteile mit einem Lösemittel entfernt werden.

Gegenstand der Erfindung ist daher auch ein Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I oder II zugibt und mit Licht im Bereich von 200 bis 600 nm bestrahlt.

Die nachfolgenden Beispiele erläutern die Erfindung weiter. Angaben in Teilen oder Prozenten beziehen sich, ebenso wie in der übrigen Beschreibung und in den Patent- ansprüchen, auf das Gewicht, sofern nichts anderes angegeben ist.

### I) Herstellung der Edukte

### Beispiel 1: Herstellung von 2,4-Dibenzyloxy-6-chloro-pyrimidin

Die Reaktion wird unter Argon Schutzgasatmosphäre durchgeführt. Zu 9,6 g NaH (0,24 Mol, 60 %ige Suspension in Paraffin) in 120 ml Tetrahydrofuran (THF) werden 24,8 ml (0,24 Mol) absoluter Benzylalkohol in 100 ml THF bei 25 °C getropft. Die Reaktionsmi- schung wird 0,5 h auf 50 °C erwärmt, abgekühlt und dann tropfenweise zu einer auf 0 °C abgekühlten Lösung von 13,8 ml 2,4,6-Trichlorpyrimidin in 100 ml THF gegeben. Ueber Nacht wird auf 25 °C erwärmen lassen, und die entstandene Mischung wird auf 200 ml Wasser gegossen. Nach dreimaliger Extraktion mit Toluol werden die vereinigten or- ganischen Phasen mit 100 ml Wasser gewaschen, mit MgSO₄ getrocknet und nach dem Filtrieren am Rotationsverdampfer eingeengt. Nach der Filtration auf Kieselgel (Laufmittel Essigsäureethylester:Hexan 1:1) erhält man 39,9 g (100 % d. Theorie) des Titelproduktes.

### Beispiel 2: Herstellung von 2,4-Isopropyloxy-6-chloro-pyrimidin

Die Reaktion wird unter Argon Schutzgasatmosphäre durchgeführt. 4,6 g Natrium in kleinen Stücken werden mit 180 ml Isopropanol 4 h am Rückfluss erhitzt. Nach dem Abkühlen entsteht ein leichter Niederschlag, der mit 50 ml THF aufgelöst wird. Diese Lösung wird, auf 0 °C abgekühlt, tropfenweise zu einer Lösung von 11,5 ml (0,1 Mol) 2,4,6-Trichlorpyrimidin in 20 ml absolutem Isopropanol gegeben. Sofort fällt ein weisser Niederschlag aus. Die Reaktionsmischung wird über Nacht auf 25 °C erwärmen lassen. Laut Dünnschichtchromatographie enthält sie kein Edukt mehr. Die Lösemittel werden am Rotationsverdampfer entfernt und der Rückstand in 100 ml Toluol aufgenommen. Die entstandene Suspension wird zweimal mit 100 ml Wasser behandelt, die wässrigen Phasen nochmals mit 100 ml Toluol extrahiert. Die organischen Phasen werden vereinigt und mit MgSO₄ getrocknet. Nach dem Filtieren wird das Lösemittel entfernt, und man erhält 22,8 g Rückstand (99,1 %). Die Trennung über SiO₂ (Laufmittel:Diethylether:Hexan 5:95) ergibt 18 g (78,3 % d. Theorie) der reinen Titelverbindung.

### Beispiel 3: Herstellung von 6-Chloro-4-(3-methyl-but-1-oxy)-2-phenyl-pyrimidin

Die Reaktion wird unter Argon Schutzgasatmosphäre durchgeführt. Zu einer auf 0 °C abgekühlten Lösung von 12,4 g 4,6-Dichloro-2-phenyl-pyrimidin in 50 ml 3-Methylbutan- ol wird tropfenweise eine Lösung von 6,7 g (60,5 mMol) Natrium-t-amylat in 50 ml 3-Methylbutanol gegeben. Ueber Nacht wird die Reaktionsmischung auf 25 °C erwärmen lassen. Sie enthält nach Dünnschichtchromatogramm kein Edukt mehr. Die Reaktions- mischung wird auf 180 ml Wasser gegossen und dreimal mit 80 ml Essigsäureethylester extrahiert. Die vereinigten organischen Phasen werden mit Wasser gewaschen, mit MgSO₄ getrocknet und filtriert. Nach dem Entfernen des Lösemittels werden 14,6 g (96 % d. Theorie) der Titelverbindung erhalten.

| Elementaranalyse: | | | | | |
|---|---|---|---|---|---|
| ber. | C | 69,1 % | gef. | C | 69,1 % |
| | H | 6,2 % | | H | 6,4 % |
| | N | 10,1 % | | N | 10,0 % |
| | Cl | 12,8 % | | Cl | 12,6 % |

### Beispiel 4: Herstellung von 6-Chloro-2,4-diethoxy-pyrimidin

Unter Argon-Schutzgasatmosphäre werden zu 100 ml absolutem Ethanol 7,35 g (0,32 Mol) Natrium in kleinen Stücken gegeben. Die Suspension wird solange am Rückfluss gehalten, bis das Natrium gelöst ist. Die Lösung wird abgekühlt und bei 0 °C zu einer Lösung aus 18,4 ml (0,16 Mol) 2,4,6-Trichloropyrimidin in 100 ml Ethanol getropft. Die Temperatur wird langsam auf 25 °C gebracht, das Ethanol am Rotationsverdampfer entfernt und 100 ml Wasser werden zugegeben. Danach wird dreimal mit 100 ml Toluol extrahiert. Die vereinigten organischen Phasen werden zweimal mit je 100 ml Wasser gewaschen, über MgSO₄ getrocknet, filtriert und eingeengt. Es resultieren 32,5 g rohes Produkt. Die Reinigung durch SiO₂-Flash-Chromatographie mit Hexan als Laufmittel liefert 24,9 g (76,9 % d. Theorie).

| Elementaranalyse | | | | | |
|---|---|---|---|---|---|
| ber. | C | 47,4 % | gef. | C | 48,3 % |
| | H | 5,5 % | | H | 5,8 % |
| | N | 13,8 % | | N | 13,8 % |
| | Cl | 17,5 % | | Cl | 17,0 % |

### Beispiele 5-8:

Die Verbindungen der Beispiele 5-8 werden analog zu den Verbindungen der Beispiele 1 oder 3 hergestellt und sind der folgenden Tabelle 1 zu entnehmen.

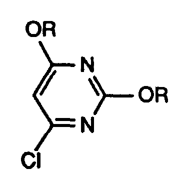

**Tabelle 1**

| Bsp. | R | Synthese | Ausbeute [%] | Elementaranalyse [%] | | |
|---|---|---|---|---|---|---|
| | | | | Atom | berechnet | gefunden |
| 5 | MethoxyEthyl | A | 48,3 | C | 45,7 | 46,7 |
| | | | | H | 5,8 | 5,7 |
| | | | | N | 10,7 | 10,5 |
| 6 | 3-Methylbut-1-yl | C | 51,3 | C | 58,6 | 59,7 |
| | | | | H | 8,1 | 8,3 |
| | | | | N | 9,8 | 9,4 |
| | | | | Cl | 12,4 | 12,2 |
| 7 | Cyclohexyl | A | 42,8 | C | 61,8 | 61,4 |
| | | | | H | 7,5 | 7,6 |
| | | | | N | 9,0 | 8,8 |
| | | | | Cl | 11,4 | 12,7 |
| 8 | Cyclohexylmethyl | A | 99,9 | C | 63,8 | 64,2 |
| | | | | H | 8,0 | 8,3 |
| | | | | N | 8,3 | 8,1 |
| | | | | Cl | 10,5 | 10,4 |
| A: Methode nach Beispiel 1 | | | | | | |
| C: Methode nach Beispiel 3 | | | | | | |

### Beispiel 9: Herstellung von 2,4-Dichloro-6-(3-methyl-but-1-oxy)-pyrimidin

Eine Lösung von 28,6 g (0,26 Mol)Natrium-tert-Amylat in 150 ml 3-Methyl-butanol wird 30 Minuten bei 45-50 °C gerührt, auf 20 °C abgekühlt und einer Lösung von 30 ml (0,26 Mol) Trichlorpyrimidin in 150 ml 3-Methylbutanol bei -30 °C tropfenweise zugegeben. Nach der Zugabe der Lösung ist die Temperatur bei 0 °C. Die Reaktionsmischung wird über Nacht stehen gelassen. Das Lösemittel wird entfernt und der Rückstand in 150 ml Wasser aufgenommen. Dreimalige Extraktion mit Toluol, Trocknung der vereinigten organischen Phasen mit MgSO₄ und Einengen liefert 60,36 g (98,7 % d. Theorie) der Titelverbindung.

| Elementaranalyse: | | | | | |
|---|---|---|---|---|---|
| ber. | C | 46,0 % | gef. | C | 45,9 % |
| | H | 9,1 % | | H | 9,1 % |
| | N | 11,9 % | | N | 12,0 % |
| | Cl | 30,2 % | | Cl | 30,6 % |

### Beispiel 10: Herstellung von 6-Chloro-2-isobutylthio-4-(3-methyl-but-1-oxy)-pyrimidin

Zu einer Suspension von 2,2 g NaH in 90 ml THF wird eine Lösung von 6,7 ml (55,3 mMol) Isobutylmercaptan in 40 ml THF getropft. Dabei wird mit Hilfe von Kühlung verhindert, dass die Temperatur über 50 °C steigt. Die Lösung wird auf 20 °C abgekühlt und zu einer Lösung von 13,0 g 2,4-Dichloro-6-(3-methyl-but-1-oxy)-pyrimidin in 80 ml THF bei -10 °C gegeben. Nachdem die Temperatur langsam auf 25 °C gekommen ist, wird die Reaktionsmischung auf 200 ml Wasser gegossen. Dreimalige Extraktion mit Toluol, Trocknen der vereinigten organischen Phasen mit MgSO₄ und Verdampfen des Lösemittels liefert 17,3 g eines Gemisches. Nach der Trennung über SiO₂ (Petrolether 80 °-110 °) werden 11,5 g (71,9 % d. Theorie) des Titelproduktes erhalten.

| Elementaranalyse: | | | | | |
|---|---|---|---|---|---|
| ber. | C | 54,1 % | gef. | C | 57,2 % |
| | H | 7,3 % | | H | 8,0 % |
| | N | 9,7 % | | N | 8,8 % |
| | S | 11,1 % | | S | 10,4 % |
| | Cl | 12,3 % | | Cl | 11,0 % |

### Beispiel 11: Herstellung von 5-Brom-2,4-di(1,1-dimethylpropyloxy)-pyrimidin

11.1: 5-Bromuracil
39,4 g (0,35 Mol) Uracil werden in 200 ml Essigsäure gelöst und die Mischung auf 70 °C erwärmt. Wärhend 2 h werden zu dieser Lösung 20 ml (0,38 Mol) Brom, in 200 ml Essigsäure gelöst, getropft. Die orange Suspension wird über Nacht auf 70 °C gehalten, danach auf 0-5 °C gekühlt. Der erhaltene Niederschlag wird abfiltriert, mit 200 ml kaltem Wasser gewaschen und getrocknet. Es resultieren 60,2 g 5-Bromuracil (89,7 % d. Theorie).

| Elementaranalyse: | | | | | |
|---|---|---|---|---|---|
| ber. | C | 25,16 % | gef. | C | 25,26 % |
| | H | 1,58 % | | H | 1,62 % |
| | N | 14,67 % | | N | 14,69 % |
| | Br | 41, 84 % | | Br | 41,66 % |

11.2: 5-Brom-2,4-dichloropyrimidin
Zu 580 ml (6,3 Mol) Phosphoroxychlorid werden bei Raumtemperatur 48 ml Dimethylanilin und 40 g (0,21 Mol) 5-Bromuracil zugegeben und 4,5 h am Rückfluss erhitzt. Die Reaktionsmischung wird langsam auf Eiswasser gegossen und mehrmals mit Dichlormethan extrahiert. Die vereinigten organischen Phasen werden mit MgSO₄ getrocknet, filtriert und das Lösemittel am Rotationsverdampfer entfernt. Es werden 15 g (31,4 % d. Theorie) 5-Brom-2,4-dichloropyrimidin erhalten.

| Elementaranalyse: | | | | | |
|---|---|---|---|---|---|
| ber. | C | 21,08 % | gef. | C | 21,09 % |
| | H | 0,44 % | | H | 0,48 % |
| | N | 12,29 % | | N | 12,39% |
| | Cl | 31,12 % | | Cl | 29,65 % |
| | Br | 35,07 % | | Br | 34,75 % |

11.3: 5-Brom-2,4-di(1,1-dimethylpropyloxy)-pyrimidin
Unter Argon-Schutzgas werden 21,5 g (0,195 Mol) Natrium-t-amylat in 150 ml THF gelöst und 14,8 g (0,065 Mol) 5-Brom-2,4-dichloropyrimin, in 80 ml THF gelöst, zugegeben. Die rötliche Suspension wird 4 h am Rückfluss erhitzt. Die gekühlte Reaktionsmischung wird auf 150 ml Wasser gegossen und dreimal mit Toluol extrahiert. Nach dem Trocknen der vereinigten organischen Phasen über MgSO₄ und dem Entfernen des Lösemittels werden 20,25 g rohes Produkt erhalten. Die Reinigung über SiO₂ mit Essigsäureethylester:Petrolether als Laufmittel im Verhältnis 5:95 ergibt 19,25 g (89,5 %) d. Theorie) der Titelverbindung.

| Elementaranalyse: | | | | | |
|---|---|---|---|---|---|
| ber. | C | 50,8 % | gef. | C | 52,2 % |
| | H | 7,0 % | | H | 7,6 % |
| | N | 8,5 % | | N | 8,3 % |
| | Br | 24,1 % | | Br | 22,8 % |

### Beispiel 12: Herstellung von 5-Brom-2,4,6-tris(3-methyl-but-1-oxy)-pyrimidin

12.1: 2,4,6-Tris(3-methyl-but-1-oxy)-pyrimidin
Bei 50 °C werden 49,5 g (0,45 Mol) Natrium-t-amylat in 200 ml Isopentanol gelöst und 13 ml (0,11 Mol) Trichlorpyrimidin in 50 ml Isopentanol werden während 30 min zu dieser Lösung getropft. Nach einer Stunde Erwärmen auf 50 °C ist durch Dünnschichtchromatographie in der Reaktionsmischung kein Edukt mehr festzustellen. Das Lösemittel wird am Rotationsverdampfer entfernt und der Rückstand auf 200 ml Wasser gegossen. Es wird dreimal mit je 150 ml Toluol extrahiert, die organischen Phasen werden mit MgSO₄ getrocknet und filtriert. Nach dem Entfernen des Lösemittels werden 37,5 g (98,7 % d. Theorie) 2,4,6-Tris(3-methyl-but-1-oxy)-pyrimidin erhalten.

| Elementaranalyse: | | | | | |
|---|---|---|---|---|---|
| ber. | C | 67,4 % | gef. | C | 67,3 % |
| | H | 10,1 % | | H | 10,6 % |
| | N | 8,3 % | | N | 7,6 % |

12.2: 5-Brom-2,4,6-tris(3-methyl-but-1-oxy)-pyrimidin
35,0 g (0,1 Mol) 2,4,6-Tris(3-methyl-but-1-oxy)-pyrimidin werden in 75,7 ml Essigsäure und 14,7 ml Essigsäureanhydrid gelöst und auf 100 °C erwärmt. Es werden 23 g (0,13 Mol) N-Bromsuccinimid zugegeben, die Temperatur der Reaktionsmischung für 10 min auf 120 °C eingestellt und danach 3 h auf 100 °C gehalten. Nach dem Abkühlen der Mischung werden die Lösemittel am Rotationsverdampfer entfernt, 100 ml Wasser zugegeben und die Suspension dreimal mit 100 ml Dichlormethan extrahiert. Die vereinigten organischen Phasen werden mit Wasser gewaschen, mit MgSO₄ getrocknet, filtriert und das Lösemittel am Rotationsverdampfer entfernt. Die Reinigung mit SiO₂-Flashchromatographie und Siedegrenzebenzin (80-110 °C) als Laufmittel liefert 33,6 g (77,9 % d. Theorie) der Titelverbindung als farblose Flüssigkeit.

| Elementaranalyse: | | | | | |
|---|---|---|---|---|---|
| ber. | C | 54,7 % | gef. | C | 56,8 % |
| | H | 8,0 % | | H | 8,5 % |
| | N | 6,7 % | | N | 6,2 % |
| | Br | 19,1 % | | Br | 17,7 % |

### Beispiel 13: Herstellung von 5-Brom-2,4,6-tri(cyclohexyloxy)-pyrimidin

Unter Argon-Schutzgas werden zu 5,8 g (0,1925 Mol) Natriumhydrid (60 % in Oel) in 100 ml THF 20,3 ml (0,1925 Mol) Cyclohexanol in 40 ml THF getropft. Nach der Zugabe wird die Reaktionsmischung 40 min auf 50 °C erhitzt und 6,3 ml (0,055 Mol) 2,4,6-Trichlorpyrimidin in 40 ml THF werden zugetropft. Dabei wird die Temperatur auf 50 °C gehalten. Die Reaktionsmischung wird abgekühlt, auf 180 ml Wasser gegossen und dreimal mit Toluol extrahiert. Die vereinigten organischen Phasen werden zweimal mit 100 ml Wasser gewaschen, über MgSO₄ getrocknet, filtriert und das Lösemittel am Rotationsverdampfer entfernt. Die Reinigung erfolgt mit Mitteldruck-Chromatographie auf Kieselgel LiChoprep Si 60 Korngrösse 25-40 µm der Firma MERCK und Toluol/Hexane 1:1 als Laufmittel.

| Elementaranalyse: | | | | | |
|---|---|---|---|---|---|
| ber. | C | 70,6 % | gef. | C | 71,4 % |
| | H | 9,2 % | | H | 10,1 % |
| | N | 7,5 % | | N | 6,9 % |

Der Bromierungschritt erfolgt wie unter Beispiel 12.2 beschrieben. Die Verbindung hat einen Schmelzbereich von 120-124 °C.

### Beispiele 14-18:

Die Verbindungen der Beispiele 14-18 werden analog zu der Verbindung des Beispiels 13 hergestellt. Bei den Beispielen 14 und 17 wird dabei das THF durch Dimethylacetamid (DMA) ersetzt. Der Bromierungsschritt erfolgt wie unter Beispiel 12.2 beschrieben. Die Verbindungen sind in der folgenden Tabelle 2 aufgelistet.

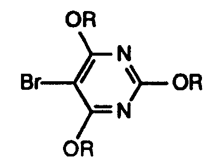

**Tabelle 2**

| Bsp. | R | Schmelzbereich [°C] | Elementaranalyse [%] | | |
|---|---|---|---|---|---|
| | | | Atom | berechnet | gefunden |
| 14 | Tetrahydrofurfuryl | 120-124 | C | 49,7 | 50,3 |
| | | | H | 5,9 | 6,2 |
| | | | N | 6,1 | 5,9 |
| | | | Br | 17,4 | 16,6 |
| 15 | Isopropyl | Oel | C | 46,8 | 46,9 |
| | | | H | 6,4 | 6,3 |
| | | | N | 8,4 | 8,4 |
| | | | Br | 24,0 | 24,3 |
| 16 | Ethyl | 42-44 | C | 41,3 | 41,4 |
| | | | H | 5,2 | 5,2 |
| | | | N | 9,6 | 9,6 |
| | | | Br | 27,5 | 27,2 |
| 17 | Methoxyethyl | Oel | C | 41,0 | 41,4 |
| | | | H | 5,6 | 5,7 |
| | | | N | 7,4 | 7,4 |
| | | | Br | 21,0 | 19,8 |
| 18 | Cyclohexylmethyl | 76-81 | C | 60,6 | 61,1 |
| | | | H | 7,9 | 8,6 |
| | | | N | 5,7 | 5,4 |
| | | | Br | 16,1 | 15,5 |

### Beispiel 19: Herstellung von 2,4,6-Trimethoxypyrimidin

Unter Argon Schutzgas werden zu 106 ml einer 5,4 M Lösung von Natriummethanolat in Methanol (0,576 Mol) tropfenweise und unter Kühlung 13,5 ml 2,4,6-Trichlorpyrimidin in 80 ml Methanol gegeben. Nach 90 min Erwärmen am Rückfluss wird das Lösemittel ent- fernt und der Rückstand auf Wasser gegossen. Es wird zweimal mit Toluol extrahiert, die organischen Phasen mit MgSO₄ getrocknet, filtriert und das Lösemittel entfernt. Das gewünschte Produkt wird in quantitativer Ausbeute erhalten. NMR-Daten: Signale bei 3,95 ppm (Singulett für 9 H) und 5,7 ppm (Singulett für 1 H). Der Bromierungsschritt erfolgt wie unter Beispiel 12.2 beschrieben. NMR-Daten: Signale bei 4 ppm (Singulett für 9 H).

### Beispiel 20: Herstellung von 6-Chloro-4-(3-methyl-but-1-oxy)-2-propyl-pyrimidin

Die Verbindung des Beispiels 20 wird analog zu der Verbindung des Beispiels 3 hergestellt, wobei das 4,6-Dichloro-2-phenyl-pyrimidin durch 4,6-Dichloro-2-propyl-pyrimidin ersetzt wird.

| Elementaranalyse: | | | | | |
|---|---|---|---|---|---|
| ber. | C | 59,4 % | gef. | C | 60,2 % |
| | H | 7,9 % | | H | 8,2 % |
| | N | 11,5 % | | N | 11,3 % |
| | Cl | 14,6 % | | Cl | 13,7 % |

### Beispiel 21: Herstellung von 6-Chloro-4-(2-ethylhexyloxy)-2-propyl-pyrimidin

Die Verbindung des Beispiels 21 wird analog zu der Verbindung des Beispiels 3 hergestellt, wobei 4,6-Dichloro-2-phenyl-pyrimidin durch 4,6-Dichloro-2-propyl-pyrimidin und 3-Methylbutanol durch 2-Ethylhexanol ersetzt werden.
NMR-Daten (in CDCl₃): Signale bei 6,6 ppm (Singulett für 1 H), 4,3 ppm (Dublett für 2 H), 3,8 ppm (Dublett of Dublett) und 0,7-2,2 ppm (Multiplett für 20 H).

### Beispiel 22: Herstellung von 6-Chloro-4-(3-methyl-but-1-oxy)-2-i-propyl-pyrimidin

Die Verbindung des Beispiels 22 wird analog zu der Verbindung des Beispiels 3 hergestellt, wobei 4,6-Dichloro-2-phenyl-pyrimidin durch 4,6-Dichloro-2-i-propyl-pyrimidin ersetzt wird.
NMR-Daten (in CDCl₃): Signale bei 6,5 ppm (Singulett für 1 H), 4,4 ppm (Dublett für 2 H), 3,1 ppm (Septett für 1 H), 1,0-2,2 ppm (Multiplett für 2 H), 1,3 ppm (Dublett für 6 H) und 1,0 ppm (Dublett für 6 H).

### Beispiel 23: Herstellung von 6-Chloro-4-(2-ethylhexyloxy)-2-i-propyl-pyrimidin

Die Verbindung des Beispiels 23 wird analog zu der Verbindung des Beispiels 3 hergestellt, wobei 4,6-Dichloro-2-phenyl-pyrimidin durch 4,6-Dichloro-2-i-propyl-pyrimidin und 3-Methylbutanol durch 2-Ethylhexanol ersetzt werden.
NMR-Daten (in CDCl₃): Signale bei 6,5 ppm (Singulett für 1 H), 4,3 ppm (Dublett für 2 H), 3,1 ppm (Septett für 1 H) und 0,7-2,1 ppm (Multiplett für 21 H).

### Beispiel 24: Herstellung von 6-Chloro-4-(3-methyl-but-1-oxy)-2-decyl-pyrimidin

Die Verbindung des Beispiels 24 wird analog zu der Verbindung des Beispiels 3 hergestellt, wobei 4,6-Dichloro-2-phenyl-pyrimidin durch 4,6-Dichloro-2-decyl-pyrimidin ersetz wird.
NMR-Daten (in CDCl₃): Signale bei 6,5 ppm (Singulett für 1 H), 4,4 ppm (Dublett für 2 H), 2,8 ppm (Triplett für 2 H) und 0,7-2,1 ppm (Multiplett für 28 H).

### Beispiel 25: Herstellung von 6-Chloro-4-(2-ethylhexyloxy)-2-decyl-pyrimidin

Die Verbindung des Beispiels 25 wird analog zu der Verbindung des Beispiels 3 hergestellt, wobei 4,6-Dichloro-2-phenyl-pyrimidin durch 4,6-Dichloro-2-decyl-pyrimidin und 3-Methylbutanol durch 2-Ethylhexanol ersetzt werden.
NMR-Daten (in CDCl₃): Signale bei 6,5 ppm (Singulett für 1 H), 4,3 ppm (Dublett für 2 H), 2,8 ppm (Triplett für 2 H) und 0,7-2,0 ppm (Multiplett für 34 H).

### Beispiele 26-35:

Die Verbindungen der Beispiele 26-35 werden analog zu den Verbindungen der Beispiele 3, 4 oder 43.3 unter Verwendung der jeweiligen Alkohole bzw. Alkoholate hergestellt. Die Ergebnisse sind in der folgenden Tabelle 3 zusammengestellt.

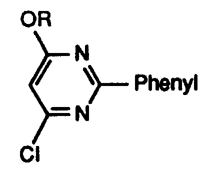

**Tabelle 3**

| Bsp. | R | Schmelzbereich [°C] | Elementaranalyse [%] | | | Herstellungsmethode |
|---|---|---|---|---|---|---|
| | | | Atom | berechnet | gefunden | |
| 26 | Methyl | 66-71 | C | 62,3 | 62,1 | |
| | | | H | 4,2 | 4,5 | D |
| | | | N | 9,1 | 8,6 | |
| | | | Cl | 11,5 | 11,0 | |
| 27 | Ethyl | 52-69 | C | 63,3 | 63,2 | |
| | | | H | 4,7 | 4,6 | Z |
| | | | N | 8,7 | 8,3 | |
| | | | Cl | 11,0 | 11,0 | |
| 28 | i-Propyl | 57-64 | C | 62,8 | 62,8 | |
| | | | H | 5,3 | 5,3 | C |
| | | | N | 11,3 | 11,1 | |
| | | | Cl | 14,3 | 14,2 | |
| 29 | i-Butyl | braune | C | 64,0 | 64,3 | |
| | | Flüssig- | H | 5,8 | 5,9 | C |
| | | keit | N | 10,7 | 10,5 | |
| | | | Cl | 13,5 | 13,2 | |
| 30 | Decyl | 40-45 | C | 69,3 | 67,2 | |
| | | | H | 7,9 | 7,2 | C |
| | | | N | 8,1 | 8,5 | |
| | | | Cl | 10,2 | 13,0 | |
| 31 | 2-Ethyl- | gelbes | C | 68,1 | 67,8 | |
| | hexyl | Oel | H | 6,9 | 7,3 | C |
| | | | N | 8,8 | 8,7 | |
| 32 | Cyclohexyl | 44-48 | C | 66,6 | 66,7 | |
| | | | H | 5,9 | 6,1 | |
| | | | N | 9,7 | 8,9 | Z |
| | | | Cl | 12,3 | 11,5 | |
| 33 | Cyclohexyl- | 55-63 | C | 67,4 | 66,4 | |
| | methyl | | H | 6,3 | 6,1 | |
| | | | N | 9,3 | 9,3 | Z |
| | | | Cl | 11,7 | 13,1 | |
| 34 | Methoxyethyl | 43-46 | +) | | | C |
| 35 | Phenoxyethyl | 123-127 | C | 66,2 | 66,0 | |
| | | | H | 4,6 | 4,8 | Z |
| | | | N | 8,6 | 8,5 | |
| | | | Cl | 10,8 | 11,1 | |
| D: Herstellung analog zu Beispiel 4 C: Herstellung analog zu Beispiel 3 Z: Herstellung analog zu Beispiel 43.3 +): NMR-Daten (CDCl₃): Signale bei 8,3 ppm (Multiplett für 2 H), 7,4 ppm (Multiplett für 3 H), 6,6 ppm (Singulett für 1 H), 4,6 ppm (Multiplett für 2 H), 3,7 ppm (Multiplett für 2 H) und 3,4 ppm (Singulett für 3 H) | | | | | | |

### Beispiel 36: Herstellung von 6-Chloro-2-p-chlorphenyl-4-(2-ethylhexyloxy)-pyrimidin

36.1: p-Chlorobenzamidin-hydrochlorid
(vgl. F.C. Schaefer und A.P. Krapcho, Journal of the Chemical Society, Vol. 27, (1962), 1255)
Es werden 275,14 g (2 Mol) 4-Chlorobenzonitril, 427,9 g Ammoniumchlorid (8 Mol) und 681,2 g (40 Mol) Ammoniak in einen 6,3 l Autoklaven gegeben. Der Druck steigt auf ca. 10 bar. Während 18 h wird auf 125 °C erhitzt, wobei der Druck auf 65 bar ansteigt. Der feste Rückstand wird in 2 l heissem Wasser gelöst, warm filtriert und die Wasserphase mit 30 %iger NaOH basisch eingestellt. Die entstehende Suspension wird filtiert. Es werden 240,8 g (63,1 % d. Theorie) des Produktes mit einem Schmelzpunkt von 158,4-158,5 °C erhalten.

| Elementaranalyse: | | | | | |
|---|---|---|---|---|---|
| ber. | C | 54,4 % | gef. | C | 54,2 % |
| | H | 4,6 % | | H | 4,6 % |
| | N | 18,1 % | | N | 17,7 % |
| | Cl | 22,9 % | | Cl | 22,9 % |

36.2: 2-p-Chlorphenyl-hydroxypyrimidon
In einem 2,5 l Sulfierkolben werden unter Schutzgasatmosphäre 500 ml Methanol und 280,9 g (1,56 Mol) einer 30 %igen Lösung von Natriummethanolat in Methanol gemischt. Dazu werden 120,4 g (0,78 Mol) p-Chlorbenzamidin-hydrochlorid gegeben und 30 min am Rückfluß erwärmt. Danach werden 89,4 ml (103,05 g, 0,78 Mol) Dimethylmalonat während einer Zeit von 1,5 h zugetropft. Es wird eine weitere Stunde reagieren lassen. Danach wird die Reaktionsmischung abgekühlt und das Lösemittel am Rotationsverdampfer entfernt. Der Rückstand wird in 2 l Wasser suspendiert und mit Essigsäure auf einen pH-Wert von 3-4 angesäuert. Die Suspension wird abfiltriert, der Filterkuchen mit Wasser gewaschen und anschließend getrocknet. Es werden 169,4 g (97,6 % d. Theorie) des Produktes erhalten. Der Schmelzpunkt liegt über 250 °C.

| Elementaranalyse: | | | | | |
|---|---|---|---|---|---|
| ber. | C | 54,0 % | gef. | C | 53,4 % |
| | H | 3,2 % | | H | 3,3 % |
| | N | 12,6 % | | N | 12,2 % |
| | Cl | 15,9 % | | Cl | 15,8 % |

36.3: 2-p-Chlorphenyl-4,6-dichloropyrimidin
In einem 2,5 l Sulfierkolben werden unter Schutzgasatmosphäre 90 g (0,4 Mol) 2-p-Chlorphenyl-hydroxypyrimidon mit 1 l Chlorbenzol auf 50 °C erwärmt. Es werden 219,7 ml Phosphoroxychlorid (2,4 Mol) während ca. 3 h so zugetropft, daß die Temperatur bei 50 °C bleibt. Danach werden während ca. 1 Stunde 256 ml (1,6 Mol) Dimethylanilin zugetropft, wobei die Temperatur wieder bei 50 °C gehalten wird. Anschließend wird ca. 16 h auf 130 °C erwärmt. Nach dem Abkühlen der Reaktionsmischung werden 2 l Eiswasser zugegeben, die Phasen getrennt und die wäßrige Phase mit Chlorbenzol extrahiert. Die vereinigten organischen Phasen werden über MgSO₄ getrocknet, filtriert und am Rotationsverdampfer eingeengt. Der Rückstand wird aus Methanol umkristallisiert. Es werden 42,8 g (51,5 % d. Theorie) des Produktes mit einem Schmelzpunkt von 124,0-124,1 °C erhalten.

| Elementaranalyse: | | | | | |
|---|---|---|---|---|---|
| ber. | C | 46,3 % | gef. | C | 46,3 % |
| | H | 1,9 % | | H | 2,1 % |
| | N | 10,8 % | | N | 10,6 % |
| | Cl | 41,0 % | | Cl | 40,3 % |

36.4: 6-Chloro-2-(p-chlorphenyl)-4-(2-ethylhexyloxy)-pyrimidin
Die Umsetzung des 2-(p-Chlorophenyl)-4,6-dichlorpyrimidins zum 6-Chloro-2-(p-chlorphenyl)-4-(2-ethylhexyloxy)-pyrimidin erfolgt analog zu der im Beispiel 3 beschriebenen Methode, wobei 4,6-Dichloro-2-phenyl-pyrimidin durch 4,6-Dichloro-2-(p-chlorphenyl)-pyrimidin und 3-Methylbutanol durch 2-Ethylhexanol ersetzt werden.

| Elementaranalyse: | | | | | |
|---|---|---|---|---|---|
| ber. | C | 61,2 % | gef. | C | 62,7 % |
| | H | 6,3 % | | H | 6,7 % |
| | N | 7,9 % | | N | 7,2 % |
| | Cl | 20,1 % | | Cl | 18,9 % |

### Beispiel 37: Herstellung von 6-Chloro-2-(p-chlorphenyl)-4-phenoxyethyloxy-pyrimidin

Die Verbindung des Beispiels 37 wird analog zu der Verbindung des Beispiels 36 hergestellt, wobei jedoch bei der Umsetzung des 4,6-Dichlor-Eduktes nicht nach der Methode des Beispiels 3, sondern nach der des Beispiels 43.3 gearbeitet wird.

### Beispiel 38: Herstellung von 4-Chloro-6-(3-methyl-but-1-oxy)-2-(p-octylphenylthio)-pyrimidin

38.1: p-Octylthiobenzonitril
In einem Sulfierkolben werden unter Schutzgasatmosphäre 103,2 g (0,75 Mol) p-Chlorbenzonitril, 140 g Kaliumcarbonat und 143,2 ml (0,825 Mol) Octanthiol in Dimethylacteamid während ca. 16 h bei 100 °C gerührt. Die entstandene weiße abgekühlte Suspension wird auf Eiswasser gegossen und mit Dichlormethan mehrmals extrahiert. Die organischen Phasen werden vereinigt, mit Wasser gewaschen, über MgSO₄ getrocknet, filtriert und eingeengt. Es resultieren 193,1 g Rohprodukt. Das Produkt wird bei 92 °C/0,1 mmHg destilliert.
38.2: 2-(p-Octylphenylthio)-hydroxypyrimidon (ohne Isolierung der Amidin-Zwischenstufe)
In einem 2,5 l Sulfierkolben weden 100 g (0,404 Mol) 4-Octylthiobenzonitril in 300 ml Xylol gelöst und 41 g (0,525 Mol) einer 50 %igen Suspension von Natriumamid in Toluol zugegeben. Die Suspension wird auf 135 °C erhitzt. Nach 3,5 h haben die Edukte vollständig reagiert (Kontrolle: Dünnschichtchromatographisch). Die Reaktionsmischung wird auf 60 °C abgekühlt und 200 ml Methanol werden langsam zugetropft. Zu der beigefarbenen Mischung werden dann 46,3 ml (0,404 Mol) Dimethylmalonat in 100 ml Methanol bei 60 °C während einer Stunde getropft. Die schwer rührbare Suspension wird mit 200 ml Methanol verdünnt und bei Raumtemperatur ca. 16 h stehen gelassen. Danach wird der pH-Wert mit Essigsäure auf 3 eingestellt und die viskose Mischung filtriert.Der feste Rückstand wird mit Wasser gewaschen und bei 40 °C getrocknet. Es resultieren 68,5 % der Theorie des Produktes mit einem Schmelzpunkt von >250 °C.

| Elementaranalyse: | | | | | |
|---|---|---|---|---|---|
| ber. | C | 65,0 % | gef. | C | 64,7 % |
| | H | 7,3 % | | H | 7,1 % |
| | N | 8,4 % | | N | 8,0 % |
| | S | 9,6 % | | S | 9,6 % |

38.3: 4,6-Dichloro-2-(p-octylphenylthio)-pyrimidin
4,6-Dichloro-2-(p-octylphenylthio)-pyrimidin wird analog zu der Verbindung des Beispiels 36.3 aus 2-(p-Octylphenylthio)-hydroxypyrimidon in einer Ausbeute von 97,1 % erhalten.

| Elementaranalyse: | | | | | |
|---|---|---|---|---|---|
| ber. | C | 58,5 % | gef. | C | 58,6 % |
| | H | 6,0 % | | H | 6,1 % |
| | N | 7,6 % | | N | 7,7 % |
| | S | 8,7 % | | S | 9,0 % |
| | Cl | 19,2 % | | Cl | 18,0 % |

38.4: 4-Chloro-6-(3-methyl-but-1-oxy)-2-(p-octylphenylthio)-pyrimidin
Das Titelprodukt wird nach der Herstellungsmethode des Beispiels 3 aus 4,6-Dichloro-2-(p-octylphenylthio)-pyrimidin erhalten.

| Elementaranalyse: | | | | | |
|---|---|---|---|---|---|
| ber. | C | 65,6 % | gef. | C | 65,8 % |
| | H | 7,9 % | | H | 8,0 % |
| | N | 6,7 % | | N | 6,6 % |
| | S | 7,6 % | | S | 7,7 % |
| | Cl | 8,4 % | | Cl | 8,4 % |

### Beispiele 39-40:

Die Verbindungen der Beispiele 39 und 40 werden aus 4,6-Dichloro-2-(p-octylphenylthio)-pyrimidin analog zu den in der folgenden Tabelle 4 angegebenen Herstellungsmethoden erhalten.

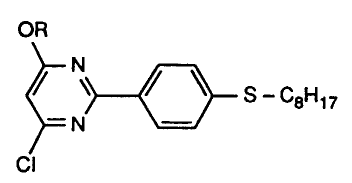

**Tabelle 4**

| Beispiel | R | Elementaranalyse [%] | | |
|---|---|---|---|---|
| | | Atom | ber. | gef. |
| 39 | Ethyl | C | 63,4 | 62,8 |
| | | H | 7,2 | 7,2 |
| | | N | 7,4 | 7,3 |
| | | S | 8,5 | 8,6 |
| | | Cl | 9,4 | 9,4 |
| 40 | Phenoxyethyl | C | 66,3 | 66,1 |
| | | H | 6,6 | 6,6 |
| | | N | 6,0 | 5,8 |
| | | S | 6,8 | 6,8 |
| | | Cl | 7,5 | 6,7 |

### Beispiel 41: 2-Butoxyphenyl-4-chloro-6-(3-methyl-but-1-oxy)-pyrimidin

41.1: p-Butoxybenzonitril
In einem Sulfierkolben werden unter Schutzgasatmosphäre 250 ml Butanol und 15,2 g (0,66 Mol) Natrium solange erhitzt, bis das Metall abreagiert hat. Nach dem Abkühlen wird portionsweise p-Chlorbenzonitril zugegeben und die Reaktionsmischung anschlies- send ca. 16 h am Rückfluß erhitzt. Die abgekühlte Mischung wird auf Wasser gegossen und mit Essigsäureethylester extrahiert. Die organische Phase wird dann mit MgSO₄ getrockent, filtriert und das Lösemittel eingeengt. Es werden 95 % d. Theorie des Titelproduktes erhalten.

| Elementaranalyse: | | | | | |
|---|---|---|---|---|---|
| ber. | C | 75,4 % | gef. | C | 75,4 % |
| | H | 7,4 % | | H | 7,5 % |
| | N | 8,8 % | | N | 8,1 % |

41.2: 2-(p-Butoxyphenyl)-hydroxypyrimidon
Das Titelprodukt wird analog zur Verbindung des Beispiels 38.2 aus p-Butoxybenzonitril in einer Ausbeute von 83,3 % d. Theorie erhalten. Das Produkt schmilzt bei 259-265 °C.

| Elementaranalyse: | | | | | |
|---|---|---|---|---|---|
| ber. | C | 64,6 % | gef. | C | 64,5 % |
| | H | 6,2 % | | H | 6,2 % |
| | N | 10,8 % | | N | 10,6 % |

41.3: 2-(p-Butoxyphenyl)-4,6-dichlorpyrimidin
Das Titelprodukt wird analog zur Verbindung des Beispiels 38.3 aus 2-(p-Butoxyphe- nyl)-hydroxypyrimidon in einer Ausbeute von 46 % d. Theorie erhalten. Das Produkt schmilzt bei 54-58 °C.

| Elementaranalyse: | | | | | |
|---|---|---|---|---|---|
| ber. | C | 56,6 % | gef. | C | 56,6 % |
| | H | 4,8 % | | H | 4,9 % |
| | N | 9,4 % | | N | 9,4 % |
| | Cl | 23,9 % | | Cl | 23,8 % |

41.4: 2-Butoxyphenyl-4-chloro-6-(3-methyl-but-1-oxy)-pyrimidin
Die Herstellung von 2-Butoxyphenyl-4-chloro-6-(3-methyl-but-1-oxy)-pyrimidin erfolgt nach der Methode des Beispiels 3 aus 2-(p-Butoxyphenyl)-4,6-dichloropyrimidin. Es werden 87 % d. Theorie, mit einem Schmelzbereich von 47-50 °C erhalten.

| Elementaranalyse: | | | | | |
|---|---|---|---|---|---|
| ber. | C | 65,4 % | gef. | C | 65,6 % |
| | H | 7,2 % | | H | 7,3 % |
| | N | 8,0 % | | N | 7,7 % |
| | Cl | 10,2 % | | Cl | 9,9 % |

### Beispiel 42: Herstellung von 2-Butoxyphenyl-4-chloro-6-(2-ethylhexyloxy)-pyrimidin

Die Herstellung erfolgt nach der Methode des Beispiels 43.3 aus 2-(p-Butoxyphenyl)-4,6-dichlorpyrimidin. Es werden 96,8 % d. Theorie erhalten.

| Elementaranalyse: | | | | | |
|---|---|---|---|---|---|
| ber. | C | 67,6 % | gef. | C | 67,5 % |
| | H | 8,0 % | | H | 7,9 % |
| | N | 7,2 % | | N | 7,3 % |
| | Cl | 9,1 % | | Cl | 9,4 % |

### Beispiel 43: Herstellung von 4-Chloro-2-(p-methylphenylthio)-6-phenoxyethyloxy-pyrimidin

43.1: 2-(p-Methylphenylthio)-hydroxypyrimidon
Die Titelverbindung wird durch Umsetzung von 6-(Methylthio)benzonitril mit Natrium- amid zum entsprechenden Amidin und Umsetzung desselben -ohne vorherige Isolierung- mit Dimethylmalonat entsprechend der im Beispiel 38.2 beschriebenen Methode mit einer Ausbeute von 63,3 % d. Theorie und einem Schmelzpunkt von >250 °C erhalten.

| Elementaranalyse: | | | | | |
|---|---|---|---|---|---|
| ber. | C | 56,4 % | gef. | C | 55,5 % |
| | H | 4,3 % | | H | 4,4 % |
| | N | 12,0 % | | N | 11,5 % |
| | S | 13,7 % | | S | 13,2 % |

43.2: 4,6-Dichloro-2-(p-methylphenylthio)-pyrimidin
Die Titelverbindung wird durch Umsetzung des unter 43.1 beschriebenen Pyrimidons entsprechend der unter 38.3 beschriebenen Methode erhalten. Die Ausbeute beträgt 74,2 % d. Theorie, der Schmelzpunkt nach Umkristallisation liegt bei 111,6-113,4 °C.

| Elementaranalyse: | | | | | |
|---|---|---|---|---|---|
| ber. | C | 48,7 % | gef. | C | 48,7 % |
| | H | 3,0 % | | H | 3,1 % |
| | N | 10,3 % | | N | 10,6 % |
| | S | 11,8 % | | S | 12,0 % |
| | Cl | 26,2 % | | Cl | 25,8 % |

43.3: 4-Chloro-2-(p-methylphenylthio)-6-phenoxyethyloxy-pyrimidin
In einem Sulfierkolben werden 150 ml 2-Methyl-2-butanol, 2,33 g (0,101 Mol) Natrium, 13 ml 2-Phenoxyethanol und eine Spur Eisen-III-chlorid zum Rückfluß erhitzt. Die Suspension wird solange am Rückfluß gehalten, bis das Natrium abreagiert hat. Diese Mischung wird nach dem Abkühlen unter Argon in einen Tropftrichter überführt und bei 0 °C während 1,5 h zu einer Mischung von 25 g 4,6-Dichloro-2-(p-methylphenylthio)- pyrimidin in 150 ml absolutem Tetrahydrofuran getropft. Die Reaktionsmischung wird im Laufe von ca. 16 h auf 20 °C erwärmen lassen. Die Mischung wird dann auf Eiswasser gegossen und mit Toluol mehrmals extrahiert. Die organischen Phasen werden vereinigt, mit Wasser gewaschen, über MgSO₄ getrocknet, filtriert und eingeengt. Es resultieren 65 % d. Theorie des Titelproduktes mit einem Schmelzbereich von 128-132 °C.

| Elementaranalyse: | | | | | |
|---|---|---|---|---|---|
| ber. | C | 61,2 % | gef. | C | 61,0 % |
| | H | 4,6 % | | H | 4,6 % |
| | N | 7,5 % | | N | 7,4 % |
| | S | 8,6 % | | S | 8,7 % |
| | Cl | 9,5 % | | Cl | 9,8 % |

### Beispiel 44: Herstellung von 4-Chloro-6-ethyloxy-2-(p-methylphenylthio)-pyrimidin

Die Herstellung erfolgt anlog zu der in Beispiel 4 beschriebenen Methode, wobei 2,4,6-Trichlorpyrimidin durch 4,6-Dichloro-2-(p-methylphenylthio)-pyrimidin ersetzt wird. Es resultieren 82 % d. Theorie der Titelverbindung mit einem Schmelzbereich von 94-97 °C.

| Elementaranalyse: | | | | | |
|---|---|---|---|---|---|
| ber. | C | 55,6 % | gef. | C | 55,7 % |
| | H | 4,7 % | | H | 4,7 % |
| | N | 10,0 % | | N | 9,8 % |
| | S | 11,4 % | | S | 11,4 % |
| | Cl | 12,6 % | | Cl | 12,6 % |

### Beispiel 45: Herstellung von 4-Chloro-2-(p-methylphenylthio)-6-(3-methyl-but-1-oxy)-pyrimidin

Die Herstellung erfolgt anlog zu der in Beispiel 3 beschriebenen Methode, wobei 4,6-Dichloro-2-phenyl-pyrimidin durch 4,6-Dichloro-2-(p-methylphenylthio)-pyrimidin ersetzt wird. Es resultieren 92,4 % d. Theorie der Titelverbindung mit einem Schmelz- bereich von 83-86 °C.
NMR-Daten (CDCl₃): Signale bei 8,3 ppm, 8,16 ppm, 7,3 ppm, 7,16 ppm (AA'BB'-System 4 H), 6,5 ppm (Singulett, 1 H), 4,5 ppm (Triplett, 2 H), 2,5 ppm (Singulett, 3 H), 1,7 ppm (Triplett, 2 H), 0,9 ppm (Dublett, 6 H).

### Beispiel 46: Herstellung von 4-Chloro-2-(p-methylphenylthio)-6-(2-ethylhexyloxy)-pyrimidin

Die Herstellung erfolgt anlog zu der in Beispiel 3 beschriebenen Methode, wobei 4,6-Dichloro-2-phenyl-pyrimidin durch 4,6-Dichloro-2-(p-methylphenylthio)-pyrimidin und 3-Methylbutanol durch 2-Ethylhexanol ersetzt werden. Man erhält die Titelverbin- dung als Harz in einer Ausbeute von 85 % d. Theorie.
NMR-Daten (CDCl₃): Signale bei 8,3 ppm, 8,1 ppm, 7,2 ppm, 7,1 ppm (AA'BB'-System, 4 H), 6,5 ppm (Singulett, 1 H), 4,4 ppm (Triplett, 2 H), 2,5 ppm (Singulett, 3 H), 0,8-2,0 ppm (Multiplett, 15 H).

### Beispiel 47: Herstellung von 2-(Biphenyl)-4-chloro-6-(3-methyl-but-1-oxy)-pyrimidin

47.1: 2-(Biphenyl)-hydroxypyrimidon
Die Herstellung der Titelverbindung erfolgt analog zu der im Beispiel 38.2 beschriebenen Methode, wobei das p-Chlorbenzonitril durch p-Phenylbenzonitril ersetzt wird. Es resultieren 62 % d. Theorie mit einem Schmelzpunkt >250 °C.

| Elementaranalyse: | | | | | |
|---|---|---|---|---|---|
| ber. | C | 72,2 % | gef. | C | 71,6 % |
| | H | 4,6 % | | H | 4,6 % |
| | N | 10,6 % | | N | 10,0 % |

47.2: 2-(Biphenyl)-4,6-dichloro-pyrimidin
Die Herstellung der Titelverbindung erfolgt analog zu der im Beispiel 38.3 beschriebenen Methode. Es resultieren 62 % d. Theorie mit einem Schmelzpunkt von 115,0-115,4 °C.

| Elementaranalyse: | | | | | |
|---|---|---|---|---|---|
| ber. | C | 63,8 % | gef. | C | 63,9 % |
| | H | 3,3 % | | H | 3,6 % |
| | N | 9,3 % | | N | 8,8 % |
| | Cl | 23,5 % | | Cl | 22,6 % |

47.3: 2-(Biphenyl)-4-chloro-6-(3-methyl-but-1-oxy)-pyrimidin
Herstellungsmethode und physikalische Daten der Titelverbindung sind der Tabelle 5 zu entnehmen.

### Beispiele 48-49:

Die Verbindungen der Beispiele 48 und 49, sowie deren physikalische Daten, sind der nachfolgenden Tabelle 5 zu entnehmen.

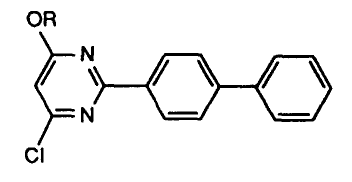

**Tabelle 5**

| Beispiel | R | Schmelzbereich [°C] | Synthese | Ausbeute [%] | Elementaranalyse [%] | | |
|---|---|---|---|---|---|---|---|
| | | | | | Atom | ber. | gef. |
| 47.3 | 3-Methyl- | 53-57 | Z | 57 | C | 71,5 | 71,5 |
| | but-1-yl | | | | H | 6,0 | 6,0 |
| | | | | | N | 7,9 | 7,7 |
| | | | | | Cl | 10,1 | 9,8 |
| 48 | 2-ethyl- | Harz | A | 80,3 | C | 72,8 | 72,8 |
| | hexyl | | | | H | 7,1 | 6,8 |
| | | | | | N | 7,1 | 6,8 |
| | | | | | Cl | 9,0 | 9,2 |
| 49 | Phenoxy- | 123-127 | Z | 72 | C | 71,6 | 71,3 |
| | Ethyl | | | | H | 4,8 | 4,7 |
| | | | | | N | 7,0 | 6,9 |
| | | | | | Cl | 8,8 | 8,3 |
| A: Herstellung analog zu Beispiel 1 | | | | | | | |
| Z: Herstellung analog zu Bcispiel 43.3 | | | | | | | |

### Beispiel 50: Herstellung von 4-Chloro-2-(p-phenylphenylthio)-6-(3-methyl-but-1-oxy)-pyrimidin

### 50.1: 2-(Phenylthiophenyl)-benzonitril

Die Verbindung wird analog zur im Beispiel 38.1 beschriebenen Methode hergestellt. Die erhaltenene Titelverbindung hat einen Schmelzbereich von 110-115 °C.

### 50.2: 2-(Phenylthiophenyl)-hydroxypyrimidon

Die Titelverbindung wird analog zu der Verbindung des Beispiels 38.2 hergestellt. Sie wird in einer Ausbeute von 63,8 % d. Theorie mit einem über 250 °C liegenden Schmelzpunkt erhalten.

| Elementaranalyse: | | | | | |
|---|---|---|---|---|---|
| ber. | C | 64,9 % | gef. | C | 64,5 % |
| | H | 4,1 % | | H | 4,2 % |
| | N | 9,5 % | | N | 9,2 % |
| | S | 10,8 % | | S | 10,8 % |

### 50.3: 4,6-Dichloro-2-(p-phenylthiophenyl)-pyrimidin

Die Titelverbindung wird analog zu der Verbindung des Beispiels 38.3 hergestellt. Sie wird in einer Ausbeute von 91,9 % d. Theorie mit einem Schmelzbereich von 94-97 °C erhalten.

| Elementaranalyse: | | | | | |
|---|---|---|---|---|---|
| ber. | C | 57,7 % | gef. | C | 58,5 % |
| | H | 3,0 % | | H | 3,3 % |
| | N | 8,4 % | | N | 8,4 % |
| | S | 9,6 % | | S | 9,6 % |
| | Cl | 21,3 % | | Cl | 19,2 % |

50.4: 4-Chloro-2-(p-phenylthiophenyl)-6-(3-methyl-but-1-oxy)-pyrimidin
   Die Verbindung des Beispiels 50.4, sowie deren Herstellungsmethode und physikalische Daten sind in der Tabelle 6 enthalten.

### Beispiele 51-52:

Die Edukte für die Verbindungen der Beispiele 51 und 52 werden analog zu den Verbindungen der Beispiele 38.1-38.3 hergestellt. Die Umsetzung zum Endprodukt erfolgt nach der in der nachstehenden Tabelle 6 angegebenen Methode.

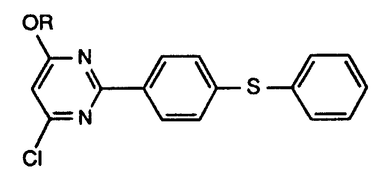

**Tabelle 6**

| Beispiel | R | Schmelzbereich [°C] | Ausbeute [%] | Synthese | Elementaranalyse [%] | | |
|---|---|---|---|---|---|---|---|
| | | | | | Atom | ber. | gef. |
| 50.4 | 3-Methylbut-1-yl | 47-51 | 42 | Z | C | 65,5 | 65,3 |
| | | | | | H | 5,5 | 5,4 |
| | | | | | N | 7,3 | 7,3 |
| | | | | | S | 8,3 | 8,5 |
| | | | | | Cl | 9,2 | 9,1 |
| 51 | 2-Ethylhexyl | viskose Flüssigkeit | 80 | Z | C | 67,5 | 68,5 |
| | | | | | H | 6,4 | 6,8 |
| | | | | | N | 6,6 | 6,1 |
| | | | | | S | 7,5 | 7,2 |
| | | | | | Cl | 8,3 | 7,5 |
| 52 | Phenoxyethyl | 101-105 | 54 | Z | C | 66,3 | 66,2 |
| | | | | | H | 4,4 | 4,5 |
| | | | | | N | 6,4 | 6,3 |
| | | | | | S | 7,4 | 7,5 |
| | | | | | Cl | 8,2 | 7,7 |
| Z: Herstellungsmethode analog zu Beispiel 43.3 | | | | | | | |

### Beispiel 53: Herstellung von 4-Chloro-2-(p-dimethylaminophenyl)-6-(3-methyl-but-1-oxy)-pyrimidin

53.1: 2-(p-Dimethylaminophenyl)-hydroxypyrimidinon
Das Titelprodukt wird analog zu der Verbindung des Beispiels 38.2 hergestellt und in einer Ausbeute von 84,1 % d. Theorie mit einem Schmelzpunkt von über 250 °C erhalten.

| Elementaranalyse: | | | | | |
|---|---|---|---|---|---|
| ber. | C | 62,3 % | gef. | C | 56,9 % |
| | H | 5,7 % | | H | 6,1 % |
| | N | 18,2 % | | N | 16,4 % |

53.2: 2-(p-Dimethylaminophenyl)-4,6-dichlorpyrimidin
Die Verbindung wird analog zu der Verbindung des Beispiels 38.3 hergestellt. Man erhält sie in einer Ausbeute von 63,8 % d. Theorie mit einem Schmelzbereich von 168,5-169,5 °C.

| Elementaranalyse: | | | | | |
|---|---|---|---|---|---|
| ber. | C | 53,8 % | gef. | C | 54,6 % |
| | H | 4,1 % | | H | 4,3 % |
| | N | 15,7 % | | N | 15,7 % |
| | Cl | 26,4 % | | Cl | 25,2 % |

53.3: 4-Chloro-2-(p-dimethylaminophenyl)-6-(3-methyl-but-1-oxy)-pyrimidin Das Titelprodukt wird nach der Methode des Beispiels 43.3 hergestellt. Man erhält es in einer Ausbeute von 75,3 % d.Theorie mit einem Schmelzbereich von 83-93 °C.

| Elementaranalyse: | | | | | |
|---|---|---|---|---|---|
| ber. | C | 63,8 % | gef. | C | 63,7 % |
| | H | 6,9 % | | H | 6,8 % |
| | N | 13,1 % | | N | 13,3 % |
| | Cl | 11,1 % | | Cl | 11,1 % |

### Beispiel 54: Herstellung von 4-Chloro-2-pyrrolo-6-(3-methyl-but-1-oxy)-pyrimidin

54.1: 4,6-Dichloro-2-pyrrolo-pyrimidin
   19,7 g (0,12 Mol) 2-Amino-4,6-dichloropyrimidin, 37 g (0,24 Mol) Dimethoxytetrahydrofuran und 0,05 g p-Toluolsulfonsäure werden auf 140 °C erhitzt, und das entstehende Methanol wird sofort abdestilliert. Danach wird 2 h bei 140 °C gerührt,abgekühlt und mit Dichlormethan verdünnt. Nach der Filtration über SiO₂ wird das Lösemittel entfernt und das Produkt säulenchromatographich mit Hexan als Laufmittel gereinigt. Es resultieren 16,3 g, das sind 63,2 % d. Theorie. Nach der Umkristallisation aus Methanol hat das Produkt einen Schmelzpunkt von 53,3-56,3 °C.
54.2: 4-Chloro-2-pyrrolo-6-(3-methyl-but- I-oxy)-pyrimidin
   4-Chloro-2-pyrrolo-6-(3-methyl-but-1-oxy)-pyrimidin wird analog zu der Methode des Beispiels 3 aus 4,6-Dichloro-2-pyrrolo-pyrimidin hergestellt.
   NMR-Daten (CDCl₃): Signale bei 7,6 ppm (Triplett, 2 H), 6,4 ppm (Singulett, 1 H), 6,2 ppm (Triplett, 2 H), 4,4 ppm (Triplett, 2 H), 1,7 ppm (Triplett, 3 H) und 1,0 ppm (Dublett, 6 H).

### Beispiel 55: Herstellung von 4,6-Di(3-methyl-but-1-oxy)-2-phenyl-pyrimidin

Die Herstellung erfolgt analog zu der im Beispiel 12.1 beschriebenen Methode, wobei das Trichlorpyrimidin durch 4,6-Dichloro-2-phenyl-pyrimidin ersetzt wird. Es resultieren 89,3 % d.Theorie einer gelben Flüssigkeit.

| Elementaranalyse: | | | | | |
|---|---|---|---|---|---|
| ber. | C | 73,1 % | gef. | C | 73,1 % |
| | H | 8,6 % | | H | 8,6 % |
| | N | 8,5 % | | N | 8,6 % |

### Beispiel 56: Herstellung von 5-Brom-4,6-di(3-methyl-but-1-oxy)-2-phenyl-pyrimidin

Das Titelprodukt wird analog zu der in Beispiel 12.2 beschriebenen Methode in einer Ausbeute von 72,4 % d. Theorie als farblose Flüssigkeit erhalten.

| Elementaranalyse: | | | | | |
|---|---|---|---|---|---|
| ber. | C | 59,0 % | gef. | C | 59,4 % |
| | H | 6,7 % | | H | 6,7 % |
| | N | 6,9 % | | N | 6,8 % |
| | Br | 19,6 % | | Br | 19,3 % |

### Beispiel 57: Herstellung von 6-Chloro-4-(2-ethylhexyl)-pyrimidin

Die Verbindung wird analog zur in Beispiel 3 beschriebenen Methode hergestellt, wobei 4,6-Dichlor-2-phenyl-pyrimidin durch 4,6-Dichlorpyrimidin und 3-Methylbutanol durch 2-Ethylhexanol ersetzt werden. Ausbeute: 76,2 % d. Theorie.
NMR-Daten (CDCl₃): Signale bei 8,4 ppm (Singulett 1 H), 6,7 ppm (Singulett 1 H), 4,4 ppm (Dublett, 2 H) und 0,8-2,0 ppm (Multiplett, 15 H).

### II) Herstellung der Titanocene

### Beispiel 58: Herstellung von Bis[Cyclopentadienyl]-bis[6-chlor-2,4-di(3-methyl-but-1-oxy)-pyrimidinyl]titan

5,7 g (19,8 mmol) 6-Chlor-2,4-di(3-methyl-but-1-oxy)-pyrimidin werden in 40 ml absolutem Tetrahydrofuran (THF) in einem Kolben mit Magnetrührer und Argonzuleitung auf -40 °C gekühlt. Unter Rühren werden zu dieser Lösung 12,4 ml (19,8 mmol) einer 1,6 M Lösung von n-Butyllithium in Hexan getropft. 2,25 g (9 mmol) festes Dicyclopentadienyltitandichlorid werden bei -40 °C zu der entstandenen orangen Lösung gegeben. Die entstandene Suspension wird langsam auf 25 °C erwärmen lassen. Danach wird die Mischung auf 40 ml Wasser gegossen und über ®Hyflo filtriert. Nach dem Abtrennen der wässrigen Phase wird die rote organische Phase mit Magnesiumsulfat getrocknet, abfiltriert und am Rotationsverdampfer eingeengt. Der Rückstand wird durch Flashchromatographie (SiO₂; Laufmittel: Essigester/Siedegrenzebenzin [80-110 °C] 5:95) gereinigt. Man erhält 2,7 g (40 % Ausbeute) der Titelverbindung mit einem Schmelz- bereich von 89-96 °C.

| Elementaranalyse: | | | | | |
|---|---|---|---|---|---|
| ber. | C | 60,9 % | gef. | C | 60,0 % |
| | H | 7,3 % | | H | 7,4 % |
| | N | 7,5 % | | N | 6,9 % |
| | Cl | 9,5 % | | Cl | 9,4 % |

### Beispiele 59-65:

Die Verbindungen der Beispiele 60-66 werden analog zu der Verbindung des Beispiels 58 hergestellt. Ihre Strukturen und physikalischen Daten sind der nachfolgenden Tabelle 7 zu entnehmen.

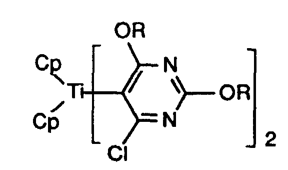

**Tabelle 7:**

| Bsp. | R | Schmelzbereich[°C] | Ausbeute [%] | Elementaranalyse [%] | | |
|---|---|---|---|---|---|---|
| | | | | Atom | berechnet | gefunden |
| 59 | Methyl | 175-178 | - | | - | |
| 60 | Ethyl | 140-150 | 55,2 | C | 53,7 | 53,8 |
| | | | | H | 5,5 | 5,0 |
| | | | | N | 9,6 | 9,5 |
| | | | | Cl | 12,2 | 12,0 |
| 61 | iso-Propyl | 170-175 | 38,2 | C | 56,5 | 56,6 |
| | | | | H | 6,0 | 5,8 |
| | | | | N | 8,8 | 8,1 |
| | | | | Cl | 11,1 | 10,5 |
| 62 | Methoxyethyl | - | 28,6 | C | 51,4 | 50,9 |
| | | | | H | 5,5 | 5,5 |
| | | | | N | 8,0 | 8,2 |
| | | | | Cl | 10,1 | 10,2 |
| 63 | Cyclohexyl* | 89-96 | 13,9 | C | 63,2 | 63,4 |
| | | | | H | 6,8 | 7,1 |
| | | | | N | 7,0 | 6,6 |
| | | | | Cl | 8,9 | 8,9 |
| 64 | Cyclohexylmethyl | 164-172 | 49,0 | C | 64,7 | 65,3 |
| | | | | H | 7,3 | 7,9 |
| | | | | N | 6,6 | 6,5 |
| | | | | Cl | 8,3 | 7,8 |
| 65 | Benzyl | 168-175 | 30,6 | C | 66,6 | 65,9 |
| | | | | H | 4,6 | 4,9 |
| | | | | N | 6,8 | 6,1 |
| | | | | Cl | 8,6 | 7,7 |

| | | | | | | |
|---|---|---|---|---|---|---|
| *Für die Flashchromatographie wurde Essigester/Hexan 20:80 als Laufmittel verwendet | | | | | | |

### Beispiele 66-67:

Die Verbindungen der Beispiele 66 und 67 werden analog zu der Verbindung des Beispiels 58 hergestellt, wobei das Dicyclopentadienyltitandichlorid durch Bis(methyl- cyclopentadienyl)titandichlorid ersetzt wird. Strukturen und physikalische Daten der Verbindungen sind der Tabelle 8 zu entnehmen.

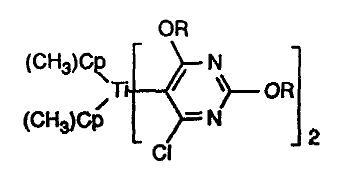

**Tabelle 8:**

| Bsp. | R | Schmelzbereich [°C] | Ausbeute [%] | Elementaranalyse [%] | | |
|---|---|---|---|---|---|---|
| | | | | Atom | berechnet | gefunden |
| 66 | Methyl | 169-173 | - | C | 55,2 | 55,5 |
| | | | | H | 5,6 | 6,1 |
| | | | | N | 9,2 | 8,4 |
| 67 | Ethyl | 115-123 | 11 | C | 57,4 | 56,4 |
| | | | | H | 5,9 | 6,0 |
| | | | | N | 10,3 | 10,1 |

### Beispiel 68: Herstellung von Chlor-bis(cyclopentadienyl)-(6-chlor-2,4-dicyclohexyl-oxy-pyrimidinyl)titan

Unter Argon als Schutzgas werden 6,15 g (19,8 mmol) 6-Chlor-2,4-bis(cyclohexyloxy)- pyrimidin in 40 ml THF gelöst, auf -40 °C gekühlt, und 12,4 ml n-Butyllithium (1,6 M/Hexan) werden zugetropft. Zu der erhaltenen Lösung werden bei -40 °C 2,25 g (9 mmol) festes Biscyclopentadienyltitandichlorid gegeben. Die Reaktionsmischung wird langsam von -40 °C auf 25 °C erwärmen lassen, danach auf 40 ml Wasser gegossen und über ®Hyflo filtriert. Nach dem Abtrennen der wässrigen Phase wird die organische Phase mit Magnesiumsulfat getrocknet, abfiltriert und am Rotationsverdampfer eingeengt. Der Rückstand wird durch Flashchromatographie (SiO₂) getrennt. Man erhlät 1,0 g der Ver- bindung aus Beispiel 63 und 0,9 g der Titelverbindung mit einem Schmelzbereich von 145-155 °C.

| Elementaranalyse: | | | | | |
|---|---|---|---|---|---|
| ber. | C | 59,7 % | gef. | C | 60,3 % |
| | H | 6,2 % | | H | 6,2 % |
| | N | 5,4 % | | N | 6,9 % |
| | Cl | 13,6 % | | Cl | 13,1 % |

### Beispiel 69: Herstellung von Bis[cyclopentadienyl]-bis[6-chlor-2-i-butyl-thio-4-(3-methyl-but-1-oxy)-pyrimidinyl]titan

Die Verbindung des Beispiels 69 wird analog zu der Verbindung des Beispiels 58 hergestellt, wobei 6-Chlor-2,4-di(3-methyl-but-1-oxy)-pyrimidin durch 6-Chlor-2-i-butyl- thio-4-(3-methyl-but-1-oxy)-pyrimidin ersetzt wird.
Man erhält die Titelverbindung mit einem Schmelzbereich von 123-132 °C.

### Beispiel 70: Herstellung von Bis[cyclopentadienyl]-bis[2,4-bis(1,1-dimethylpropyl-oxy)-pyrimidinyl]titan

Die Verbindung des Beispiels 70 wird analog zu der Verbindung des Beispiels 58 herge- stellt, wobei 6-Chlor-2,4-di(3-methyl-but-1-oxy)-pyrimidin durch 5-Brom-2,4-bis(1,1-di- methylpropyloxy)-pyrimidin ersetzt wird. Die erhaltene Verbindung hat einen Schmelzbe- reich von 135-143 °C.

### Beispiele 71-78:

Die Herstellung der Verbindungen der Beispiele 71-78 erfolgt analog zu der der Verbindung des Beispiels 58, wobei als Edukt jeweils das in 5-Stellung bromierte Pyrimidin Derivat verwendet wird.
Die Verbindungen der Beispiele 71-78 und ihre physikalischen Daten sind der Tabelle 9 zu entnehmen.

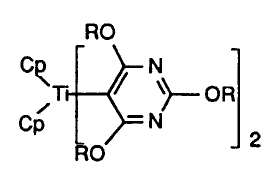

**Tabelle 9**

| Bsp. | R | Schmelzbereich [°C] | Ausbeute [%] | Elementaranalyse [%] | | |
|---|---|---|---|---|---|---|
| | | | | Atom | berechnet | gefunden |
| 71 | Methyl | 118-119 | 99,8 | C | 55,8 | 55,7 |
| | | | | H | 5,5 | 5,6 |
| | | | | N | 10,9 | 11,0 |
| 72 | Ethyl | 148-165 | 26,7 | C | 60,0 | 59,8 |
| | | | | H | 6,7 | 6,8 |
| | | | | N | 9,3 | 9,2 |
| 73 | i-Propyl | 135-145 | 44,2 | C | 63,2 | 62,2 |
| | | | | H | 7,7 | 7,6 |
| | | | | N | 8,2 | 8,1 |
| 74 | Methoxyethyl | flüssig | 39,9 | C | 55,4 | 55,6 |
| | | | | H | 6,7 | 7,2 |
| | | | | N | 7,2 | 6,8 |
| 75 | 3-Methyl-but-1-yl | flüssig | 46,3 | C | 67,6 | 68,7 |
| | | | | H | 9,0 | 9,4 |
| | | | | N | 6,6 | 5,9 |
| 76 | Cyclohexyl | 75-85 | 13,5 | C | 70,1 | 70,3 |
| | | | | H | 8,3 | 8,9 |
| | | | | N | 6,1 | 5,4 |
| 77 | Cyclohexylmethyl | 127-138 | 42,9 | C | 71,4 | 70,5 |
| | | | | H | 8,8 | 8,9 |
| | | | | N | 5,6 | 5,2 |
| 78 | Tetrahydrofurfuryl | Wachs | 36,0 | C | 61,5 | 60,7 |
| | | | | H | 6,9 | 6,9 |
| | | | | N | 6,0 | 5,7 |

### Beispiel 79: Herstellung von Biscyclopentadienyl-bis[6-chlor-4-(3-methyl-but-1-oxy)-2-phenyl-pyrimidinyl]titan

Die Reaktion wird unter Argon Schutzgasatmosphäre durchgeführt. Zu einer auf 0 °C gekühlten Lösung von 1,95 ml (13,8 ml) Diisopropylamin in 12,5 ml THF werden 8,6 ml einer 1,6 M n-Butyllithium-Lösung in Hexan (13,8 mMol) getropft. Die entstandene Lösung wird auf -78 °C gekühlt und eine Lösung von 3,7 g 4-Chlor-6-(3-methyl-but-1-oxy)-2-phenylpyrimidin in 12,5 ml THF wird zugetropft. Nachdem die Mischung 2 h bei -78 °C gerührt worden ist, werden 1,1 g festes Biscyclopentadienyltitandichlorid zugegeben. Die rote Suspension wird über Nacht bei -78 °C gerührt und mit überschüssigem Kohlendioxid (fest) versetzt. Danach wird die orange-braune Lösung auf 90 ml Wasser gegossen und mit Essigsäureethylester extrahiert. Nach dem Trocknen der organischen Phasen mit MgSO₄, Filtration und Einengen werden 4,9 g eines roten Produktes erhalten. Die Reinigung an SiO₂ (Essigsäureethylester/Siedegrenzebenin [80-110 °C] 1:9) ergibt 0,45 g Edukt, 0,3 g eines orange-roten Produkt-Konformeren mit dem Schmelzbereich 66-76 °C und 2,65 g eines gelben Produkt-Konformeren mit dem Schmelzbereich 169-174 °C.

| Elementaranalyse des orange-roten Produktes: | | | | | |
|---|---|---|---|---|---|
| ber. | C | 65,9 % | gef. | C | 65,6 % |
| | H | 5,8 % | | H | 5,9 % |
| | N | 7,7 % | | N | 7,2 % |
| | Cl | 9,7 % | | Cl | 10,2 % |

| Elementaranalyse des gelben Produktes: | | | | | |
|---|---|---|---|---|---|
| ber. | C | 65,9 % | gef. | C | 63,8 % |
| | H | 5,8 % | | H | 5,6 % |
| | N | 7,7 % | | N | 7,0 % |
| | Cl | 9,7 % | | Cl | 9,0 % |

### Beispiel 80: Selektive Herstellung des roten Konformeren von Biscyclopentadienyl-bis[6-chlor-4-(3-methyl-but-1-oxy)-2-phenyl-pyrimidinyl]titan

Ein Sulfierkolben wird unter Argon-Schutzgas mit 18 ml destilliertem THF und 8,3 ml Diisopropylamin puriss. gefüllt und auf -78 °C gekühlt. Dann werden 36,65 ml einer 1,6 M Lösung von n-Butyllithium in Hexan zugetropft. Die Lösung wird 10 min bei 0 °C gerührt. In einem zweiten Reaktionsgefäss werden 27 ml absolutes THF, 17,0 g 4-Chlor-6-(3-methyl-but-1-oxy)-2-phenyl-pyrimidin und 6,95 g Biscyclopentadienyltitan- dichlorid durch Rühren in Suspension gebracht (die entstehende Suspension ist rot) und auf -20/-15 °C gekühlt. Die Lösung des Lithiumdiisopropylamins (LDA) wird in einen Tropftrichter transferiert und langsam zu der Suspension getropft. Nach einer halben Stunde wird die kalte Lösung auf eine Mischung aus 60 ml Ethanol und 3,7 ml Essigsäure gegossen. Die Mischung wird mit Wasser verdünnt und mehrmals mit Essigsäureethyles- ter extrahiert. Die vereinigten organischen Phasen werden mit MgSO₄ getrocknet, filtriert und das Lösemittel am Rotationsverdampfer entfernt. Flash-Säulenchromatographie (Elutionsmittel Essigsäureethylester/Petrolether 20:80) liefert 12,1 g, d.h. 60 % Ausbeute des Produktes mit einem Schmelzbereich von 112-122 °C.

| Elementaranalyse: | | | | | |
|---|---|---|---|---|---|
| ber. | C | 65,9 % | gef.: | C | 65,7 % |
| | H | 5,8 % | | H | 5,7 % |
| | N | 7,7 % | | N | 7,6 % |
| | Cl | 9,7 % | | Cl | 9,7 % |

### Beispiele 81-90:

Die Verbindungen der Beispiele 81-90 werden analog zu der Verbindung des Beispiels 79 hergestellt. Die Verbindungen und ihre Daten sind der folgenden Tabelle 10 zu entnehmen.

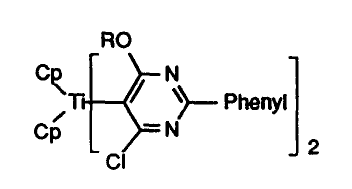

**Tabelle 10**

| Beispiel | R | Schmelz-Bereich [°C] | Ausbeute [%] | Elementaranalyse [%] | | |
|---|---|---|---|---|---|---|
| | | | | Atom | ber. | gef. |
| 81 | Methyl | 185-200 | 53 | C | 62,3 | 62,1 |
| | | | | H | 4,2 | 4,5 |
| | | | | N | 9,1 | 8,6 |
| | | | | Cl | 11,5 | 11,0 |
| 82 | Ethyl (A)* | 208-218 | 18 | C | 63,3 | 63,2 |
| | | | | H | 4,7 | 4,6 |
| | | | | N | 8,7 | 8,3 |
| | | | | Cl | 11,0 | 11,0 |
| | | | | | | |
| | Ethyl (B)* | 215-220 | 35 | C | 63,3 | 63,0 |
| | | | | H | 4,7 | 4,8 |
| | | | | N | 8,7 | 8,2 |
| | | | | Cl | 11,0 | 11,1 |
| 83 | i-Propyl | 105-115 | 28 | C | 64,2 | 65,2 |
| | | | | H | 5,1 | 5,4 |
| | | | | N | 8,3 | 7,8 |
| | | | | Cl | 10,5 | 9,9 |
| 84 | i-Butyl | 103-115 | 26,4 | C | 65,1 | 65,5 |
| | | | | H | 5,5 | 5,6 |
| | | | | N | 8,0 | 7,5 |
| | | | | Cl | 10,1 | 9,8 |
| 85 | Decyl | 78-88 | 16,2 | C | 69,0 | 68,3 |
| | | | | H | 7,2 | 7,2 |
| | | | | N | 6,4 | 6,3 |
| | | | | Cl | 8,2 | 8,5 |
| 86 | 2-Ethylhexyl | Harz | 21,8 | C | 67,9 | 67,9 |
| | | | | H | 6,7 | 6,9 |
| | | | | N | 6,9 | 6,6 |
| | | | | Cl | 8,7 | 8,4 |
| 87 | Cyclohexyl | 130-140 | 25 | C: | 66,9 | 67,6 |
| | | | | H: | 5,6 | 6,0 |
| | | | | N: | 7,4 | 7,0 |
| | | | | Cl: | 9,4 | 8,7 |
| 88 | Cyclohexylmethyl (A)* | 188-196 | 10 | C: | 67,6 | 67,4 |
| | | | | H: | 5,9 | 6,0 |
| | | | | N: | 7,2 | 7,0 |
| | | | | Cl: | 9,1 | 9,0 |
| | | | | | | |
| | Cyclohexyl- * methyl (B)* | 85-95 | 15 | C: | 67,6 | 66,9 |
| | | | | H: | 5,9 | 5,9 |
| | | | | N: | 7,2 | 6,8 |
| | | | | Cl: | 9,1 | 10,0 |
| 89 | Methoxyethyl | 94-104 | 42,2 | C: | 61,3 | 61,9 |
| | | | | H: | 4,9 | 5,2 |
| | | | | N: | 7,9 | 7,6 |
| | | | | Cl: | 10,1 | 9,8 |
| 90 | Phenoxyethyl | 110-120 | 22,5 | C: | 66,6 | 65,0 |
| | | | | H: | 4,6 | 4,9 |
| | | | | N: | 6,8 | 6,1 |
| | | | | Cl: | 8,6 | 8,1 |

| | | | | | | |
|---|---|---|---|---|---|---|
| * (A) und (B) sind zwei säulenchromatographisch trennbare Konformere | | | | | | |

### Beispiele 91-96:

Die Verbindungen der Beispiele 91-96 werden analog zu der Verbindung des Beispiels 79 hergestellt. Die Verbindungen und ihre Daten sind der folgenden Tabelle 11 zu entnehmen. Die Substanzen werden, mit Ausnahme der Verbindung des Beispiels 91, welche eine dickflüssige Flüssigkeit ist, als Harze erhalten.

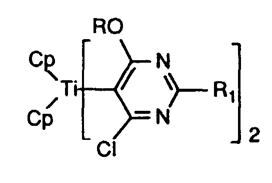

**Tabelle 11**

| Beispiel | R | R₁ | Ausbeute [%] | Elementaranalyse [%] | | |
|---|---|---|---|---|---|---|
| | | | | Atom | ber. | gef. |
| 91 | 3-Methyl-but-1-yl | n-Propyl | 40,6 | C | 61,7 | 61,7 |
| | | | | H | 7,0 | 7,1 |
| | | | | N | 8,5 | 8,4 |
| | | | | Cl | 10,7 | 10,0 |
| 92 | 2-Ethylhexyl | n-Propyl | 45 | C | 64,4 | 64,9 |
| | | | | H | 7,8 | 8,3 |
| | | | | N | 7,5 | 6,9 |
| | | | | Cl | 9,5 | 8,5 |
| 93 | 3-Methyl-but-1-yl | i-Propyl | 6,2 | C | 61,7 | 59,8 |
| | | | | H | 7,0 | 6,6 |
| | | | | N | 8,5 | 7,8 |
| | | | | Cl | 10,7 | 10,0 |
| 94 | 2-Ethylhexyl | i-Propyl | 41,3 | C | 64,4 | 62,1 |
| | | | | H | 7,8 | 7,7 |
| | | | | N | 7,5 | 7,0 |
| | | | | Cl | 9,5 | 8,9 |
| 95 | 3-Methyl-but-1-yl | Decyl | 22 | C | 67,2 | 65,3 |
| | | | | H | 8,7 | 8,9 |
| | | | | N | 6,5 | 5,9 |
| | | | | Cl | 8,3 | 6,7 |
| 96 | 2-Ethylhexyl | Decyl | - | C | 68,8 | 68,5 |
| | | | | H | 9,2 | 10,0 |
| | | | | N | 6,0 | 4,8 |
| | | | | Cl | 7,5 | 5,9 |

### Beispiele 97-98:

Die Verbindungen der Beispiele 97 und 98 werden analog zu der Verbindung des Beispiels 79 hergestellt. Die Verbindungen und ihre Daten sind der folgenden Tabelle 12 zu entnehmen.

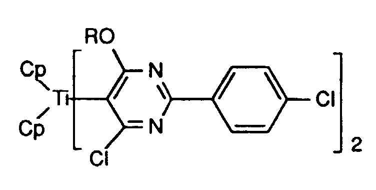

**Tabelle 12**

| Beispiel | R | Schmelzbereich [°C] | Ausbeute [%] | Elementaranalyse [%] | | |
|---|---|---|---|---|---|---|
| | | | | Atom | ber. | gef. |
| 97 | 2-Ethylhexyl | 83-95 | 42 | C | 62,6 | 62,8 |
| | | | | H | 5,9 | 6,1 |
| | | | | N | 6,4 | 5,9 |
| | | | | Cl | 16,1 | 15,7 |
| 98 | Phenoxyethyl | 107-117 | 15,5 | C | 61,5 | 62,1 |
| | | | | H | 4,0 | 4,3 |
| | | | | N | 6,2 | 6,1 |
| | | | | Cl | 15,8 | 15,4 |

### Beispiele 99-100:

Die Verbindungen der Beispiele 99 und 100 werden analog zu der Verbindung des Beispiels 79 hergestellt. Die Verbindungen und ihre Daten sind der folgenden Tabelle 13 zu entnehmen.

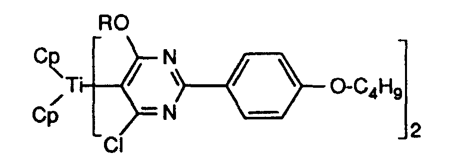

**Tabelle 13**

| Beispiel | R | Schmelzbereich [°C] | Ausbeute [%] | Elementaranalyse [%] | | |
|---|---|---|---|---|---|---|
| | | | | Atom | ber. | gef. |
| 99 | 3-Methyl-but-1-yl | 90-110 | 65 | C | 66,0 | 66,0 |
| | | | | H | 6,7 | 6,9 |
| | | | | N | 6,4 | 6,3 |
| | | | | Cl | 8,1 | 8,2 |
| 100 | 2-Ethylhexyl | Harz | 28,7 | C | 67,7 | 69,7 |
| | | | | H | 7,4 | 7,9 |
| | | | | N | 5,9 | 5,5 |
| | | | | Cl | 7,4 | 7,0 |

### Beispiele 101-103:

Die Verbindungen der Beispiele 101-103 werden analog zu der Verbindung des Beispiels 79 hergestellt. Die Verbindungen und ihre Daten sind der folgenden Tabelle 14 zu entnehmen.

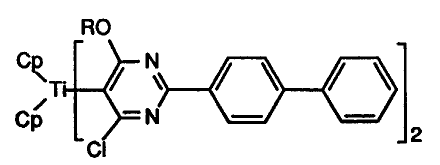

**Tabelle 14**

| Beispiel | R | Schmelzbereich [°C] | Ausbeute [%] | Elementaranalyse [%] | | |
|---|---|---|---|---|---|---|
| | | | | Atom | ber. | gef. |
| 101 | 3-Methyl-but-1-yl | 73-83 | 7,3 | C | 70,8 | 70,8 |
| | | | | H | 5,7 | 6,2 |
| | | | | N | 6,4 | 5,6 |
| | | | | Cl | 8,0 | 7,3 |
| 102 | 2-Ethylhexyl | 73-85 | 33,5 | C | 72,0 | 72,1 |
| | | | | H | 6,7 | 6,8 |
| | | | | N | 5,8 | 5,2 |
| | | | | Cl | 7,3 | 7,0 |
| 103 | Phenoxyethyl | 110-120 | 13 | C | 71,0 | 71,0 |
| | | | | H | 4,7 | 5,1 |
| | | | | N | 5,7 | 5,6 |
| | | | | Cl | 7,2 | 7,0 |

### Beispiele 104-110:

Die Verbindungen der Beispiele 104-110 werden analog zu der Verbindung des Beispiels 79 hergestellt. Die Verbindungen und ihre Daten sind der folgenden Tabelle 15 zu entnehmen.

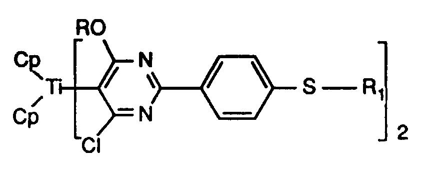

**Tabelle 15**

| Beispiel | R | R₁ | Schmelzbereich [°C] | Ausbeute [%] | Elementaranalyse [%] | | |
|---|---|---|---|---|---|---|---|
| | | | | | Atom | ber. | gef. |
| 104 | 3-Methyl-but-1-yl | Octyl | Harz | 47,0 | C | 66,1 | 65,7 |
| | | | | | H | 7,3 | 7,2 |
| | | | | | N | 5,5 | 5,1 |
| | | | | | S | 6,3 | 6,1 |
| | | | | | Cl | 7,0 | 7,4 |
| 105 | Ethyl | Octyl | Harz | 15,5 | C | 64,3 | 64,7 |
| | | | | | H | 6,7 | 6,9 |
| | | | | | N | 6,0 | 5,5 |
| | | | | | S | 6,9 | 6,3 |
| | | | | | Cl | 7,6 | 7,1 |
| 106 | Phenoxyethyl | Octyl | Harz | 40,4 | C | 66,6 | 66,8 |
| | | | | | H | 6,3 | 6,3 |
| | | | | | N | 5,0 | 5,0 |
| | | | | | S | 5,7 | 5,6 |
| | | | | | Cl | 6,3 | 6,2 |
| 107 | Ethyl | Methyl | 155-165 | 44,6 | C | 58,6 | 59,7 |
| | | | | | H | 4,6 | 4,9 |
| | | | | | N | 7,6 | 7,2 |
| | | | | | S | 8,7 | 8,3 |
| | | | | | Cl | 9,6 | 9,1 |
| 108 | 3-Methyl-but-1-yl | Methyl | 102-112 | 45,0 | C | 61,4 | 61,4 |
| | | | | | H | 5,7 | 5,8 |
| | | | | | N | 6,8 | 6,6 |
| | | | | | S | 8,6 | 8,7 |
| | | | | | Cl | 7,8 | 7,5 |
| 109 | 2-Ethylhexyl | Methyl | Harz | 24,6 | C | 63,3 | 61,4 |
| | | | | | H | 6,5 | 6,2 |
| | | | | | N | 6,2 | 5,9 |
| | | | | | S | 7,8 | 7,7 |
| | | | | | Cl | 7,1 | 7,0 |
| 110 | Phenoxyethyl | Methyl | 101-110 | 15,0 | C | 62,5 | 63,3 |
| | | | | | H | 4,6 | 5,0 |
| | | | | | N | 6,1 | 5,7 |
| | | | | | S | 7,0 | 6,4 |
| | | | | | Cl | 7,7 | 7,2 |

### Beispiele 111-113:

Die Verbindungen der Beispiele 111-113 werden analog zu der Verbindung des Beispiels 79 hergestellt. Die Verbindungen und ihre Daten sind der folgenden Tabelle 16 zu entnehmen.

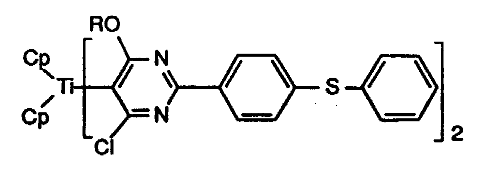

**Tabelle 16**

| Beispiel | R | Schmelzbereich [°C] | Ausbeute [%] | Elementaranalyse [%] | | |
|---|---|---|---|---|---|---|
| | | | | Atom | ber. | gef. |
| 111 | 3-Methyl-but-1-yl | 87-97 | 20,8 | C | 66,0 | 65,5 |
| | | | | H | 5,3 | 5,3 |
| | | | | N | 5,9 | 5,9 |
| | | | | S | 7,5 | 7,5 |
| | | | | Cl | 6,8 | 6,7 |
| 112 | 2-Ethylhexyl | 67-77 | 44,6 | C | 67,6 | 67,9 |
| | | | | H | 6,1 | 6,3 |
| | | | | N | 5,4 | 5,2 |
| | | | | S | 6,2 | 6,3 |
| | | | | Cl | 6,9 | 6,8 |
| 113 | Phenoxyethyl | 94-104 | 32,7 | C | 66,6 | 67,7 |
| | | | | H | 4,4 | 4,9 |
| | | | | N | 5,3 | 5,1 |
| | | | | S | 6,8 | 6,5 |
| | | | | Cl | 6,1 | 5,9 |

### Beispiel 114: Herstellung von Bis(cyclopentadienyl)-bis[6-chloro-2-(p-N,N-dimethylaminophenyl)-4-(3-methyl-but-1-oxy)-pyrimidinyl]-titan

Die Herstellung der Titelverbindung erfolgt analog zu der in Beispiel 79 beschriebenen Methode. Die Verbindung wird in einer Ausbeute von 16 % d. Theorie mit einem Schmelzbereich von 105-115 °C erhalten.

| Elementaranalyse: | | | | | |
|---|---|---|---|---|---|
| ber. | C | 64,8 % | gef. | C | 64,7 % |
| | H | 6,4 % | | H | 6,5 % |
| | N | 10,3 % | | N | 10,7 % |
| | Cl | 8,7 % | | Cl | 8,8 % |

### Beispiel 115: Herstellung von Bis(cyclopentadienyl)-bis[6-chloro-4-(3-methyl-but-1-oxy)-2-pyrrolo-pyrimidinyl]-titan

Die Herstellung der Titelverbindung erfolgt analog zu der in Beispiel 79 beschriebenen Methode. Die Verbindung wird in einer Ausbeute von 38 % d. Theorie mit einem Schmelzbereich von 152-158 °C erhalten.

| Elementaranalyse: | | | | | |
|---|---|---|---|---|---|
| ber. | C | 61,6 % | gef. | C | 59,2 % |
| | H | 5,7 % | | H | 5,6 % |
| | N | 11,9 % | | N | 11,0 % |
| | Cl | 10,0 % | | Cl | 9,4 % |

### Beispiel 116: Herstellung von Bis(cyclopentadienyl)-bis[4,6-di(3-methyl-but-1-oxy)-2-phenyl-pyrimidinyl]-titan

Die Herstellung der Titelverbindung erfolgt analog zu der in Beispiel 79 beschriebenen Methode. Die Verbindung wird in einer Ausbeute von 37 % d. Theorie mit einem Schmelzbereich von 173-175 °C erhalten.

| Elementaranalyse: | | | | | |
|---|---|---|---|---|---|
| ber. | C | 72,1 % | gef. | C | 72,3 % |
| | H | 7,7 % | | H | 7,8 % |
| | N | 6,7 % | | N | 6,6 % |

### Beispiel 117: Herstellung von Bis(cyclopentadienyl)-bis[6-chloro-4-(2-ethylhexyloxy)-pyrimidinyl]-titan

Die Herstellung der Titelverbindung erfolgt analog zu der in Beispiel 79 beschriebenen Methode. Die Verbindung wird als Harz in einer Ausbeute von 49 % d. Theorie erhalten.

| Elementaranalyse: | | | | | |
|---|---|---|---|---|---|
| ber. | C | 61,7 % | gef. | C | 61,9 % |
| | H | 7,0 % | | H | 7,4 % |
| | N | 8,5 % | | N | 8,1 % |
| | Cl | 10,7 % | | Cl | 10,0 % |

### Beispiel 118: Herstellung von Bis(cyclopentadienyl)-[4-chloro-6-(3-methyl-but-1-oxy)-2-phenyl-pyrimidinyl]-acetyloxy-titan

In einer Stickstoffatmosphäre werden zu einer Lösung aus 15,6 ml (0,11 Mol) Diisopropylamin in 200 ml Tetrahydrofuran bei 0 °C 69 ml (0,11 Mol, 1,6 M) Butyllithium innerhalb von 15 min getropft. Diese Lösung wird bei -70 bis -60 °C innerhalb von 2 Stunden zu einer Suspension aus 24,9 g (0,1 Mol) Titanocendichlorid und 27,7 g (0,1 Mol) 4-Chloro-6-(3-methyl-but-1-oxy)-2-phenyl-pyrimidin in 1000 ml Tetrahydrofuran getropft. Nach 1 h Rühren bei -70 °C lässt man das Reaktionsgemisch in ca. 3 h auf Raumtemperatur erwärmen und giesst es anschliessend unter Rühren auf Wasser und 19,0 g (0,23 Mol) Essigsäure. Die entstandene rotorange Emulsion wird über ®Hyflo filtriert. Nach dem Abtrennen der organischen Phase wird diese mit Magnesiumsulfat getrocknet, filtriert und am Rotationsverdampfer eingeengt. Der Rückstand wird mittels Flash-Chromatographie mit Hexan/Essigsäureethylester im Verhältnis 3:1 als Laufmittel gereinigt. Es resultieren 11,2 g (22,4 % d.Theorie) der Titelverbindung als gelbes Pulver mit einem Schmelzpunkt von 158 °C.

| Elementaranalyse: | | | | | |
|---|---|---|---|---|---|
| ber. | C | 62,4 % | gef. | C | 62,9 % |
| | H | 5,8 % | | H | 5,8 % |
| | N | 5,6 % | | N | 5,3 % |
| | Cl | 7,1 % | | Cl | 7,0 % |

### Beispiel 119: Herstellung von Bis(cyclopentadienyl)-[4-chloro-6-(3-methyl-but-1-oxy)-2-phenyl-pyrimidinyl]-benzoyloxy-titan

Die Titelverbindung wird analog zu der Verbindung des Beispiels 118 hergestellt, wobei die Essigsäure durch Benzoesäure ersetzt wird. Es resultieren 2,6 g (4,6 % d. Theorie) der Titelverbindung als oranges Pulver mit einem Schmelzpunkt von 118-120 °C.

| Elementaranalyse: | | | | | |
|---|---|---|---|---|---|
| ber. | C | 66,1 % | gef. | C | 66,3 % |
| | H | 5,6 % | | H | 5,6 % |
| | N | 5,0 % | | N | 4,6 % |
| | Cl | 6,3 % | | Cl | 6,4 % |

### Beispiel 120: Herstellung von Bis(cyclopentadienyl)-bis[3,5-dichloro-1-phenyl-pyrazol-4-yl]-titan

120.1: N-Phenyl-3,5-dichloropyrazol
Die Herstellung des N-Phenyl-3,5-dichloropyrazols erfolgt nach der von A. Michaelis und H. Röhmer in Berichte XXXIII, 3009 (1898) beschriebenen Methode. N-Phenyl-3,5-dichloropyrazol wird jedoch nicht als Festsubstanz mit einem Schmelzbereich von 22-26 °C, wie dort beschrieben ist, erhalten, sondern fällt als leicht gelbes Oel an.

| Elementaranalyse von N-Phenyl-3,5-dichloropyrazol: | | | | | |
|---|---|---|---|---|---|
| ber. | C | 50,8 % | gef. | C | 50,8 % |
| | H | 2,8 % | | H | 3,0 % |
| | N | 13,2 % | | N | 13,3 % |
| | Cl | 33,3 % | | Cl | 32,9 % |

120.2: Bis(cyclopentadienyl)-[4-chloro-6-(3-methyl-but-1-oxy)2-phen- yl-pyrimidinyl]-benzoyloxy-titan
Das Titelprodukt wird analog zu der Verbindung des Beispiels 80 hergestellt. Dabei wird jedoch das 4-Chlor-6-(3-methyl-but-1-oxy)-2-phenyl-pyrimidin durch N-Phenyl-3,5-dichloropyrazol ersetzt. Auch die Isolierung der Verbindung erfolgt auf anderem Wege: Nach der Zugabe des Lithiumdiisopropylamins wird die Reaktionsmischung auf Wasser/Essigsäure gegossen, wobei ein roter Niederschlag entsteht. Der Niederschlag wird filtriert, mit Wasser gewaschen und getrocknet. Es resulieren 80,4 % d.Theorie der Titelverbindung mit einem Schmelzbereich von 234-244 °C.

| Elementaranalyse: | | | | | |
|---|---|---|---|---|---|
| ber. | C | 55,9 % | gef. | C | 55,9 % |
| | H | 3,4 % | | H | 3,8 % |
| | N | 9,3 % | | N | 8,9 % |
| | Cl | 23,6 % | | Cl | 22,0 % |

### Beispiel 121: Reaktivitätstest in einem Klarlack

Durch Mischen der folgenden Komponenten wird eine photohärtbare Zusammensetzung hergestellt:

| | |
|---|---|
| 10,0 g | Dipentaerythritol-Monohydroxy-Pentaacrylat, ®SR 399, Sartomer Co., Berkshire, GB |
| 15,0 g | Tripropylenglycol-Diacrylat, Stoarmer Co., Berkshire, GB |
| 15,0 g | N-Vinylpyrrolidon, Fluka |
| 10,0 g | Trismethylolpropan-Triacrylat, Degussa |
| 50,0 g | Urethan-Acrylat ®Actilan AJ20, Societé National des Poudres et Explosifs |
| 0,3 g | Verlaufhilfsmittel ®Byk 300, Byk-Mallinckrodt. |

Portionen dieser Zusammensetzung werden mit 0,3 %, bezogen auf den Feststoffgehalt, des erfindungsgemässen Titanocen-Photoinitiators vermischt. Alle Operationen werden unter Rotlicht ausgeführt. Die mit Initiator versetzten Proben werden auf eine 200 µm Aluminiumfolie aufgetragen. Die Stärke der Trockenschicht ist 60 µm. Auf diesen Film wird eine 76 µm dicke Polyesterfolie aufgebracht und auf diese ein standardisiertes Testnegativ mit 21 Stufen unterschiedlicher optischer Dichte (Stauffer Keil) aufgelegt. Die Probe wird mit einer zweiten UV-transparenten Folie abgedeckt und auf einer Metallplatte mittels Vakuum angepresst. Die Belichtung erfolgt in einer ersten Testreihe während 5 Sekunden, in einer zweiten während 10 und in einer dritten während 20 Sekunden im Abstand von 30 cm mittels einer 5kW Lampe. Nach der Belichtung werden die Folien und die Maske entfernt und die belichtete Schicht wird in einem Ultraschallbad bei 23 °C in Ethanol 10 Sekunden lang entwickelt. Die Trocknung erfolgt bei 40 °C während 5 Minuten in einem Umluftofen. Die Empdindlichkeit des verwendeten Initiatorsystems wird durch die Angabe der letzten klebefrei abgebildeten Keilstufe charakterisiert. Je höher die Zahl der Stufen ist, desto empfindlicher ist das getestete System.
Die Ergebnisse sind in den Tabellen 17 und 18 zusammengefasst.

**Tabelle 17**

| Verbindung aus Bsp. | Zahl der abgebildeten Stufen | | |
|---|---|---|---|
| | nach 5s | 10s | 20s Belichtung |
| 60 | 9 | 12 | 15 |
| 61 | 8 | 11 | 13 |
| 62 | 8 | 11 | 13 |
| 65 | 7 | 10 | 13 |
| 72 | 7 | 7 | 11 |
| 74 | 8 | 11 | 13 |
| 75 | 9 | 11 | 14 |

**Tabelle 18**

| Verbindung aus Bsp. | Zahl der abgebildeten Stufen | | |
|---|---|---|---|
| | nach 5s | 10s | 20s Belichtung |
| 58 | 8 | 10 | 13 |
| 63 | 7 | 9 | 12 |
| 68 | 7 | 9 | 12 |
| 73 | 9 | 11 | 15 |
| 76 | 7 | 9 | 12 |

### Beispiel 122: Reaktivitätstest in einem Lötresist

Es wird eine Zusammensetzung hergestellt aus:

| | |
|---|---|
| 37,64 g | Pentaerythritol-Triacrylat ®SR 444, Sartomer Co., Berkshire, GB |
| 10,76 g | Hexamethoxymethylmelamin ®Cymel 301, American Cyanamid Corp. |
| 47,30 g | Thermoplastisches Acrylat mit Carboxylgruppen ®Carboset 525, B.F. Goodrich, Ohio, USA |
| 4,30 g | Polyvinylpyrrolidon PVP 30, GAF AG, Zug, CH. |
| Zu 100 g | dieser Zusammensetzung werden |
| 0,5 g | Irgalithgrün |
| 319,0 g | Methylenchlorid und |
| 30,0 g | Methanol gegeben. |

Portionen dieser Zusammensetzung werden mit 0,3 %, bezogen auf den Feststoffgehalt, der zu testenden Titanocen-Verbindung vermischt. Alle Operationen werden unter Rotlicht ausgeführt. Die mit Initiator versetzten Proben werden mit einer Trockenschichtstärke von 30 µm auf eine 200 µm Aluminiumfolie aufgetragen. Das Lösemittel wird durch Erwärmung auf 60 °C während 15 Minuten im Umluftofen entfernt. Auf den Film wird eine 76 µm dicke Polyesterfolie aufgebracht und auf diese ein standardisiertes Testnegativ mit 21 Stufen unterschiedlicher optischer Dichte (Stauffer-Keil) gelegt. Mit einer zweiten UV-transparenten Folie wird die Probe abgedeckt und mittels Vakuum auf einer Metallplatte angepresst. Die Probe wird dann mit einer 5 kW Lampe in einer ersten Testreihe 10 Sekunden, in einer zweiten 20 und in einer dritten Testserie 40 Sekunden in einem Abstand von 30 cm belichtet. Nach der Belichtung werden die Folien und die Maske entfernt, die belichtete Schicht in einem Ultraschallbad 4 Minuten mit dem Entwickler A* bei 23 °C entwickelt und anschliessend getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System.

Die Ergebnisse sind in den Tabellen 19 und 20 angegeben.

* Der Entwickler A besteht aus:

| | |
|---|---|
| 15,00 g | Natriummetasilikat · 9 H₂O |
| 0,16 g | Kaliumhydroxid |
| 3,00 g | Polyethylenglycol 6000 |
| 0,50 g | Lävulinsäure |
| 1000,0 g | deionisiertes Wasser |

**Tabelle 19**

| Verbindung ausBsp. | Zahl der abgebildeten Stufen | | |
|---|---|---|---|
| | nach 10s | 20s | 40s Belichtung |
| 61 | 8 | 11 | 13 |
| 62 | 8 | 10 | 13 |
| 65 | 7 | 9 | 12 |

**Tabelle 20**

| Verbindung aus Bsp. | Zahl der abgebildeten Stufen | | |
|---|---|---|---|
| | nach 10s | 20s | 40s Belichtung |
| 58 | 9 | 12 | 15 |
| 60 | 9 | 12 | 15 |
| 63 | 8 | 10 | 13 |
| 64 | 8 | 10 | 13 |
| 68 | 8 | 10 | 13 |

### Beispiel 123: Reaktivität in einer Aetzresistformulierung

Durch Mischen der folgenden Komponenten wird eine photohärtbare Zusammensetzung hergestellt:

| | |
|---|---|
| 10,0 g | Dipentaerythritol-Monohydroxy-Pentaacrylat, ®SR 399, Sartomer Co., Berkshire, GB |
| 15,0 g | Tripropylenglycol-Diacrylat, Sartomer Co., Berkshire, GB |
| 15,0 g | N-Vinylpyrrolidon, Fluka |
| 10,0 g | Trimethylolpropan-Triacrylat, Degussa |
| 50,0 g | Urethan-Acrylat ®Actilan AJ20, Societé National des Poudres et Explosifs |
| 0,3 g | Verlaufhilfsmittel ®Byk 300, Byk-Mallinckrodt. |

Portionen dieser Zusammensetzung werden mit 0,3 %, bezogen auf den Feststoffgehalt, des erfindungsgemässen Titanocen-Photoinitiators vermischt. Alle Operationen werden unter Rotlicht ausgeführt. Die mit Initiator versetzten Proben werden in einer Stärke von 100 µm auf eine 300 µm Aluminiumfolie aufgetragen. Die Stärke der Trockenschicht ist 60 µm-70 µm. Auf diesen Film wird eine 76 µm dicke Polyesterfolie aufgebracht und auf diese ein standardisiertes Testnegativ mit 21 Stufen unterschiedlicher optischer Dichte (Stauffer Keil) aufgelegt. Die Probe wird mit einer zweiten UV-transparenten Polyesterfolie abgedeckt und auf einer Metallplatte mittels Vakuum angepresst. Die Belichtung erfolgt in einer ersten Testreihe während 5 Sekunden, in einer zweiten während 10 und in einer dritten während 20 Sekunden im Abstand von 30 cm mittels einer 5kW Lampe. Nach der Belichtung werden die Folien und die Maske entfernt und die belichtete Schicht wird in einem Ultraschallbad bei 23 °C in Ethanol 10 Sekunden lang entwickelt Die Trocknung erfolgt bei 40 °C während 5 Minuten in einem Umluftofen. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das getestete System.
Die Ergebnisse sind in der Tabelle 21 zusammengefasst.

**Tabelle 21**

| Vcrbindung aus Bsp. | Zahl der abgebildeten Stufen | | |
|---|---|---|---|
| | nach 5s | 10s | 20s Belichtung |
| 107 | 11 | 14 | 17 |
| 108 | 12 | 15 | 18 |
| 110 | 11 | 13 | 16 |
| 111 | 10 | 12 | 15 |
| 112 | 11 | 13 | 16 |
| 113 | 11 | 13 | 16 |
| 114 | 13 | 15 | 18 |
| 120 | 9 | 11 | 13 |
| 81 | 11 | 14 | 17 |
| 82 B | 8 | 11 | 13 |
| 83 | 9 | 12 | 14 |
| 84 | 10 | 13 | 15 |
| 85 | 11 | 14 | 16 |
| 87 | 10 | 12 | 15 |
| 88 A | 10 | 12 | 15 |
| 89 | 11 | 14 | 17 |
| 90 | 11 | 13 | 16 |
| 97 | 11 | 13 | 16 |
| 98 | 10 | 12 | 15 |
| 101 | 10 | 12 | 15 |
| 102 | 12 | 15 | 18 |
| 103 | 10 | 13 | 16 |
| 99 | 10 | 13 | 16 |
| 100 | 10 | 13 | 16 |
| 105 | 10 | 12 | 15 |
| 106 | 10 | 13 | 16 |

### Beispiel 124: Reaktivität in einer Lötresistformulierung

Es wird eine Zusammensetzung hergestellt aus:

| | |
|---|---|
| 37,64 g | Trimethylolpropan-triacrylat, Degussa |
| 10,76 g | Hexamethoxymethylmelamin ®Cymel 301, American Cyanamid Corp. |
| 47,30 g | Polyacrylat mit 3-5% Carboxylgruppen ®Carboset 525, B.F. Goodrich, Ohio, USA |
| 4,30 g | Polyvinylpyrrolidon PVP 30, GAF AG, Zug, CH. |
| Zu 100 g | dieser Zusammensetzung werden |
| 0,5 g | Irgalithgrün |
| 319,0 g | Methylenchlorid und |
| 30,0 g | Methanol gegeben. |

Portionen dieser Zusammensetzung werden mit 0,3 %, bezogen auf den Feststoffgehalt, der zu testenden Titanocen-Verbindung vermischt. Alle Operationen werden unter Rotlicht ausgefürt. Die mit Initiator versetzten Proben werden in einer Stärke von 200 µm auf eine 300 µm Aluminiumfolie aufgetragen. Die Stärke der Trockenschicht beträgt 30-35 µm. Es wird 5 Minuten bei Raumtemperatur trocknen lassen. Das Lösemittel wird dann durch Erwärmung auf 60 °C während 15 Minuten im Umluftofen entfernt. Auf den Film wird eine 76 µm dicke Polyesterfolie aufgebracht und auf diese ein standardisiertes Testnegativ mit 21 Stufen unterschiedlicher optischer Dichte (Stauffer-Keil) gelegt. Mit einer zweiten UV-transparenten Polyesterfolie wird die Probe abgedeckt und mittels Vakuum auf einer Metallplatte angepresst. Die Probe wird dann mit einer 5 kW Lampe im Abstand von 30 cm in einer ersten Testreihe 10 Sekunden, in einer zweiten 20 und in einer dritten Testserie 40 Sekundenbelichtet. Nach der Belichtung werden die Folien und die Maske entfernt, die belichtete Schicht in einem Ultraschallbad 4 Minuten mit einem Entwickler* bei 23 °C entwickelt und anschliessend 5 Minuten bei 40 °C getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System.
Die Ergebnisse sind in der Tabelle 22 angegeben.
* Der Entwickler besteht aus:

| | |
|---|---|
| 15,00 g | Natriummetasilikat · 9 H₂O |
| 0,16 g | Kaliumhydroxid |
| 3,00 g | Polyethylenglycol 6000 |
| 0,50 g | Lävulinsäure |
| 1000,5 g | deionisiertes Wasser |

**Tabelle 22**

| Verbindung aus Bsp. | Zahl der abgebildeten Stufen | | |
|---|---|---|---|
| | nach 10s | 20s | 40s Belichtung |
| 81 | 12 | 14 | 17 |
| 82 B | 12 | 14 | 17 |
| 83 | 11 | 14 | 16 |
| 84 | 11 | 13 | 16 |
| 85 | 11 | 13 | 16 |
| 87 | 10 | 12 | 15 |
| 88 A | 10 | 12 | 15 |
| 89 | 12 | 14 | 17 |
| 90 | 11 | 13 | 16 |
| 97 | 12 | 14 | 16 |
| 98 | 10 | 12 | 15 |
| 101 | 10 | 12 | 15 |
| 102 | 13 | 15 | 17 |
| 103 | 10 | 12 | 15 |
| 99 | 11 | 13 | 16 |
| 100 | 11 | 13 | 15 |
| 105 | 11 | 13 | 16 |
| 106 | 11 | 13 | 16 |
| 107 | 12 | 14 | 17 |
| 108 | 13 | 16 | 19 |
| 110 | 11 | 13 | 16 |
| 111 | 11 | 13 | 15 |
| 112 | 11 | 13 | 16 |
| 113 | 10 | 12 | 15 |
| 114 | 15 | 17 | 20 |
| 120 | 10 | 12 | 15 |

## Patentansprüche

1. Verbindungen der Formel I oder II 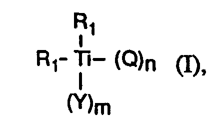 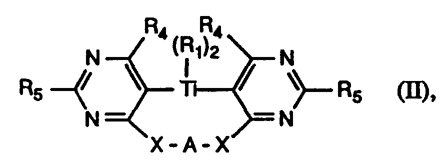 worin beide R₁ unabhängig voneinander Cyclopentadienyl^{⊖}, Indenyl^{⊖} oder 4,5,6,7-Tetrayhydroindenyl^{⊖} bedeuten, wobei diese Reste unsubstituiert oder durch C₁-C₁₈-Alkyl oder -Alkoxy, C₂-C₁₈-Alkenyl, C₅-C₈-Cycloalkyl, C₁-C₄-Alkyl-C₅-C₈-cycloalkyl, Phenyl, Naphthyl, mit Phenyl substituiertes C₁-C₁₂-Alkyl, -Si(R₂)₃, -Ge(R₂)₃, Cyano, Cl, Br oder I substituiert sind und
beide R₂ unabhängig voneinander C₁-C₁₂-Alkyl, C₅-C₈-Cycloalkyl, unsubstituiertes oder mit C₁-C₆-Alkyl substituiertes Phenyl oder Benzyl bedeuten,
Q für einen Rest 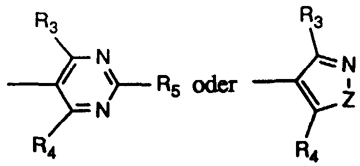 steht,
Z für -NR₁₀-, -O- oder -S- steht,
Y Cl, Br, I, CN, SCN, -O-CO-CH₃, -O-CO-Phenyl oder -O-SO₂-CH₃ bedeutet
n 1 oder 2 ist,
m 0 oder 1 ist, wobei die Summe von n und m 2 sein muss,
R₃, R₄ und R₅ unabhängig voneinander Wasserstoff, Cl, Br, I, unsubstituiertes oder mit C₁-C₄-Alkoxy, C₅-C₆-Cycloalkyl oder Phenyl substituiertes C₁-C₁₂-Alkyl, unsubstituiertes oder mit C₁-C₄-Alkyl substituiertes C₃-C₈-Cycloalkyl oder Adamantyl sind, oder R₃, R₄ und R₅ Phenyl, Pyrryl, Furyl, Thienyl, Imidazolyl, Pyridyl, Naphthyl, Anthryl, Phenanthryl oder Biphenylyl bedeuten, wobei die Reste Phenyl, Pyrryl, Furyl, Thienyl, Imidazolyl, Pyridyl, Naphthyl, Anthryl, Phenanthryl oder Biphenylyl unsubstituiert oder mit C₁-C₁₂-Alkyl, Cyclopentyl, Cyclohexyl, Cl, Br, I, C₁-C₈-Alkylthio, -NR₈R₉, Phenyl, Phenylthio oder/und C₁-C₁₀-Alkoxy substituiert sind, oder R₃, R₄ und R₅ unsubstituiertes C₂-C₁₂-Alkenyl oder C₂-C₁₂-Alkenyl, welches mit unsubstituiertem oder mit C₁-C₄-Alkyl 1, C₁-C₄-Alkoxy, C₁-C₄-Alkylthio, Cl, Br oder I substituiertem Phenyl oder 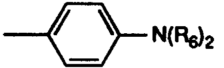 substituiert ist, bedeuten, oder R₃, R₄ und R₅ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy, C₂-C₆-Alkenyloxy, -O-Si-(R₇)₃, C₁-C₈-Alkylthio, C₃-C₈-Cycloalkylthio, unsubstituiertes oder mit C₁-C₄-Alkyl und/oder C₁-C₄-Alkoxy substituiertes Benzylthio,unsubstituiertes oder mit C₁-C₄-Alkyl und/oder C₁-C₄-Alkoxy substituiertes Phenylthio, -S(O)R₈, -SO₂R₈, -N(R₉)₂, 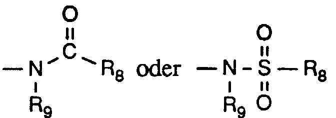 bedeuten,
wobei R₃ und R₄ nicht gleichzeitig Wasserstoff bedeuten, und im Rest 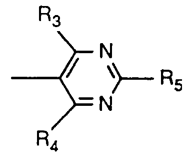 mindestens ein Rest R₃ oder R₄ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
und im Falle, dass Z -NR₁₀- ist, R₃ und R₄ Cl, Br oder I darstellen,
beide R₆ unabhängig voneinander C₁-C₄-Alkyl oder C₂-C₁₀-Alkenyl bedeuten oder beide
R₆ zusammen mit dem N-Atom, an welches sie gebunden sind einen Morpholino-Rest bilden,
R₇ für C₁-C₁₂-Alkyl, C₅-C₈-Cycloalkyl, unsubstituiertes oder mit C₁-C₆-Alkyl substituiertes Phenyl steht,
R₈ unsubstituiertes oder mit C₁-C₄-Alkyl substituiertes Phenyl oder in α-Position tertiäres C₄-C₆-Alkyl darstellt,
R₉ unsubstituiertes oder mit Phenyl, C₇-C₁₂-Alkylphenyl, C₅-C₈-Cycloalkyl oder C₁-C₄-Alkyl-C₅-C₈-cycloalkyl substituiertes C₁-C₈-Alkyl, C₂-C₈-Alkenyl, unsubstituiertes oder mit C₁-C₄-Alkyl substituieres C₅-C₈-Cycloalkyl, C₆-C₂₀-Cycloalkenylalkyl, unsubstituiertes oder mit C₁-C₁₂-Alkyl substituiertes Phenyl, einen Rest 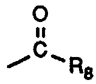 oder 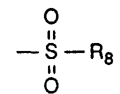 bedeutet, wobei ausserdem in -N(R₉)₂ beide R₉ gleich oder verschieden sind und die beiden R₉ zusammen mit dem N-Atom, an welches sie gebunden sind, einen 5- oder 6-gliedrigen Heterozyklus, der neben dem N-Atom noch weitere N-, O- oder S-Atome enthalten kann, bilden können, oder die beiden R₉ zusammen mit dem N-Atom, an welches sie gebunden sind, einen Rest 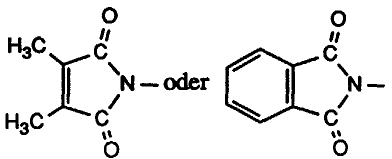 bilden,
R₁₀ die Bedeutungen von R₉ hat und zusätzlich Naphthyl, Biphenylyl, Pyridyl oder Pyrimidinyl ist, wobei diese Reste unsubstituiert oder mit Cl, Br, I, NO₂, C₁-C₁₂-Alkyl, C₁-C₁₀-Alkoxy, C₁-C₈-Alkylthio, Phenylthio, Morpholino oder -N(C₁-C₄-Alkyl)₂ substituiert sind, oder R₁₀ mit Cl, Br, I, NO₂, C₁-C₁₀-Alkoxy, C₁-C₈-Alkylthio, Phenylthio, Morpholino oder -N(C₁-C₄-Alkyl)₂ substituiertes Phenyl ist,
X -O-, -S-, 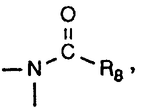 Methylen oder Ethylen bedeutet,
A für C₁-C₁₂-Alkylen steht, oder -X-A-X- für eine direkte Bindung steht.

2. Verbindungen nach Anspruch 1, worin beide R₁ unabhängig voneinander unsubstituiertes oder durch C₁-C₁₈-Alkyl oder -Alkoxy, C₂-C₁₈-Alkenyl, -Si(R₂)₃ oder Cl, Br, I, insbesondere C₁-C₄-Alkyl, substituiertes Cyclopentadienyl^{⊖} bedeuten.

3. Verbindungen der Formel I nach Anspruch 1, worin R₃ und R₅ für unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy stehen.

4. Verbindungen nach Anspruch 1, worin R₅ C₁-C₈-Alkythio, C₃-C₈-Cycloalkylthio, unsubstituiertes oder mit C₁-C₄-Alkyl oder/und C₁-C₄-Alkoxy substituiertes Benzylthio, unsubstituiertes oder mit C₁-C₄-Alkyl oder/und C₁-C₄-Alkoxy substituiertes Phenylthio, -S(O)R₈ oder -SO₂R₈, insbesondere C₁-C₈-Alkylthio, bedeutet.

5. Verbindungen der Formel I nach Anspruch 1, worin R₃, R₄ und R₅ unabhängig voneinander für unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy stehen.

6. Verbindungen nach Anspruch 1, worin R₅ Phenyl, Pyrryl, Furyl, Thienyl, Imidazolyl, Pyridyl, Naphthyl, Anthryl, Phenanthryl oder Biphenylyl bedeuten, wobei die Reste Phenyl, Pyrryl, Furyl, Thienyl, Imidazolyl, Pyridyl, Naphthyl, Anthryl, Phenanthryl oder Biphenylyl unsubstituiert oder mit C₁-C₁₂-Alkyl, Cyclopentyl, Cyclohexyl, Cl, Br, I, C₁-C₈-Alkylthio, -NR₈R₉, Phenyl, Phenylthio oder C₁-C₁₀-Alkoxy substituiert sind, bedeutet.

7. Verbindungen nach einem der Ansprüche 1-6, worin R₄ Cl, Br oder I, insbesondere Cl, bedeutet.

8. Verbindungen der Formel I nach Anspruch 1, worin
R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
R₄ für Cl steht und
R₅ unsubstituiertes oder mit C₁-C₁₂-Alkyl, Cl, Br, C₁-C₈-Alkylthio, -NR₈R₉, Phenyl, Phenylthio oder C₁-C₁₀-Alkoxy substituiertes Phenyl ist.

9. Verbindungen der Formel I nach Anspruch 1, worin
R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, unsubstituiertes oder mit C₁-C₄-Alkyl substituiertes C₃-C₁₂-Cycloalkoxy, unsubstituiertes oder mit C₁-C₄-Alkoxy oder/und C₁-C₄-Alkyl substituiertes Phenoxy, unsubstituiertes oder mit C₁-C₄-Alkyl substituiertes Benzyloxy, Tetrahydrofurfuryloxy oder C₂-C₆-Alkenyloxy bedeutet,
R₄ für Cl steht und
R₅ C₁-C₁₂-Alkyl, C₃-C₈-Cycloalkyl oder Adamantyl ist.

10. Verbindungen der Formel I nach Anspruch 1, worin n = 2 ist.

11. Verbindungen der Formel I nach Anspruch 1, worin
Y Cl, -O-CO-CH₃ oder -O-CO-Phenyl ist,
R₃ unsubstituiertes oder mit C₅-C₈-Cycloalkyl oder Phenoxy substituiertes C₁-C₁₂-Alkoxy, durch ein oder mehrere O-Atome unterbrochenes C₂-C₁₂-Alkoxy, C₅-C₈Cycloalkoxy, Benzyloxy, Tetrahydrofurfuryloxy oder Cl bedeutet,
R₄ die für R₃ definierten Bedeutungen hat und zusätzlich Wasserstoff ist und
R₅ die für R₃ gegebenen Bedeutungen hat und zusätzlich Wasserstoff, C₁-C₁₂-Alkyl, C₁-C₈-Alkylthio, Pyrryl, unsubstituiertes oder mit Cl, C₁-C₁₀-Alkoxy, Phenyl, C₁-C₈-Alkylthio, Phenylthio oder NR₈R₉ substituiertes Phenyl ist und
R₁₀ für Phenyl steht.

12. Verbindungen der Formel I nach Anspruch 1, worin Q für einen Rest 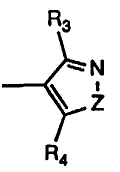 steht,
R₃ und R₄ Cl bedeuten,
Z für -NR₁₀- steht und
R₁₀ unsubstituiertes oder mit Cl, Br, I, NO₂, C₁-C₁₂-Alkyl, C₁-C₁₀-Alkoxy, C₁-C₈-Alkylthio, Phenylthio, Morpholino oder -N(C₁-C₄-Alkyl)₂ substituiertes Phenyl darstellt.

13. Photopolymerisierbare Zusammensetzung, enthaltend
(a) mindestens eine ethylenisch ungesättigte photopolymerisierbare Verbindung und
(b) als Photoinitiator mindestens eine Verbindung der Formel I oder II wie in Anspruch 1 definiert und gegebenfalls neben dem Photoinitiator (b) noch mindestens einen weiteren Photoinitiator
(c) und/oder andere Additive.

14. Zusammensetzung nach Anspruch 13, enthaltend als Photoinitiator (c) ein Titanocen, welches nicht der Formel I oder II entspricht, ein Benzophenon, einen Benzoinalkylether, ein Benzilketal, ein 4-Aroyl-1,3-dioxolan, ein Dialkoxyacetophenon, ein α-Hydroxy- oder α-Aminoacetophenon, ein α-Hydroxycycloalkylphenylketon oder ein Mono- oder Bisacylphosphinoxid oder Mischungen davon als zusätzlichen Photoinitiator.

15. Verwendung von in Anspruch 1 definierten Verbindungen als Photoinitiatoren für die Photopolymerisation ethylenisch ungesättigter Verbindungen, gegebenenfalls in Kombination mit einem anderen Photoinitiator und/oder anderen Additiven.

16. Verwendung einer Zusammensetzung nach Anspruch 13 zur Herstellung von Lacken, Druckfarben, Druckplatten, Dentalmassen, Resistmaterialien sowie als Bild- aufzeichnungsmaterial, insbesondere für holographische Aufzeichnungen.

17. Beschichtetes Substrat, das auf mindestens einer Oberfläche mit einer Zusammensetzung nach Anspruch 13 beschichtet ist.

18. Verfahren zur photographischen Herstellung von Reliefabbildungen, dadurch gekennzeichnet, dass man ein beschichtetes Substrat nach Anspruch 17 bildmässig belichtet und die unbelichteten Anteile danach mit einem Lösemittel entfernt.

## Claims

1. A compound of the formula I or II 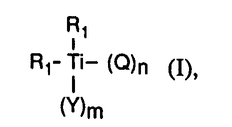 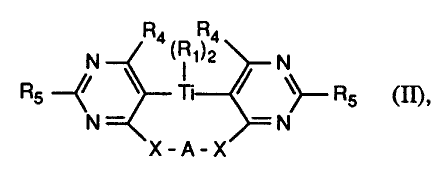 in which the two R₁ radicals, independently of one another, are cyclopentadienyl^{⊖}, indenyl^{⊖} or 4,5,6,7-tetrahydroindenyl^{⊖} , these radicals being unsubstituted or substituted by C₁-C₁₈alkyl, C₁-C₁₈alkoxy, C₂-C₁₈alkenyl, C₅-C₈cycloalkyl, C₁-C₄alkyl-C₅-C₈cycloalkyl, phenyl, naphthyl, phenyl-substituted C₁-C₁₂alkyl, -Si(R₂)₃, -Ge(R₂)₃, cyano, Cl, Br or I, and
the two R₂ radicals, independently of one another, are C₁-C₁₂alkyl, C₅-C₈cycloalkyl, or unsubstituted or C₁-C₆alkyl-substituted phenyl or benzyl,
Q is a 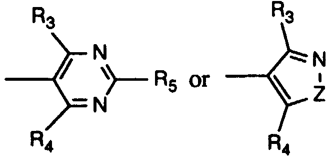 radical,
Z is -NR₁₀-, -O or -S-,
Y is Cl, Br, I, CN, SCN, -O-CO-CH₃, -O-CO-phenyl or -O-SO₂-CH₃,
n is 1 or 2,
m is 0 or 1, where the sum of n and m must be 2,
R₃, R₄ and R₅, independently of one another, are hydrogen, Cl, Br, I, unsubstituted or C₁-C₄alkoxy-, C₅-C₆cycloalkyl- or phenyl-substituted C₁-C₁₂alkyl, unsubstituted or C₁-C₄alkyl-substituted C₃-C₈cycloalkyl or adamantyl, or R₃, R₄ and R₅ are phenyl, pyrryl, furyl, thienyl, imidazolyl, pyridyl, naphthyl, anthryl, phenanthryl or biphenylyl where the radicals phenyl, pyrryl, furyl, thienyl, imidazolyl, pyridyl, naphthyl, anthryl, phenanthryl or biphenylyl are unsubstituted or substituted by C₁-C₁₂alkyl, cyclopentyl, cyclohexyl, Cl, Br, I, C₁-C₈alkylthio, -NR₈R₉, phenyl, phenylthio and/or C₁-C₁₀alkoxy, or R₃, R₄ and R₅ are unsubstituted C₂-C₁₂alkenyl or C₂-C₁₂alkenyl which is substituted by unsubstituted or C₁-C₄alkyl-, C₁-C₄alkoxy-, C₁-C₄alkylthio-, Cl-, Br- or I-substituted phenyl or 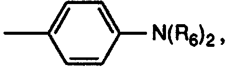 or R₃, R₄ and R₅ are unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy, C₂-C₆alkenyloxy, -O-Si-(R₇)₃, C₁-C₈alkylthio, C₃-C₈cycloalkylthio, unsubstituted or C₁-C₄alkyl- and/or C₁-C₄alkoxy-substituted benzylthio, unsubstituted or C₁-C₄alkyl- and/or C₁-C₄alkoxy-substituted phenylthio, -S(O)R₈, -SO₂R₈ -N(R₉)₂, 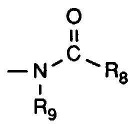 or 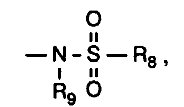 where R₃ and R₄ are not simultaneously hydrogen, and at least one radical R₃ or R₄ in the 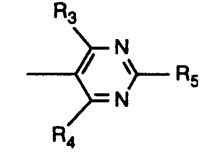 radical is unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy or C₂-C₆alkenyloxy,
and in the case where Z is -NR₁₀-, R₃ and R₄ are Cl, Br or I,
the two R₆ radicals, independently of one another, are C₁-C₄alkyl or C₂-C₁₀alkenyl, or the two R₆ radicals, together with the nitrogen atom to which they are bonded, form a morpholino radical,
R₇ is C₁-C₁₂alkyl, C₅-C₈cycloalkyl or unsubstituted or C₁-C₆alkyl-substituted phenyl,
R₈ is unsubstituted or C₁-C₄alkyl-substituted phenyl or α-tertiary C₄-C₆alkyl,
R₉ is unsubstituted or phenyl-, C₇-C₁₂alkylphenyl-, C₅-C₈cycloalkyl- or C₁-C₄alkyl-C₅-C₈cycloalkyl-substituted C₁-C₈alkyl, C₂-C₈alkenyl, unsubstituted or C₁-C₄alkyl-substituted C₅-C₈cycloalkyl, C₆-C₂₀cycloalkenylalkyl, unsubstituted or C₁-C₁₂alkyl-substituted phenyl, a 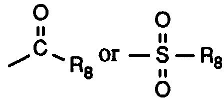 radical, where, in addition, the two R₉ radicals in -N(R₉)₂ are identical or different and, together with the nitrogen atom to which they are bonded, may form a 5- or 6-membered heterocyclic ring which, in addtion to the nitrogen atom, may also contain further nitrogen, oxygen or sulfur atoms, or the two R₉ radicals, together with the nitrogen atom to which they are bonded, form a 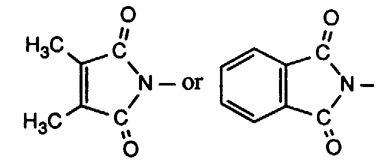 radical,
R₁₀ is as defined for R₉ or additionally is naphthyl, biphenylyl, pyridyl or pyrimidinyl, these radicals being unsubstituted or substituted by Cl, Br, I, NO₂, C₁-C₁₂alkyl, C₁-C₁₀alkoxy, C₁-C₈alkylthio, phenylthio, morpholino or -N(C₁-C₄alkyl)₂, or R₁₀ is phenyl which is substituted by Cl, Br, I, NO₂, C₁-C₁₀alkoxy, C₁-C₁₀alkylthio, phenylthio, morpholino or -N(C₁-C₄alkyl)₂,
X is -O-, -S-, 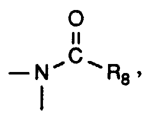 methylene or ethylene, and
A is C₁-C₁₂alkylene or -X-A-X- is a direct bond.

2. A compound according to claim 1, in which the two R₁ radicals, independently of one another, are cyclopentadienyl^{⊖} which is unsubstituted or substituted by C₁-C₁₈alkyl, C₁-C₁₈alkoxy, C₂-C₁₈alkenyl, -Si(R₂)₃ or Cl, Br, I, in particular C₁-C₄alkyl.

3. A compound of the formula I according to claim 1, in which R₃ and R₅ are unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy or C₂-C₆alkenyloxy.

4. A compound according to claim 1, in which R₅ is C₁-C₈alkylthio, C₃-C₈cycloalkylthio, unsubstituted or C₁-C₄alkyl- and/or C₁-C₄alkoxy-substituted benzylthio, unsubstituted or C₁-C₄alkyl- and/or C₁-C₄alkoxy-substituted phenylthio, -S(O)R₈ or -SO₂R₈, in particular C₁-C₈alkylthio.

5. A compound of the formula I according to claim 1, in which R₃, R₄ and R₅, independently of one another, are unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy or C₂-C₆alkenyloxy.

6. A compound according to claim 1, in which R₅ is phenyl, pyrryl, furyl, thienyl, imidazolyl, pyridyl, naphthyl, anthryl, phenanthryl or biphenylyl, where the radicals phenyl, pyrryl, furyl, thienyl, imidazolyl, pyridyl, naphthyl, anthryl, phenanthryl and biphenylyl are unsubstituted or substituted by C₁-C₁₂alkyl, cyclopentyl, cyclohexyl, Cl, Br, I, C₁-C₈alkylthio, -NR₈R₉, phenyl, phenylthio or C₁-C₁₀alkoxy.

7. A compound according to any one of claims 1 to 6, in which R₄ is Cl, Br or I, in particular Cl.

8. A compound of the formula I according to claim 1, in which
R₃ is unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy or C₂-C₆alkenyloxy,
R₄ is Cl, and
R₅ is phenyl which is unsubstituted or substituted by C₁-C₁₂alkyl, Cl, Br, C₁-C₈alkylthio, -NR₈R₉, phenyl, phenylthio or C₁-C₁₀alkoxy.

9. A compound of the formula I according to claim 1, in which
R₃ is unsubstituted or C₅-C₈cycloalkyl- or phenoxy-substituted C₁-C₁₂alkoxy, C₂-C₁₂alkoxy which is interrupted by one or more oxygen atoms, unsubstituted or C₁-C₄alkyl-substituted C₃-C₁₂cycloalkoxy, unsubstituted or C₁-C₄alkoxy- and/or C₁-C₄alkyl-substituted phenoxy, unsubstituted or C₁-C₄alkyl-substituted benzyloxy, tetrahydrofurfuryloxy or C₂-C₆alkenyloxy,
R₄ is Cl, and
R₅ is C₁-C₁₂alkyl, C₃-C₈cycloalkyl or adamantyl.

10. A compound of the formula I according to claim 1, in which n = 2.

11. A compound of the formula I according to claim 1, in which
Y is Cl, -O-CO-CH₃ or -O-CO-phenyl,
R₃ is unsubstituted or C₅-C₈cycloalkyl- or phenoxy-substituted C₁-C₁₂alkoxy, C₂-C₁₂alkoxy which is interrupted by one or more oxygen atoms, C₅-C₈cycloalkoxy, benzyloxy, tetrahydrofurfuryloxy or Cl,
R₄ is as defined for R₃ or additionally hydrogen, and
R₅ is as defined for R₃ or additionally hydrogen, C₁-C₁₂alkyl, C₁-C₈alkylthio, pyrryl, or phenyl which is unsubstituted or substituted by Cl, C₁-C₁₀alkoxy, phenyl, C₁-C₈alkylthio, phenylthio or -NR₈R₉, and
R₁₀ is phenyl.

12. A compound of the formula I according to claim 1, in which Q is a 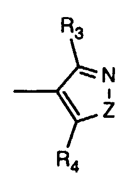 radical,
R₃ and R₄ are Cl,
Z is -NR₁₀-, and
R₁₀ is phenyl which is unsubstituted or substituted by Cl, Br, I, NO₂, C₁-C₁₂alkyl, C₁-C₁₀alkoxy, C₁-C₈alkylthio, phenylthio, morpholino or -N(C₁-C₄alkyl)₂.

13. A photopolymerisable composition comprising
(a) at least one ethylenically unsaturated, photopolymerisable compound and
(b), as photoinitiator, at least one compound of the formula I or II as defined in claim 1 and, if appropriate, in addition to the photoinitiator (b), also at least one further photoinitiator (c) and/or other additives.

14. A composition according to claim 13, wherein the photoinitiator (c) is a titanocene which does not conform to the formula I or II, a benzophenone, a benzoin alkyl ether, a benzil ketal, a 4-aroyl-1,3-dioxolane, a dialkoxyacetophenone, an α-hydroxy- or α-aminoacetophenone, an α-hydroxycycloalkyl phenyl ketone or a mono- or bisacylphosphine oxide, or a mixture thereof, as an additional photoinitiator.

15. The use of a compound defined in claim 1 as a photoinitiator for the photopolymerisation of ethylenically unsaturated compounds, if appropriate in combination with another photoinitiator and/or other additives.

16. The use of a composition according to claim 13 for the production of paints, printing inks, printing plates, dental compositions, resist materials and as an image-recording material, in particular for holographic recordings.

17. A coated substrate which is coated on at least one surface with a composition according to claim 13.

18. A process for the photographic production of relief images, wherein a coated substrate according to claim 17 is exposed imagewise, and the unexposed areas are then removed by means of a solvent.

## Revendications

1. Composés de formule I ou II 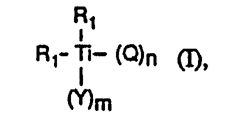 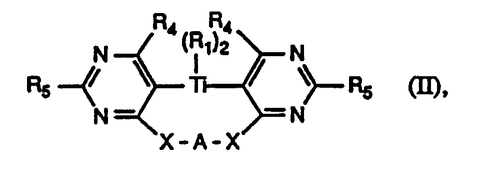 dans lesquelles
les deux R₁, indépendamment l'un de l'autre, représentent des groupes cyclopentadiényle^{Θ}, indényle^{Θ} ou 4,5,6,7-tétrahydroindényle^{Θ}, ces restes étant non substitués ou substitués par des groupes alkyle en C₁-C₁₈ ou alkoxy en C₁-C₁₈, alcényle en C₂-C₁₈, cycloalkyle en C₅-C₈, (alkyl en C₁-C₄)-cycloalkyle en C₅-C₈, phényle, naphtyle, alkyle en C₁-C₁₂ substitué par phényle, -Si(R₂)₃, -Ge(R₂)₃, cyano, Cl, Br ou I, et les deux R₂, indépendamment l'un de l'autre, représentent des groupes alkyle en C₁-C₁₂, cycloalkyle en C₅-C₈, benzyle ou phényle non substitué ou substitué par alkyle en C₁-C₆,
Q représente un reste 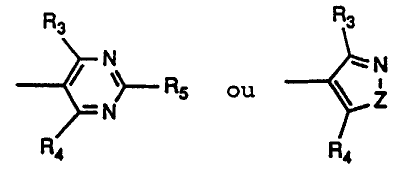
Z représente -NR₁₀-, -O- ou -S-,
Y représente Cl, Br, I, CN, SCN, -O-CO-CH₃, -O-CO-phényle ou -0-SO₂-CH₃,
n vaut 1 ou 2,
m vaut 0 ou 1, la somme de n et de m devant être égale à 2,
R₃, R₄ et R₅, indépendamment les uns des autres, représentent un atome d'hydrogène, Cl, Br, I, un groupe alkyle en C₁-C₁₂ non substitué ou substitué par des groupes alkoxy en C₁-C₄, cycloalkyle en C₅-C₆ ou phényle, adamantyle ou cycloalkyle en C₃-C₈ non substitué ou substitué par alkyle en C₁-C₄, ou R₃, R₄ et R₅ représentent phényle, pyrryle, furyle, thiényle, imidazolyle, pyridyle, naphtyle, anthryle, phénanthryle ou biphénylyle, les restes phényle, pyrryle, furyle, thiényle, imidazolyle, pyridyle, naphtyle, anthryle, phénanthryle ou biphénylyle étant non substitués ou substitués par des substituants alkyle en C₁-C₁₂, cyclopentyle, cyclohexyle, Cl, Br, I, (alkyl en C₁-C₈)thio, -NR₈R₉, phényle, phénylthio et/ou alkoxy en C₁-C₁₀, ou R₃, R₄ et R₅ représentent alcényle en C₂-C₁₂ non substitué ou alcényle en C₂-C₁₂ substitué par un groupe 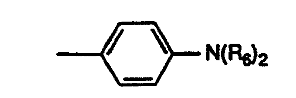 ou par un groupe phényle non substitué ou substitué par des substituants alkyle en C₁-C₄, alkoxy en C₁-C₄, (alkyl en C₁-C₄)thio, Cl, Br ou I, ou R₃, R₄ et R₅ représentent un groupe alkoxy en C₁-C₁₂ non substitué ou substitué par cycloalkyle en C₅-C₈ ou phénoxy, un groupe alkoxy en C₂-C₁₂ interrompu par un ou plusieurs atomes d'oxygène, cycloalkoxy en C₃-C₁₂ non substitué ou substitué par un groupe alkyle en C₁-C₄, phénoxy non substitué ou substitué par des groupes alkoxy en C₁-C₄ et/ou alkyle en C₁-C₄, alcényloxy en C₂-C₆, tétrahydrofurfuryloxy, benzyloxy non substitué ou substitué par un groupe alkyle en C₁-C₄, représente -O-Si-(R₇)₃, (alkyl en C₁-C₈)thio, cyclo(alkyl en C₃-C₈)thio, benzylthio non substitué ou substitué par des groupes alkyle en C₁-C₄ et/ou alkoxy en C₁-C₄, phénylthio non substitué ou substitué par des groupes alkyle en C₁-C₄ et/ou alkoxy en C₁-C₄, -S(O)R₈, -SO₂R₈, -N(R₉)₂, 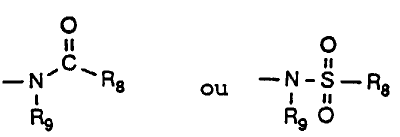 R₃ et R₄ n'ayant pas simultanément la signification d'un atome d'hydrogène, et dans le reste 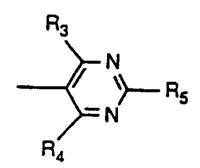 au moins un reste R₃ ou R₄ étant un groupe alkoxy en C₁-C₁₂ non substitué ou substitué par des groupes cycloalkyle en C₅-C₈ ou phénoxy, alkoxy en C₂-C₁₂ interrompu par un ou plusieurs atomes d'oxygène, cycloalkoxy en C₃-C₁₂ non substitué ou substitué par un groupe alkyle en C₁-C₄, phénoxy non substitué ou substitué par des groupes alkoxy en C₁-C₄ et/ou alkyle en C₁-C₄, alcényloxy en C₂-C₆, tétrahydrofurfuryloxy ou benzyloxy non substitué ou substitué par un groupe alkyle en C₁-C₄, et dans le cas où Z représente -NR₁₀-, R₃ et R₄ représentent Cl, Br ou I,
les deux R₆, indépendamment l'un de l'autre, représentent alkyle en C₁-C₄ ou alcényle en C₂-C₁₀ ou les deux R₆, conjointement avec l'atome de N auquel ils sont liés, forment un reste morpholino,
R₇ représente des groupes alkyle en C₁-C₁₂, cycloalkyle en C₅-C₈, phényle non substitué ou substitué par alkyle en C₁-C₆,
R₈ représente un groupe phényle non substitué ou substitué par alkyle en C₁-C₄ ou représente alkyle en C₄-C₆ tertiaire en position α,
R₉ représente un groupe alkyle en C₁-C₈ non substitué ou substitué par des groupes phényle, alkylphényle en C₇-C₁₂, cycloalkyle en C₅-C₈ ou (alkyl en C₁-C₄)-cycloalkyle en C₅-C₈, un groupe alcényle en C₂-C₈, un groupe cycloalkyle en C₅-C₈ non substitué ou substitué par alkyle en C₁-C₄, un groupe cycloalcénylalkyle en C₆-C₂₀, un groupe phényle non substitué ou substituté par alkyle en C₁-C₁₂, un reste 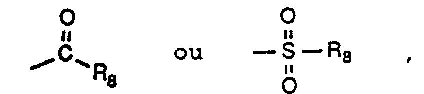 en outre, les deux R₉ dans -N(R₉)₂ étant identiques ou différents et les deux R₉ peuvent former, conjointement avec l'atome de N auquel ils sont liés, un hétérocycle de 5 à 6 chaînons, lequel peut contenir encore, outre l'atome d'azote, d'autres atomes de N, O ou S, ou les deux R₉ forment, conjointement avec l'atome de N auquel ils sont liés, un reste 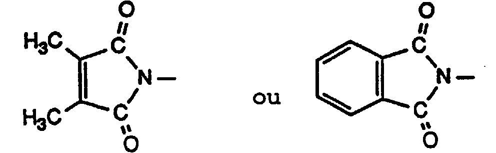
R₁₀ présente les significations de R₉ et de plus, représente naphtyle, biphénylyle, pyridyle ou pyrimidinyle, ces restes pouvant être non substitués ou substitués par des substituants Cl, Br, I, NO₂, alkyle en C₁-C₁₂, alkoxy en C₁-C₁₀, (alkyl en C₁-C₈)thio, phénylthio, morpholino ou -N(alkyle en C₁-C₄)₂, ou R₁₀ représente un groupe phényle substitué par Cl, Br, I, NO₂, alkoxy en C₁-C₁₀, (alkyl en C₁-C₈)thio, phénylthio, morpholino ou -N(alkyle en C₁-C₄)₂,
X représente -O-, -S-, 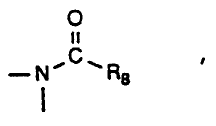 méthylène ou éthylène,
A représente alkylène en C₁-C₁₂, ou -X-A-X représente une liaison directe.

2. Composés selon la revendication 1, où les deux R₁, indépendamment l'un de l'autre, représentant un reste cyclopentadiényle^{Θ} non substitué ou substitué par alkyle ou alkoxy en C₁-C₁₈, alcényle en C₂-C₁₈, -Si(R₂)₃ ou Cl, Br, I, en particulier alkyle en C₁-C₄.

3. Composés de formule I selon la revendication 1, où R₃ et R₅ représentent un groupe alkoxy en C₁-C₁₂ non substitué ou substitué par des substituants cycloalkyle en C₅-C₈ ou phénoxy, alkoxy en C₁-C₁₂ interrompu par un ou plusieurs atomes d'oxygène, cycloalkoxy en C₃-C₁₂ non substitué ou substitué par alkyle en C₁-C₄, phénoxy non substitué ou substitué par alkoxy en C₁-C₄ et/ou alkyle en C₁-C₄, alcényloxy en C₂-C₆, tétrahydrofurfuryloxy ou benzyloxy non substitué ou substitué par alkyle en C₁-C₄.

4. Composés selon la revendication 1, où R₅ représente (alkyl en C₁-C₈)thio, cyclo(alkyl en C₃-C₈)-thio, benzylthio non substitué ou substitué par alkyle en C₁-C₄ et/ou alkoxy en C₁-C₄, phénylthio non substitué ou substitué par alkyle en C₁-C₄ et/ou alkoxy en C₁-C₄, -S(O)R₈ ou SO₂R₈, en particulier (alkyl en C₁-C₈)thio.

5. Composés de formule I selon la revendication 1, où R₃, R₄ et R₅, indépendamment les uns des autres, représentent alkoxy en C₁-C₁₂ non substitué ou substitué par des substituants cycloalkyle en C₅-C₈ ou phénoxy, alkoxy en C₁-C₁₂ interrompu par un ou plusieurs atomes d'oxygène, cycloalkoxy en C₃-C₁₂ non substitué ou substitué par alkyle en C₁-C₄, phénoxy non substitué ou susbtitué par alkoxy en C₁-C₄ et/ou alkyle en C₁-C₄, alcényloxy en C₂-C₆, tétrahydrofurfuryloxy ou benzyloxy non substitué ou substitué par alkyle en C₁-C₄.

6. Composés selon la revendication 1, où R₅ représente phényle, pyrryle, furyle, thiényle, imidazolyle, pyridyle, naphtyle, anthryle, phénanthryle ou biphénylyle, les restes phényle, pyrryle, furyle, thiényle, imidazolyle, pyridyle, naphtyle, anthryle, phénanthryle ou biphénylyle étant non substitués ou substitués par des substituants alkyle en C₁-C₁₂, cyclopentyle, cyclohexyle, Cl, Br, I, (alkyl en C₁-C₈)-thio, -NR₈R₉, phényle, phénylthio ou alkoxy en C₁-C₁₀.

7. Composés selon l'une des revendications 1 à 6, où R₄ représente Cl, Br ou I, en particulier Cl.

8. Composés de formule I selon la revendication 1, où
R₃ représente un groupe alkoxy en C₁-C₁₂ non substitué ou substitué par cycloalkyle en C₅-C₈ ou phénoxy, alkoxy en C₂-C₁₂ interrompu par un ou plusieurs atomes d'oxygène, cycloalkoxy en C₃-C₁₂ non substitué ou substitué par alkyle en C₁-C₄, phénoxy non substitué ou substitué par alkoxy en C₁-C₄ et/ou alkyle en C₁-C₄, tétrahydrofurfuryloxy, alcényloxy en C₂-C₆ ou benzyloxy non substitué ou substitué par alkyle en C₁-C₄,
R₄ représente Cl et
R₅ représente phényle non substitué ou substitué par des substituants alkyle en C₁-C₁₂, Cl, Br, (alkyl en C₁-C₈)thio, -NR₈R₉, phényle, phénylthio ou alkoxy en C₁-C₁₀.

9. Composés de formule I selon la revendication 1, où
R₃ représente alkoxy en C₁-C₁₂ non substitué ou substitué par des groupes cycloalkyle en C₅-C₈ ou phénoxy, alkoxy en C₂-C₁₂ interrompu par un ou plusieurs atomes d'oxygène, cycloalkoxy en C₃-C₁₂ non substitué ou substitué par alkyle en C₁-C₄, phénoxy non substitué ou substitué par alkoxy en C₁-C₄ et/ou alkyle en C₁-C₄, tétrahydrofurfuryloxy, alcényloxy en C₂-C₆ ou benzyloxy non substitué ou substitué par alkyle en C₁-C₄,
R₄ représente Cl et
R₅ représente alkyle en C₁-C₁₂, cycloalkyle en C₃-C₁₂ ou adamantyle.

10. Composés de formule I selon la revendication 1, où n = 2.

11. Composés de formule I selon la revendication 1, où
Y représente Cl, -O-CO-CH₃ ou -O-CO-phényle,
R₃ représente un groupe alkoxy en C₁-C₁₂ non substitué ou substitué par cycloalkyle en C₅-C₈ ou phénoxy, alkoxy en C₂-C₁₂ interrompu par un ou plusieurs atomes d'oxygène, cycloalkoxy en C₅-C₈, benzyloxy, tétrahydrofurfuryloxy ou Cl,
R₄ possède les significations données ci-dessus pour R₃ et représente en plus un atome d'hydrogène, et
R₅ possède les significations données pour R3 et représente de plus un atome d'hydrogène, des groupes alkyle en C₁-C₁₂, (alkyl en C₁-C₈)thio, pyrryle, phényle non substitué ou substitué par Cl, alkoxy en C₁-C₁₀, phényle, (alkyl en C₁-C₈)-thio, phénylthio ou -NR₈R₉, et
R₁₀ représente un groupe phényle.

12. Composés de formule I selon la revendication 1, où Q représente un reste 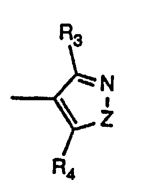
R₃ et R₄ représentent Cl,
Z représente -NR₁₀- et
R₁₀ représente un groupe phényle non substitué ou substitué par Cl, Br, I, NO₂, alkyle en C₁-C₁₂, alkoxy en C₁-C₁₀, (alkyl en C₁-C₈)thio, phénylthio, morpholino ou -N(alkyle en C₁-C₄)₂.

13. Composition photopolymérisable contenant
a) au moins un composé photopolymérisable à insaturation éthylénique et
b) en tant que photoamorceur, au moins un composé de formule I ou II comme défini dans la revendication 1 et
éventuellement, au côté du photoamorceur (b), encore au moins un autre photoamorceur
(c) et/ou d'autres additifs.

14. Composition selon la revendication 13, contenant en tant que photoamorceur (c) un titanocène, qui ne répond pas à la formule I ou II, une benzophénone, un alkyléther de benzoïne, un cétal de benzile, un 4-aroyl-1,3-dioxolane, une dialkoxyacétophénone, une α-hydroxy- ou α-aminoacétophénone, une α-hydroxycycloalkylphénylcétone ou un oxyde de mono- ou bisacylaminophosphine ou leurs mélanges, en tant que photoamorceurs supplémentaires.

15. Utilisation des composés définis dans la revendication 1 en tant que photoamorceurs pour la photopolymérisation des composés à insaturation éthylénique, éventuellement en combinaison avec un autre photoamorceur et/ou autres additifs.

16. Utilisation d'une compositon selon la revendication 13 pour la préparation de vernis, d'encres d'imprimerie, de clichés d'impression, de masses dentaires, de matières de résist ainsi que de matières d'enregistrement d'image, en particulier pour des enregistrements holographiques.

17. Substrat revêtu lequel est revêtu sur au moins une surface par une composition selon la revendication 13.

18. Procédé pour la préparation holographique de reproductions en relief, caractérisé en ce que l'on irradie selon modèle un substrat revêtu et ensuite, on élimine les portions non irradiées avec un solvant.
